(19) Europäisches Patentamt
European Patent Office
Office européen des brevets

(11) EP 3 561 469 B1

(12) # EUROPEAN PATENT SPECIFICATION

(45) Date of publication and mention of the grant of the patent:
**04.08.2021 Bulletin 2021/31**

(21) Application number: **17882696.2**

(22) Date of filing: **07.12.2017**

(51) Int Cl.:
***G01L 5/00*** (2006.01) ***G01L 1/16*** (2006.01)
***H01L 41/113*** (2006.01) ***H01L 41/193*** (2006.01)
***H01L 41/08*** (2006.01) ***H01L 41/087*** (2006.01)
***G06F 3/041*** (2006.01)

(86) International application number:
**PCT/JP2017/044082**

(87) International publication number:
**WO 2018/116857 (28.06.2018 Gazette 2018/26)**

(54) **PIEZOELECTRIC SENSOR AND COLLISION DETECTION METHOD**

PIEZOELEKTRISCHER SENSOR UND KOLLISIONSDETEKTIONSVERFAHREN

CAPTEUR PIÉZOÉLECTRIQUE ET PROCÉDÉ DE DÉTECTION DE COLLISION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.12.2016 JP 2016248354**
**19.07.2017 JP 2017140390**

(43) Date of publication of application:
**30.10.2019 Bulletin 2019/44**

(73) Proprietor: **Teijin Limited**
**Osaka-shi, Osaka 530-0005 (JP)**

(72) Inventors:
- **ONO, Yuhei**
**Osaka-shi**
**Osaka 530-0005 (JP)**
- **KANEMATSU, Shunsuke**
**Osaka-shi**
**Osaka 530-0005 (JP)**
- **YAMAMOTO, Tomoyoshi**
**Osaka-shi**
**Osaka 530-0005 (JP)**

(74) Representative: **Cockerton, Bruce Roger**
**Carpmaels & Ransford LLP**
**One Southampton Row**
**London WC1B 5HA (GB)**

(56) References cited:
**WO-A1-2016/175321** **WO-A1-2016/175321**
**CN-A- 104 458 075** **JP-A- H01 322 081**
**JP-A- 2005 515 466** **JP-A- 2014 173 844**
**JP-A- 2016 109 652** **JP-A- 2017 120 885**
**US-A- 4 943 757** **US-A1- 2009 164 147**
**US-A1- 2010 198 528**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 561 469 B1

## Description

FIELD

The present invention relates to a piezoelectric sensor and impact detection method that detect application of stress to a measured object, and to a piezoelectric sensor and impact detection method that identify a region on a measured object where stress has been applied.

BACKGROUND

Various means exist as sensors for detecting impact, vibration or deformation on objects.
One known example is a vibration detection device comprising a pressure sensor that generates a signal in response to deformation by a vibration source, and determining means that determines the vibration source based on the signal of the pressure sensor, wherein the pressure sensor is situated opposite the surface that receives the deformation, and the device has multiple curved sections formed as long, flexible linear shapes (see PTL 1, for example).
Impact location detecting devices are also known that comprise, for example, a piezoelectric element that generates a voltage upon impact, signal detection means that detects the signal generated by impact on the piezoelectric element, and processing means that identifies the location of impact on the piezoelectric element by the signal detected by the signal detection means, wherein the piezoelectric element is a long piezoelectric element comprising a long piezoelectric element and a pair of conductors that transmit signals generated by the piezoelectric element, the signal detection means is a device that detects both a front end signal generated from the front end of the long piezoelectric element and a back end signal generated from the back end of the long piezoelectric element, and the processing means is means that identifies the location of impact on the piezoelectric element based on the signal generation time difference between the front end signal and the back end signal (see PTL 2, for example).
In addition, impact recording sensors are known that comprise, for example, in impact detection means that utilizes electromotive voltage generated by a piezoelectric element set in a predetermined device to detect application of impact on the device, a detector that has the piezoelectric element and receives application of an impact, generating electromotive voltage by the piezoelectric element, and a recorder that detects and records the application of impact on the device and the impact application level based on the electromotive voltage (see PTL 3, for example).
Also known are physical quantity measurement recording devices that comprise electric power generation means that generates electromotive force when change in a physical quantity has been detected, physical quantity measurement means that measures the physical quantity by the electric power supplied from the electric power generation means, and recording means that records the physical quantity measured by the electric power supplied from the electric power generation means (see PTL 4, for example).
There are further known devices for assessing whether an object such as a baseball moving through some target region has been impacted, which use piezoelectric films as assessing instruments (see PTL 5, for example).
PTL 6 relates to a stress wave sensor comprising a piezoelectric film and means therein for connection to sensor electronics.
PTL 7 relates to an impact location and amplitude sensory system.
PTL 8 aims to provide a sensor capable of accurately detecting a compression position where pressure is applied, in spite of its simple construction.
PTL 9 relates to a safety apparatus for a motor driven window that comprises an elongated sensing mechanism that extends substantially across the width of a window aperture and along that side of the window aperture toward which a closing, motor driven window moves.
PTL 10 aims to provide a fibrous piezoelectric element which enables a large electric signal to be drawn out by stress produced by relatively small deformation.

[CITATION LIST]

[PATENT LITERATURE]

[PTL 1] Japanese Unexamined Patent Publication No. 2005-351781
[PTL 2] International Patent Publication No. WO2013/165011
[PTL 3] Japanese Unexamined Patent Publication No. 2004-163182
[PTL 4] Japanese Unexamined Patent Publication No. 2006-90960
[PTL 5] Japanese Unexamined Patent Publication HEI No. 3-238356

[PTL 6] United States Patent Application Publication No. US2009164147 A1
[PTL 7] United States Patent Application Publication No. US2010198528 A1
[PTL 8] Japanese Unexamined Patent Publication No. 2016-109652
[PTL 9] United States Patent No. US4943757
[PTL 10] International Patent Publication No. WO2016175321 A1

SUMMARY

[TECHNICAL PROBLEM]

The shapes of measured objects where sensors are provided are not limited to being flat or simple curves and also include those with complex shapes with irregularities, and therefore placement of the sensors is sometimes difficult. Moreover, when point sensors are used, for example, a large number of point sensors must be installed to identify the location of impact. A demand therefore exists for development of low-cost piezoelectric sensors that allow detection of impacts on objects with different shapes, and that have a simple structure allowing detection of the locations of impacts that may occur over a wide area, using a small number of sensors.

[SOLUTION TO PROBLEM]

The present inventors have completed this invention upon finding that by placing one or more linear piezoelectric elements near a measured object, it is possible to detect application of stress to the measured object based on the electrical signals generated by each of the linear piezoelectric elements.

The present inventors have also completed this invention after finding that by placing two or more linear piezoelectric elements near a measured object, it is possible to identify the region on the measured object where stress has been applied based on the timing at which the size of the electrical signal generated by each linear piezoelectric element has overrun a predetermined threshold value.

The present inventors have still further completed this invention after finding that by placing two or more linear piezoelectric elements near a measured object, it is possible to identify the region on the measured object where stress has been applied based on the size of the electrical signal generated by each linear piezoelectric element.

The present invention is defined by the appended claims. According to the invention there is a piezoelectric sensor comprising a linear piezoelectric element that consists of two or more linear piezoelectric elements disposed near a measured object, generating an electrical signal in response to stress applied to the linear piezoelectric element, a signal detector that detects an electrical signal generated by each linear piezoelectric element, an overrun assessing unit that assesses whether or not the size of the electrical signal detected by the signal detector has overrun a predetermined threshold value, for each linear piezoelectric element, a timing recorder that records the timing of overrun of the linear piezoelectric element when the size of the electrical signal has been assessed by the overrun assessing unit to have overrun a predetermined threshold value, and a region identifying unit that identifies the region on the measured object where stress has been applied, based on the timing of overrun of the linear piezoelectric element recorded at the timing recorder.

According to the invention there is an impact detection method whereby the region on a measured object where stress has been applied is identified, the method comprising a signal detecting step in which the electrical signal generated when stress is applied to two or more linear piezoelectric elements disposed near a measured object is detected for each linear piezoelectric element,an overrun assessing step in which it is assessed whether or not the size of the electrical signal detected in the signal detecting step has overrun a predetermined threshold value, for each linear piezoelectric element,a timing recording step in which the timing of overrun of the linear piezoelectric element is recorded when the size of the electrical signal has been assessed in the overrun assessing step to have overrun the predetermined threshold value, and a region identifying step in which the region on the measured object where stress has been applied is identified, based on the linear piezoelectric element timing recorded in the timing recording step, wherein the region identifying step comprises,a boundary defining step which, based on the order of overrun of the linear piezoelectric elements recorded in the timing recording step, defines as boundary line the collection of points equidistant from the linear piezoelectric element that has been assessed to have overrun, and the next linear piezoelectric element that has been assessed to have overrun following overrun of that linear piezoelectric element, a region establishing step which establishes, as the region of stress application, the region that has the boundary line defined in the boundary defining step and includes the linear piezoelectric element that was initially assessed to have overrun.

[ADVANTAGEOUS EFFECTS OF INVENTION]

According to one aspect of the disclosure it is possible to realize a low-cost piezoelectric sensor that allows detection of impacts on objects with different shapes, and that has a simple structure allowing detection of the locations of impacts that may occur over a wide area, using a small number of sensors. The piezoelectric sensor of this aspect can be produced by a simple process without requiring special steps, and its productivity is high.

Moreover, since the linear piezoelectric element composing the sensor portion of the piezoelectric sensor is highly flexible, it can be easily installed to match the shape of a measured object, and it can be used as an impact sensor or stress detecting sensor for various types of measured objects. In the field of railways, for example, a piezoelectric sensor according to this aspect may be used in a sensor for detecting persons passing through the ticket gate of a train station, or in a sensor for detecting the condition of congestion in train vehicles or on a train platform. Another similar method of use of the piezoelectric sensor of this aspect is as a sensor for detecting the condition of congestion in a shop or public facility, for example. Alternatively, in the field of transport including automobiles, railways, ships and aviation (and also including drones), for example, the piezoelectric sensor of this aspect may be installed at various locations of target objects to allow a greater variety of data to be easily collected when they are impacted. In addition, the piezoelectric sensor of this aspect may be installed in seats or handles in automobiles for the purpose of detecting sudden illness of drivers.

BRIEF DESCRIPTION OF DRAWINGS

FIG. 1 is a schematic diagram showing the basic construction of a piezoelectric sensor according to an embodiment.

FIG. 2 is a diagram illustrating the deformation speed of a linear piezoelectric element used for this embodiment.

FIG. 3 is a diagram showing the relationship between deformation by elongation of the linear piezoelectric element of FIG. 2, and signal strength, (A) showing the relationship between deformation speed and signal strength (current value) and (B) showing the relationship between location of the deformed portion and signal strength (current value).

FIG. 4 is a diagram that illustrates recording of the timing of overrun by the timing recorder according to this embodiment.

FIG. 5 is a flow chart showing the operation flow in the impact detection method with the piezoelectric sensor of FIG. 1.

FIG. 6(A) to (D) are diagrams illustrating identification of a region of stress application with 5 linear piezoelectric elements each vertically and horizontally arranged at equal spacings, according to this embodiment.

FIG. 7(A) to (D) are diagrams illustrating an example of identifying a region of stress application, with conventional point sensors arranged in a lattice-like fashion with equal spacings.

FIG. 8(A) to (D) are diagrams illustrating an example of identifying a region of stress application, with conventional point sensors arranged in a lattice-like fashion with equal spacings at a greater density than in FIG. 7 (maximum density).

FIG. 9 is a graph comparing the arrangement number of a piezoelectric sensor of this embodiment and a conventional point sensor, as explained using FIG. 6 to FIG. 8.

FIG. 10 is a table comparing the arrangement number and identifiable area for a piezoelectric sensor of this embodiment and a conventional point sensor, as explained using FIG. 6 to FIG. 8.

FIG. 11 is a pair of actual photographs showing a piezoelectric sensor having 4 linear piezoelectric elements arranged in a lattice-like fashion vertically and horizontally at equal spacings, according to this embodiment, (A) showing the outer side (surface) of the measured object and (B) showing the back side of the measured object.

FIG. 12 is a graph showing an example of the voltage value of the electrical signal generated by different linear piezoelectric elements, when an iron ball is dropped onto a measured object on which the piezoelectric sensor shown in FIG. 11 has been anchored.

FIG. 13(A) to (E) are diagrams showing the results of identifying regions when dropping iron balls on different locations of a measured object on which the piezoelectric sensor shown in FIG. 11 has been anchored.

FIG. 14 is a pair of graphs showing the measurement results for the size of stress detected in regions when an iron ball is dropped onto different locations of a measured object on which the piezoelectric sensor shown in FIG. 11 has been anchored, (A) showing the impact energy detected by linear piezoelectric elements CH1 to CH4 arranged in a line in the longitudinal direction, and (B) showing the impact energy detected by linear piezoelectric elements CH5 to CH8 arranged in a line in the transverse direction.

FIG. 15 is a pair of actual photographs showing a piezoelectric sensor having 8 linear piezoelectric elements, 2 of which are configured into an inverted U-shape, according to this embodiment, (A) showing the outer side (surface) of the measured object and (B) showing the back side of the measured object.

FIG. 16 is a diagram showing the configuration positions of the piezoelectric sensor on the measured object of FIG. 15.

FIG. 17 is a graph showing an example of the voltage value of the electrical signal generated by different linear piezoelectric elements, when an iron ball is dropped onto a measured object on which the piezoelectric sensor shown in FIG. 15 has been anchored.

FIG. 18(A) to (B) are diagrams showing the results of identifying regions when dropping iron balls on different locations of a measured object on which the piezoelectric sensor shown in FIG. 15 has been anchored.

FIG. 19 is a diagram showing an example of placement of linear piezoelectric elements on the non-flat surface of a measured object.

FIG. 20 is a schematic diagram showing the basic construction of a piezoelectric sensor according to another embodiment.

FIG. 21 is a flow chart showing the operation flow in the impact detection method with the piezoelectric sensor of FIG. 20.

FIG. 22 is a schematic diagram showing an example of the construction of a braided piezoelectric element according to an embodiment.

FIG. 23 is a schematic diagram illustrating a method of calculating the orientation angle θ.

FIG. 24(A) to (C) are cross-sectional photographs of a braided piezoelectric element according to an embodiment.

FIG. 25 is a graph showing an example of an electrical signal generated upon vibration on a linear piezoelectric element according to the embodiment of FIG. 20 and FIG. 21.

FIG. 26 is a graph showing an example of the polarity of an electrical signal generated upon vibration on a linear piezoelectric element according to the embodiment of FIG. 20 and FIG. 21.

DESCRIPTION OF EMBODIMENTS

The piezoelectric sensor and impact detection method will now be explained with reference to the accompanying drawings. In each diagram, similar members are indicated by like reference numerals. Moreover, usage of the same reference numerals in different diagrams indicates components having the same function. The diagrams are drawn to convenient scales for greater clarity. The present invention is a piezoelectric sensor and an impact detection method according to the independent claims. Further embodiments of the invention are described in the dependent claims.

(Basic construction of piezoelectric sensor)

Fig. 1 is a schematic diagram showing the basic construction of a piezoelectric sensor according to an embodiment. The piezoelectric sensor 1000 comprises a linear piezoelectric element 101, a signal detector 102, an overrun assessing unit 103, a timing recorder 104 and a region identifying unit 105. As an option, the piezoelectric sensor 1000 further comprises a stress calculating unit 106 that calculates the size of stress applied to the linear piezoelectric element 101 based on the size of the electrical signal detected by the signal detector 102.

The linear piezoelectric element 101 generates an electrical signal in response to applied stress. When stress (impact) is applied to a measured object (including when stress is directly applied to the linear piezoelectric element 101), deformation by elongation is produced in the linear piezoelectric element 101. This elongation deformation causes an electrical signal to be generated in the linear piezoelectric element 101. Two or more linear piezoelectric elements 101 are disposed near the measured object, where the impact is to be measured. The two or more linear piezoelectric elements 101 may be configured in any manner, such intersecting in an approximately cross-like manner, or with spacings between them. Specific examples of materials to form the linear piezoelectric element 101 and their placement will be described below. Since the linear piezoelectric element composing the sensor portion of the piezoelectric sensor is highly flexible, it can be easily installed to match the shape of a measured object, and it can be used as an impact sensor or stress detecting sensor for various types of measured objects.

The electrical properties of a linear piezoelectric element 101 that generates an electrical signal by elongation, to be used in the piezoelectric sensor of this embodiment, will now be explained with reference to Fig. 2 and Fig. 3. Fig. 2 is a diagram illustrating the deformation speed of a linear piezoelectric element used for this embodiment. For this embodiment, the linear piezoelectric element 101 used is one wherein the speed of deformation due to elongation is constant regardless of the length or the location where elongation is generated. An experiment was conducted as illustrated in Fig. 2, in which two long and short linear piezoelectric elements 101 to be used in this embodiment were prepared, each was held by a chuck with a fixed distance between them and connected to a signal detector 102 via connectors 121, elongation was applied to the measured object in the linear direction and the signal strength (current value) generated at that time was measured. Fig. 3 is a diagram showing the relationship between deformation by elongation of the linear piezoelectric element of Fig. 2, and signal strength, (A) showing the relationship between deformation speed and signal strength (current value) and (B) showing the relationship between location of deformed portion and signal strength (current value). With the linear piezoelectric elements 101 used for this embodiment, the elongation deformation speed and signal strength (current value) of the linear piezoelectric elements 101 were proportional, as shown in Fig. 3(A), while the signal strength (current value) was approximately constant regardless of the location where elongation deformation was generated (represented by the distance from the connector 21), as shown in Fig. 3(B). For this embodiment, the linear piezoelectric elements 101 used are preferably such ones wherein the signal strength is constant with respect to the speed of deformation due to elongation, regardless of the length or the location where elongation is generated. Incidentally, the electrical signal generated during elongation of the linear piezoelectric element 101 and the electrical signal generated during compression of the linear piezoelectric element 101 have reverse polarity (sign). The linear piezoelectric element 101 may also be one that does not have a constant signal strength with respect to speed of deformation due to elongation, in which case it is sufficient to provide a pre-compensating computing unit at the first stage of an overrun computing unit 103, which measures in advance the relationship between the speed of deformation in response to elongation of the linear piezoelectric element, and signal strength, and uses the measurement results as the basis for output of the deformation speed in response to the state of elongation at each location, as a constant signal strength.

Returning to Fig. 1, the signal detector 102 detects the electrical signal generated by each linear piezoelectric element 101. The signal detector 102 detects the current value and voltage value, for example, as the size of the electrical signal generated by each linear piezoelectric element. Incidentally, the linear piezoelectric elements 101 and signal detector 102 may be directly connected, but they may also be connected via an amplifier that amplifies the signal strength, or a filter (not shown). Alternatively, instead of the signal strength being the current value or voltage value, their differential values or other computed values may be used as the size of the electrical signal generated by each linear piezoelectric element. The differential value, for example, allows drastic changes in the electrical signal to be precisely obtained, or the integral value allows analysis based on the size of deformation. Also, frequency analysis allows information to be obtained relating to the state of damage or degradation of each linear piezoelectric element 101 or measured object in which each linear piezoelectric element 101 is embedded, and/or an object on which the measured object is anchored. For example, the natural frequency often changes when a portion of a measured object has been fractured, or frequency components that are not normally observed may be observed when a measured object has undergone internal detachment or damage. Needless to mention, methods such as machine learning may be used to determine the relationship between events and conditions of each linear piezoelectric element 101 or each measured object in which a linear piezoelectric element 101 is embedded, and the output waveform of each linear piezoelectric element 101.

The overrun assessing unit 103 assesses whether or not the size of the electrical signal detected by the signal detector 102 has overrun a predetermined threshold value, for each linear piezoelectric element 101, and the timing recorder 104 records the timing of overrun of the linear piezoelectric element 101 when it has been assessed by the overrun assessing unit 103 that the size of the electrical signal has overrun a predetermined threshold value. The timing of overrun of the linear piezoelectric element 101 recorded by the timing recorder 104 is stored in a memory (not shown).

For example, when the signal detector 102 is one that detects a current value as the size of the electrical signal generated by each linear piezoelectric element 101, the overrun assessing unit 103 assesses whether or not the current value detected by the signal detector has overrun a predetermined threshold value, for each linear piezoelectric element, and the timing recorder 104 records the timing of the linear piezoelectric element 101 when the size of the electrical signal has been assessed by the overrun assessing unit 103 to have overrun the predetermined threshold value.

The timing recorder 104 may also record the order of overrun of each linear piezoelectric element 101, as the timing of the linear piezoelectric element 101 recorded when the size of the electrical signal has been assessed by the overrun assessing unit 103 to have overrun the predetermined threshold value. Alternatively, the time difference between linear piezoelectric elements 101 assessed by the overrun assessing unit 103 to have overrun the predetermined threshold value may also be recorded, as the timing of the linear piezoelectric elements 101 recorded by the timing recorder 104.

An example of recording the order of overrun as the timing of overrun of each linear piezoelectric element 101 recorded by the timing recorder 104 will now be explained in greater detail.

Fig. 4 is a diagram that illustrates recording of the timing of overrun by the timing recorder according to this embodiment. In Fig. 4, the abscissa represents time [s], and the ordinate represents the size of the electrical signal generated by a linear piezoelectric element 101 as detected by a signal detector 102. Here a case is shown where stress has been applied at time $t_1$ to a measured object in which 4 linear piezoelectric elements 101 (represented as CH1, CH2, CH3 and CH4 in Fig. 4) are arranged. In Fig. 4, the distances between the location where stress has been applied and each of the linear piezoelectric elements 101 are understood to increase in length in the order: CH1, CH2, CH3, CH4. The distances between the location where stress has been applied and each of the linear piezoelectric elements 101 are different from each other, the differences appearing in the waveforms of the electrical signals generated by the linear piezoelectric elements 101. A longer distance between the location where stress has been applied and each linear piezoelectric element 101 represents a longer time for propagation of deformation, and a smaller maximum value of deformation. In the example shown in Fig. 4, when stress has been applied at time $t_1$, the electrical signal of the linear piezoelectric element 101 of CH1 overruns a predetermined threshold value at time $t_2$, the electrical signal of the linear piezoelectric element 101 of CH2 overruns a predetermined threshold value at time $t_3$, the electrical signal of the linear piezoelectric element 101 of CH3 overruns a predetermined threshold value at time $t_4$ and the electrical signal of the linear piezoelectric element 101 of CH4 overruns a predetermined threshold value at time $t_5$. Therefore, the timing recorder 104 records "CH1, CH2, CH3, CH4" as the order of overrun of the linear piezoelectric elements 101. In the explanation of Fig. 4, the predetermined threshold values for the signals from all 4 linear piezoelectric elements are the same threshold value, but the threshold values may also be set separately for each linear piezoelectric element 101, or the threshold values may vary depending on time or condition.

Returning again to Fig. 1, the region identifying unit 105 identifies the region on the measured object where stress has been applied based on the timing of overrun of the linear piezoelectric element recorded at the timing recorder 104.

When the order of overrun is recorded as the timing of overrun of each linear piezoelectric element 101 as recorded by the timing recorder 104, the region identifying unit 105 identifies the region on the measured object where stress has been applied based on the order of overrun of the linear piezoelectric elements 101 recorded at the timing recorder 104. In this case, the region identifying unit 105 has a boundary defining unit 111 and a region establishing unit 112 inside it, for example. As a modified example, a previously determined boundary line may be externally provided to the region identifying unit 105, without providing the boundary defining unit 111 inside the region identifying unit 105. When the propagation velocity is not uniform or the arrangement of the sensors is complex, the manner of use may be appropriately determined according to the need for positional precision.

Based on the order of overrun of the linear piezoelectric elements 101 recorded at the timing recorder 104, the boundary defining unit 111 defines as boundary lines the collection of points equidistant from the linear piezoelectric element 101 that has been assessed to have overrun, and the next linear piezoelectric element 101 that has been assessed to have overrun following overrun of that linear piezoelectric element 101.

The region establishing unit 112 establishes, as the region of stress application, the region that has the boundary line defined by the boundary defining unit 111 and includes the linear piezoelectric element 101 that was initially assessed to have overrun. Specific examples of establishing regions by the boundary defining unit 111 and region establishing unit 112 will be described below.

Fig. 5 is a flow chart showing the operation flow in the impact detection method with the piezoelectric sensor of Fig. 1. First, in step S201, the signal detector 102 detects electrical signals generated by application of stress on two or more linear piezoelectric elements 101 arranged near the measured object with spacing between them, for each linear piezoelectric element 101. Next, in step S202, the overrun assessing unit 103 assesses whether or not the size of the electrical signal detected by the signal detector 102 has overrun a predetermined threshold value, for each linear piezoelectric element 101. In the subsequent step S203, the timing recorder 104 records the timing for the linear piezoelectric element when it has been assessed that the size of the electrical signal has overrun the predetermined threshold value. In the next step S204, the region on the measured object where stress has been applied is identified based on the timings of the linear piezoelectric elements 101 recorded at the timing recorder 104. As an option, when the piezoelectric sensor 1000 comprises a stress calculating unit 106, stress calculation processing is carried out for the region on the measured object where stress has been applied, wherein the size of applied stress to each linear piezoelectric element 101 is calculated based on the size of the electrical signal detected by the signal detector 102, at the stage after completion of region identification processing by the region identifying unit in step S204.

In particular, when the timings of the linear piezoelectric elements 101 recorded by the timing recorder 104 have been set in order of overrun, the region-identifying step S204 includes step S204-1 and step S204-2. In step S204-1, based on the order of overrun of the linear piezoelectric elements 101 recorded at the timing recorder 104, the boundary defining unit 111 defines as boundary lines the collection of points equidistant from the linear piezoelectric element 101 that has been assessed to have overrun, and the next linear piezoelectric element 101 that has been assessed to have overrun following overrun of that linear piezoelectric element 101. In step S204-2, the region establishing unit 112 establishes, as the region of stress application, the region that has the boundary line defined by the boundary defining unit 111 and includes the linear piezoelectric element 101 that was initially assessed to have overrun.

A specific example of establishing a region by the boundary defining unit 111 and region establishing unit 112 will now be explained, for a case where the timings of the linear piezoelectric elements 101 recorded by the timing recorder 104 are in order of overrun.

Fig. 6 is a set of diagrams illustrating identification of a region of stress application with 5 linear piezoelectric elements each vertically and horizontally arranged at equal spacings, according to this embodiment. In Fig. 6, 5 linear piezoelectric elements 101 (represented as CH1, CH2, CH3, CH4 and CH5) are arranged in rows at spacing "a" in the transverse direction, while 5 linear piezoelectric elements 101 (represented as CH6, CH7, CH8, CH9 and CH10) are arranged in rows at spacing "a" in the longitudinal direction, perpendicular to those elements. When the linear piezoelectric elements 101 are arranged at spacing "a" in this manner, the number of linear piezoelectric elements 101 per unit area is "2/a". In Fig. 6, the star symbol "STAR" represents the location where stress has been applied (for example, the location on the measured object where an object has impacted), and the following explanation regards identification of the region containing the "STAR" location by a total of 10 perpendicular linear piezoelectric elements 101 at equal spacings. The propagation velocity of deformation upon application of stress is assumed to be essentially uniform.

Upon application of stress at the location indicated by the "STAR" symbol, deformation gradually propagates from this location, and the electrical signal of the linear piezoelectric element 101 of CH8 which is at the nearest location to the "STAR" symbol, as shown in Fig. 6(A) (the electrical signal generated by the linear piezoelectric element 101 of CH8) is assessed to have overrun the predetermined threshold value. For simplicity of explanation, the concept of "the electrical signal generated by the linear piezoelectric element 101 being assessed to have overrun a predetermined threshold value" will be stated as "the linear piezoelectric element 101 has detected deformation".

As shown in Fig. 6(A), among the 5 linear piezoelectric elements 101 CH6, CH7, CH8, CH9, CH10, the linear piezoelectric element 101 of CH8 is the first to detect the deformation, and if the collection of points that are equidistant from the linear piezoelectric element 101 of CH8 are represented as boundary lines H11 and H12, it can be seen that the "STAR" location where stress has been applied is included in the region including the linear piezoelectric element 101 of CH8 that is surrounded by boundary line $H_{11}$ and boundary line $H_{12}$ and is the first to detect the deformation. After detection of deformation by the linear piezoelectric element 101 of CH8, deformation is detected by the linear piezoelectric element 101 of CH3, which is at the location nearest the "STAR" symbol among the 5 linear piezoelectric elements 101 CH1, CH2, CH3, CH4, CH5. Thus, if the collection of points that are equidistant from the linear piezoelectric element 101 of CH3 are represented as boundary lines H21 and H22, it can be seen that the "STAR" location where stress has been applied is included in the region including the linear piezoelectric element 101 of CH3 that is surrounded by boundary line H21 and boundary line H22 and is the second to detect the deformation. Thus, as shown in Fig. 6(A), the "region surrounded by the boundary line H11 and boundary line H12 and the boundary line H21 and boundary line H22", which is the region of overlap between the region identified by the linear piezoelectric element 101 of CH8 that was the first to detect the deformation (the region including the linear piezoelectric element 101 of CH8 which is surrounded by the boundary line H11 and boundary line H12 and is the first to detect the deformation) and the region identified by the linear piezoelectric element 101 of CH3 that was the second to detect deformation (the region including the linear piezoelectric element 101 of CH3 that is surrounded by the boundary line H21 and boundary line H22 and is the second to detect the deformation), is identified as being the region that includes the "STAR" location where stress has been applied. Therefore, the area of the region that is locatable at the linear piezoelectric element 101 of CH8 and the linear piezoelectric element 101 of CH3, without considering the order of detection, is "a2".

Moreover, deformation was detected first by the linear piezoelectric element 101 of CH8 before the linear piezoelectric element 101 of CH3, and the order of detection of the deformation by these linear piezoelectric elements 101 (or in other words, the order in which they overrun the predetermined threshold value) means that the "STAR" location where stress has been applied is "nearer to the linear piezoelectric element 101 of CH8 than the linear piezoelectric element 101 of CH3". Therefore, the "STAR" location where stress has been applied can be further identified (pinpointed) in consideration of the order of detection of deformation by the linear piezoelectric elements 101 (that is, the order in which they overrun the predetermined threshold value). In other words, as shown in Fig. 6(B), within the "region surrounded by the boundary line $H_{11}$ and boundary line $H_{12}$ and the boundary line $H_{21}$ and boundary line $H_{22}$", the regions that have the boundary lines (represented as $H_{31}$ and $H_{32}$), as the collection of points equidistant from the linear piezoelectric element 101 of CH8 that was the first to detect the deformation and the linear piezoelectric element 101 of CH3 that was the second to detect the deformation, and include the linear piezoelectric element 101 of CH8 that was the first to detect the deformation, are identified as regions including the "STAR" location where stress has been applied (the dark-shaded regions in Fig. 6(B)). Therefore, the area of the regions that are locatable by the linear piezoelectric element 101 of CH8 that was the first to detect the deformation and the linear piezoelectric element 101 of CH3 that was the second to detect the deformation, is "$0.5 \times$ a2".

With further elapse of time after application of stress at the location indicated by the "STAR" symbol, as shown in Fig. 6(C), following detection of deformation by the linear piezoelectric element 101 of CH3, deformation is then detected by the linear piezoelectric element 101 of CH4 at the location that is the third nearest to the "STAR" symbol. Thus, among the regions identified in Fig. 6(B), the region on the side near the linear piezoelectric element 101 of CH4 that was the third to detect deformation (the region on the side where concentric circles are drawn in Fig. 6(C)) is identified as including the "STAR" location where stress has been applied. Therefore, the area of the region that is locatable by the linear piezoelectric element 101 of CH8 that was the first to detect the deformation, the linear piezoelectric element 101 of CH3 that was the second to detect the deformation and the linear piezoelectric element 101 of CH4 that was the third to detect deformation, is "$0.25 \times$ a2".

With still further elapse of time from the state shown in Fig. 6(C), following detection of deformation by the linear piezoelectric element 101 of CH4, deformation is then detected by the linear piezoelectric element 101 of CH7 at the location that is the fourth nearest to the "STAR" symbol, as shown in Fig. 6(D). Thus, among the regions identified in Fig. 6(C), the region on the side near the linear piezoelectric element 101 of CH7 that was the fourth to detect deformation (the region on the side where concentric circles arc drawn in Fig. 6(D)) is identified as including the "STAR" location where stress has been applied. Therefore, the area of the regions that are locatable by the linear piezoelectric element 101 of CH8 that was the first to detect the deformation, the linear piezoelectric element 101 of CH3 that was the second to detect the deformation, the linear piezoelectric element 101 of CH4 that was the third to detect deformation and the linear piezoelectric element 101 of CH7 that was the fourth to detect deformation is "$0.125 \times$ a2".

The region that includes the "STAR" location where stress has been applied can be gradually further narrowed down even after the state shown in Fig. 6(D), so long as the linear piezoelectric elements 101 can detect deformation.

A shorter arrangement spacing for the linear piezoelectric elements 101 or a greater number of linear piezoelectric elements 101 will increase the precision for identifying the "STAR" location where stress has been applied.

The arrangement number for a piezoelectric sensor of this embodiment and a conventional point sensor will now be compared and examined. A point sensor is a sensor that detects vibration at that point, and it differs from a line sensor in which locations parallel to lines are the regions where deformation is detected.

Fig. 7 is a set of diagrams illustrating an example of identifying a region of stress application, with conventional point sensors arranged in a lattice-like fashion with equal spacings. In Fig. 7, the point sensors are represented as "black circles", the point sensors being arranged at equal spacings in a lattice-like fashion, with spacing "a". With this type of arrangement, the number of point sensors per unit area is "$1/a^2$".

As shown in Fig. 7(A), when stress has been applied at the location of the "STAR" symbol, the point sensor A1 at the location nearest to the "STAR" symbol detects the deformation, as shown in Fig. 7(B). Therefore, the area of the region locatable by the point sensor A1 that is the first to detect the deformation is "a2". With further elapse of time, as shown in Fig. 7(C), vibration is detected by the point sensor A2 at the second nearest location to the "STAR" symbol. Therefore, the area of the region locatable by the point sensor A1 that was the first to detect the vibration and the point sensor A2 that is at the second nearest location is "0.25 × a2". With still further elapse of time, as shown in Fig. 7(D), vibration is detected by the point sensor A3 at the third nearest location to the "STAR" symbol. Therefore, the area of the region locatable by the point sensor A1 that was the first to detect the vibration, the point sensor A2 that is at the second nearest location and the point sensor A3 that is at the third nearest location, is "0.125 × a2".

Fig. 8 is a set of diagrams illustrating an example of identifying a region of stress application, with conventional point sensors arranged in a lattice-like fashion with equal spacings at a greater density than in Fig. 7 (maximum density). In Fig. 8, the point sensors are represented as "black circles", the point sensors being arranged at equal spacings in a lattice-like fashion, with spacing "a". With this arrangement, the number of linear piezoelectric elements 101 per unit area is "$(2/\sqrt{3}) \times$ a2", or "about 1.15 × a2".

As shown in Fig. 8(A), when stress has been applied at the location of the "STAR" symbol, the point sensor B1 at the location nearest to the "STAR" symbol detects the vibration, as shown in Fig. 8(B). Therefore, the area of the region locatable by the point sensor B1 that is the first to detect the vibration is "$(\sqrt{3}/2) \times$ a2", or "about 0.87 × a2". With further elapse of time, as shown in Fig. 8(C), vibration is detected by the point sensor B2 at the second nearest location to the "STAR" symbol. Therefore, the area of the region locatable by the point sensor B1 that is the first to detect the vibration and the point sensor $B_2$ that is at the second nearest location is "$(\sqrt{3}/12) \times a^2$", or "about $0.14 \times a^2$". With further elapse of time, as shown in Fig. 8(D), vibration is detected by the point sensor $B_3$ at the third nearest location to the "STAR" symbol. Therefore, the area of the region locatable by the point sensor B1 that was the first to detect the vibration, the point sensor B2 at the second nearest location and the point sensor B3 at the third nearest location, is "$(\sqrt{3}/24) \times a^2$", or "about $0.07 \times a^2$".

Fig. 9 is a graph comparing the arrangement number of a piezoelectric sensor of this embodiment and a conventional point sensor, as explained using Fig. 6 to Fig. 8. In Fig. 9, the abscissa represents the ratio of the measuring width with respect to the sensor spacing, and the ordinate represents the number of sensors necessary to identify a location. Also, Fig. 10 is a table comparing the arrangement number and identifiable area for a piezoelectric sensor of this embodiment and a conventional point sensor, as explained using Fig. 6 to Fig. 8. As seen from Fig. 9 and Fig. 10, the piezoelectric sensor of this embodiment can reduce the arrangement number of sensors per unit area compared to a conventional point sensor, allowing the location of applied stress to be identified with a smaller number of sensors.

The experimental results of identifying a region of stress application with 4 linear piezoelectric elements each vertically and horizontally arranged at equal spacings, according to this embodiment, will now be explained with reference to Fig. 11 to Fig. 18. Fig. 11 to Fig. 14 relate to an experiment in which 4 linear piezoelectric elements each were arranged vertically and horizontally at equal spacings in a lattice-like fashion, and Fig. 15 to Fig. 18 relate to an experiment in which 2 among 7 linear piezoelectric elements were arranged in an inverted U-shape. The measured object was carbon fiber-reinforced plastic (CFRP), having a size of 1000 mm × 1000 mm × 5 mm. The frame of the base on which the measured object was anchored had a size of 910 mm × 910 mm. Adhesive tape was used to anchor the measured object and the linear piezoelectric elements 101.

Fig. 11 is a pair of actual photographs showing a piezoelectric sensor having 4 linear piezoelectric elements arranged in a lattice-like fashion vertically and horizontally at equal spacings, according to this embodiment, (A) showing the outer side (surface) of the measured object and (B) showing the back side of the measured object. On the measured object composed of carbon fiber-reinforced plastic, linear piezoelectric elements 101 of CH1 to CH8 are anchored to the back sides of the locations represented as thick dotted lines in Fig. 11(A), by adhesive tape having a length of 880 mm, as shown in Fig. 11(B). Each linear piezoelectric element 101 had a length of 880 mm, and the spacing of arrangement of the linear piezoelectric elements 101 was 180 mm

Fig. 12 is a graph showing an example of the voltage value of the electrical signal generated by different linear piezoelectric elements, when an iron ball is dropped onto a measured object on which the piezoelectric sensor shown in Fig. 11 has been anchored. In Fig. 12, the abscissa represents time [s], and the ordinate represents the voltage value of the electrical signal generated at each linear piezoelectric element 101.

Fig. 13 is a set of diagrams showing the results of identifying regions when dropping iron balls on different locations of a measured object on which the piezoelectric sensor shown in Fig. 11 has been anchored. In Fig. 13, the black circles represent the locations where stress has been applied. Also in Fig. 13, the thick solid lines schematically represent the reaction times (that is, the times from dropping of the iron ball until the linear piezoelectric elements 101 have detected deformation) for the linear piezoelectric elements 101 of CH1 to CH4 arranged in lines in the longitudinal direction, the thick solid lines having shorter reaction times the further upward they are on the abscissa. Similarly, the thick broken lines schematically represent the reaction times (that is, the times from dropping of the iron ball until the linear piezoelectric elements 101 have detected deformation) for the linear piezoelectric elements 101 of CH5 to CH8 arranged in lines in the transverse direction, the thick broken lines having shorter reaction times the further rightward they are on the ordinate. For this embodiment, as shown in Fig. 13(A) to Fig. 13(E), when stress has been applied by dropping an iron ball at any location of the measured object, a correlation exists between the location where the iron ball is dropped and the time after dropping of the iron ball until the linear piezoelectric element 101 detects deformation. This indicates the effectiveness of this embodiment for detecting the time from dropping of the iron ball until the linear piezoelectric element 101 detects deformation, for each of the linear piezoelectric elements 101 of CH1 to CH8, and identifying the region of stress application based on the order of detection (in other words, the order in which they overrun the predetermined threshold value). The region of stress application may similarly be identified based on the order of shortness of the time difference of the linear piezoelectric elements 101 in which the size of the electrical signal is assessed to have overrun the predetermined threshold value after application of stress, instead of the order of detection of deformation by the linear piezoelectric elements 101 of CH1 to CH8.

Fig. 14 is a pair of graphs showing the measurement results for the size of stress detected in regions when an iron ball is dropped onto different locations of a measured object on which the piezoelectric sensor shown in Fig. 11 has been anchored, Fig. 14(A) showing the impact energy detected by linear piezoelectric elements CH1 to CH4 arranged in a line in the longitudinal direction, and Fig. 14(B) showing the impact energy detected by linear piezoelectric elements CH5 to CH8 arranged in a line in the transverse direction. The impact energies were calculated based on the weight of the iron ball and the speed of the iron ball during impact. As seen from Fig. 14(A) and Fig. 14(B), the size of the electrical signal of the linear piezoelectric element 101 generated by application of stress is proportional to the impact energy detected in the region where deformation of each linear piezoelectric element 101 can be detected. According to this embodiment, therefore, the size of stress applied to the linear piezoelectric element 101 can be calculated at the stress calculating unit 106, based on the size of the electrical signal.

Fig. 15 is a pair of actual photographs showing a piezoelectric sensor having 7 linear piezoelectric elements, 2 of which are configured into an inverted U-shape, according to this embodiment, Fig. 15(A) showing the outer side (surface) of the measured object and Fig. 15(B) showing the back side of the measured object. Fig. 16 is a diagram showing the configuration positions of the piezoelectric sensor on the measured object of Fig. 15. On the measured object composed of carbon fiber-reinforced plastic, linear piezoelectric elements 101 of CH1 to CH8 are anchored to the back sides of the locations represented as thick dotted lines in Fig. 15(A), by adhesive tape, as shown in Fig. 15(B). Each linear piezoelectric element 101 had a length of 880 mm, and the spacing of arrangement of the linear piezoelectric elements 101 was 180 mm. As shown in Fig. 15(A) and Fig. 15(B), linear piezoelectric elements 101 of CH2 and CH3 were configured in inverted U-shapes, so as to allow precise region identification at the portion of region M.

Fig. 17 is a graph showing an example of the voltage value of the electrical signal generated by different linear piezoelectric elements, when an iron ball is dropped onto a measured object on which the piezoelectric sensor shown in Fig. 15 has been anchored. In Fig. 17, the abscissa represents time [s], and the ordinate represents the voltage value of the electrical signal generated at each linear piezoelectric element 101.

Fig. 18 is a set of diagrams showing the results of identifying regions when dropping iron balls on different locations of a measured object on which the piezoelectric sensor shown in Fig. 15 has been anchored. In Fig. 18, the black circles represent the locations where stress has been applied. Also in Fig. 18, the fat solid line represents the linear piezoelectric element 101 that is first to detect the deformation, the thick broken line represents the linear piezoelectric element 101 that is the second to detect the deformation, the fat dash-dot line represents the linear piezoelectric element 101 that is the third to detect deformation, and the fat two-dot-dash line represents the linear piezoelectric element 101 that is the fourth to detect deformation. For this embodiment, as shown in Fig. 18(A) and Fig. 18(B), the linear piezoelectric elements 101 can detect deformation in order of nearness to the location where an iron ball has been dropped, even when the linear piezoelectric elements 101 are configured in a bent fashion. This indicates that regardless of the shape of arrangement of the linear piezoelectric elements 101, it is possible to identify the region of stress application based on the order of detection of deformation (in other words, the order in which they overrun the predetermined threshold value).

There is no limitation to the form of measured object that may be detected by the piezoelectric sensor 1000 of this embodiment. The above description is for an example of placing the linear piezoelectric element on a flat measured object and identifying the region where stress is applied, but the piezoelectric sensor 1000 of this embodiment can also identify regions of stress application on a non-flat surface (for example, a curved surface). Fig. 19 is a diagram showing an example of placement of linear piezoelectric elements on the non-flat surface of a measured object. In the example shown here, the measured object has a cylindrical shape, and 3 linear piezoelectric elements 101 CH4 to CH6 are arranged on the curved surface of the measured object. The signal detector 102, overrun assessing unit 103, timing recorder 104 and region identifying unit 105 described with reference to Fig. 1 are connected to the linear piezoelectric elements 101 (though they are not shown in Fig. 19), allowing identification of the region where stress is applied by the operating principle already explained above. A stress calculating unit 106 may also be connected as an option (though it is not shown in Fig. 19), and the size of the stress applied to the linear piezoelectric element 101 can be calculated based on the size of the electrical signal.

For the embodiment described above, two or more linear piezoelectric elements were arranged near a measured object for identification of a region where stress was applied near the measured object, and the region on the measured object where stress was applied was identified based on the timing at which the electrical signal overran the threshold value for each linear piezoelectric element, but as a modified example, the region on the measured object where stress has been applied may be identified by the magnitude of the size of the electrical signal (signal strength).

Furthermore, machine learning technology wherein electrical signals output from linear piezoelectric elements are inputted (artificial intelligence technology: AI) may be used to prepare a learned model, and the state of the measured object observed and predicted based on the learned model. Since a piezoelectric sensor of this aspect may also be utilized as an IoT device, it can be installed in a shop or facility, and used to create learned models relating to the relationship between obtained temporal data and meteorological data for atmospheric temperature, humidity, weather and weather forecasting, by machine learning, so as to predict degrees of congestion at shops and facilities from the latest weather forecasts based on the learned models, and create proper staffing plans. In the field of transportation as well, it is possible to install piezoelectric sensors of this aspect in multiple vehicles and prepare learned models relating to the relationship between obtained temporal data and vehicle travel route data, by machine learning, making it possible to present preferential routes having low detected pressure, i.e. routes with low potential for collision and smoother roads that are easier to travel, when setting routes with car navigation before actual traveling, based on the learned models.

Moreover, with the embodiment described above, two or more linear piezoelectric elements were situated near a measured object in order to identify regions of applied stress near the measured object, but it is sufficient to provide only one or more linear piezoelectric elements if the purpose is only to detect the application of stress itself on the measured object, or only to detect the size of stress applied to the measured object. Fig. 20 is a schematic diagram showing the basic construction of a piezoelectric sensor according to another embodiment.

According to another embodiment shown in Fig. 20, a piezoelectric sensor 1000 is constructed so as to detect just the application of stress itself on a measured object or to detect only the size of stress applied to the measured object. The piezoelectric sensor 1000 comprises a linear piezoelectric element 101, a signal detector 102, an application assessing unit 107 and a stress calculating unit 106.

The linear piezoelectric element 101 generates an electrical signal in response to applied stress, as already explained above. When stress (impact) is applied to a measured object (including when stress is directly applied to the linear piezoelectric element 101), deformation by elongation is produced in the linear piezoelectric element 101. This elongation deformation causes an electrical signal to be generated in the linear piezoelectric element 101. One or more linear piezoelectric elements 101 are disposed near the measured object, where the impact is to be measured. In the example shown in Fig. 20, only one linear piezoelectric element 101 is used. The linear piezoelectric element 101 may be distributed in any manner so long as it is near the measured object. Specific examples of materials to form the linear piezoelectric element 101 are as described above and below. Since the linear piezoelectric element composing the sensor portion of the piezoelectric sensor is highly flexible, it can be easily installed to match the shape of a measured object, and it can be used as an impact sensor or stress detecting sensor for various types of measured objects.

The signal detector 102 detects the electrical signal generated by the linear piezoelectric element 101. The signal detector 102 detects the current value and voltage value, for example, as the size of the electrical signal generated by the linear piezoelectric element. Incidentally, the linear piezoelectric elements 101 and signal detector 102 may be directly connected, but they may also be connected via an amplifier that amplifies the signal strength, or a filter (not shown). Alternatively, instead of the signal strength being the current value or voltage value, their differential values or other computed values may be used as the size of the electrical signal generated by the linear piezoelectric element. The differential value, for example, allows drastic changes in the electrical signal to be precisely obtained, or the integral value allows analysis based on the size of deformation.

The overrun assessing unit 103 assesses whether or not the size of the electrical signal detected by the signal detector 102 has overrun a predetermined threshold value. The assessment results from the overrun assessing unit 103 are sent to the application assessing unit 107. For example, when the signal detector 102 is one that detects a current value as the size of the electrical signal generated by the linear piezoelectric element 101, the overrun assessing unit 103 assesses whether or not the current value detected by the signal detector has overrun a predetermined threshold value.

The application assessing unit 107 assesses that stress has been applied to the measured object near to which the linear piezoelectric element 101 has been situated, when the size of the electrical signal has been assessed by the overrun assessing unit 103 to have overrun the threshold value. At this time, the application assessing unit 107 may record, in a memory (not shown), the time at which stress has been applied to the measured object near to which the linear piezoelectric element 101 has been situated. The application assessing unit 107 assesses that stress has not been applied to the measured object near to which the linear piezoelectric element 101 has been situated, when the size of the electrical signal has been assessed by the overrun assessing unit 103 to have not overrun the threshold value (when the size of the electrical signal has not been assessed by the overrun assessing unit 103 to have overrun the threshold value).

The stress calculating unit 106 calculates the size of stress applied to the linear piezoelectric element 101 based on the size of the electrical signal detected by the signal detector 102.

Fig. 21 is a flow chart showing the operation flow in the impact detection method with the piezoelectric sensor of Fig. 20. First, in step S301, the signal detector 102 detects an electrical signal generated by application of stress on the linear piezoelectric element 101 near the measured object. Next, in step S302, the overrun assessing unit 103 assesses whether or not the size of the electrical signal detected by the signal detector 102 has overrun a predetermined threshold value. When the size of the electrical signal has been assessed to have overrun a predetermined threshold value in step S302, the application assessing unit 107, in step S303-1, assesses that stress has been applied to the measured object near to which the linear piezoelectric element 101 has been situated. At this time, the application assessing unit 107 may record, in a memory, the time at which stress has been applied to the measured object near to which the linear piezoelectric element 101 has been situated. In addition, while not shown in Fig. 21, after step S303-1, the stress calculating unit 106 carries out stress calculation processing in which it calculates the size of stress applied to the linear piezoelectric element 101 based on the size of the electrical signal detected by the signal detector 102. The application assessing unit 107 assesses that stress has not been applied to the measured object near to which the linear piezoelectric element 101 has been situated, when the size of the electrical signal has been assessed in step S302 to have not overrun the threshold value (when the size of the electrical signal has not been assessed to have overrun the threshold value). This modified example was explained as a case in which one value is set as the threshold value, but alternatively several threshold values may be set, and the amount of deformation assessed in a stepwise manner from the sizes of signals detected as electrical signals.

(Measured object)

The measured objects used may be of any shapes and materials that allow the linear piezoelectric element to be placed near it and allow an electrical signal to be extracted from the linear piezoelectric element upon application of stress. For example, measured objects having any shapes with not only flat surfaces but also non-flat surfaces or partially non-flat surfaces may be used. The method of anchoring the linear piezoelectric element of the invention near a measured object is not particularly restricted so long as it produces deformation in the linear piezoelectric element in response to stress (impact) applied to the measured object. For example, it may be a method of directly anchoring it through pressure-sensitive adhesive tape or an adhesive, with the length of anchoring being appropriately determined. All of the portions where signals are to be detected may be anchored, or only both of their ends may be anchored. The piezoelectric sensor may be a woven fabric or knitted fabric employing a linear piezoelectric element. The piezoelectric sensor may be formed by embroidering, bonding or attaching the linear piezoelectric element on a flexible flat measured object. Alternatively, a hollow tube-like piezoelectric sensor including braids, or a piezoelectric sensor enclosed in bag tape, may be anchored to the measured object. In such cases as well, the length and area of anchoring may be determined as appropriate. The piezoelectric sensor may not only be anchored on the surface of the measured object but it may also be anchored inside the measured object, so long as the effect of the invention is exhibited. For example, the piezoelectric sensor may be integrally molded with the measured object while embedded in a thermosetting resin or in a thermoplastic resin whose molding temperature is below the melting temperature of the material composing the piezoelectric element. The piezoelectric sensor used in this case may be one having another sheath layer provided or coated on the uppermost surface layer of the braided piezoelectric element, for improved adhesion with the measured object.

(Linear piezoelectric element)

The linear piezoelectric element of the invention that is used may be any publicly known one that generates an electrical signal in response to applied stress. For example, the linear piezoelectric element used may be a piezoelectric element having a core-sheath structure with a conductive fiber as the core thread and piezoelectric fibers situated around it. More specifically, the linear piezoelectric element used may be a piezoelectric element having a piezoelectric film or piezoelectric fibers simply wrapped around a conductive fiber, or a braided piezoelectric element having piezoelectric fibers wrapped in a braided manner around a conductive fiber. Of these, the linear piezoelectric element of the invention is preferably a piezoelectric element that outputs a larger electrical signal in response to elongation deformation, and from this viewpoint it is more preferably a braided piezoelectric element. A braided piezoelectric element will now be explained in detail.

(Braided piezoelectric element)

Fig. 22 is a schematic diagram showing an example of the construction of a braided piezoelectric element according to an embodiment.

The braided piezoelectric element 1 comprises a core 3 formed of a conductive fiber B and a sheath 2 formed of braided piezoelectric fibers A covering the core 3.

In the braided piezoelectric element 1, a plurality of piezoelectric fibers A are compactly coiled around the outer peripheral surface of at least one conductive fiber B. It is surmised that when deformation is produced in the braided piezoelectric element 1, stress is produced in each of the piezoelectric fibers A by the deformation, producing an electric field in each of the piezoelectric fibers A (piezoelectric effect), and as a result a voltage change takes place in the conductive fiber B, superimposed on the electric field of the plurality of piezoelectric fibers A coiled around the conductive fiber B. That is, the electrical signal from the conductive fiber B is augmented compared to when the braided sheath 2 of piezoelectric fibers A is not used. This allows a large electrical signal to be extracted with the braided piezoelectric element 1, even by stress produced by relatively small deformation. Incidentally, the conductive fiber B may also consist of a plurality of fibers.

The braided piezoelectric element 1 is preferably one that selectively outputs a large electrical signal in response to elongation deformation, in the direction of its central axis (CL in Fig. 22).

(Braided piezoelectric element selectively outputting large electrical signal in response to elongation deformation)

The braided piezoelectric element 1 that selectively outputs a large electrical signal in response to elongation deformation in the central axis direction may be one wherein, for example, the piezoelectric fibers A used are molded from a uniaxially oriented polymer, which is a piezoelectric polymer including, as a main component, a crystalline polymer having an absolute value of between 0.1 pC/N and 1000 pC/N for the piezoelectric constant d14 when the orientation axis is the third axis. According to the invention, "including ... as the main component" means that the constituent component constitutes 50 mass% or greater. For the purpose of the invention, a crystalline polymer is a polymer comprising a crystalline portion at 1 mass% or greater, and also comprising an amorphous portion in addition to the crystalline portion, where the mass of the crystalline polymer is its total mass including the crystalline portion and the amorphous portion. Incidentally, while different values are obtained for d14 depending on the molding conditions, purity and measuring atmosphere, for the purpose of the present invention it is sufficient if, based on measurement of the degree of crystallinity and crystal orientation of the crystalline polymer measured for the piezoelectric polymer that is actually used, the absolute value of d14 for the film is between 0.1 pC/N and 1000 pC/N at the temperature of actual use, when a uniaxially stretched film having the same degree of crystallinity and crystal orientation is fabricated using the crystalline polymer, and the crystalline polymer in the piezoelectric polymer of this embodiment is not limited to specific crystalline polymers such as those mentioned below. Measurement of d14 for a film sample may be made by a publicly known method, and for example, a sample having metal vapor-deposited electrodes on both sides of the film sample may be cut out into a 4-sided rectangular shape in a direction inclined 45° from the stretching direction, and the electrical charge generated at the electrodes on both sides may be measured under a tensile load in the longitudinal direction, to measure the d14 value.

In the braided piezoelectric element 1 that selectively outputs a large electrical signal in response to elongation deformation in the central axis direction, preferably the angle formed between the central axis direction and the direction of orientation of the piezoelectric polymer (the orientation angle $\theta$) is between 15° and 75°. When this condition is satisfied, application of elongation deformation (tensile stress and compression stress) in the central axis direction with respect to the braided piezoelectric element 1 allows efficient utilization of the piezoelectric effect corresponding to the piezoelectric constant d14 of the crystalline polymer in the piezoelectric polymer, and allows electrical charges of opposite polarity (reverse signs) to be efficiently generated on the central axis side and the outside of the braided piezoelectric element 1. From this viewpoint, the orientation angle $\theta$ is preferably between 25° and 65°, more preferably between 35° and 55° and even more preferably between 40° and 50°. Such an arrangement of the piezoelectric polymer will cause the orientation direction of the piezoelectric polymer to manifest as a helix.

Such an arrangement of the piezoelectric polymer will also allow a braided piezoelectric element 1 to be obtained that avoids generating large electrical charge on the central axis side and the outside of the braided piezoelectric element 1 in response to shear deformation which rubs against the surface of the braided piezoelectric element 1, or to bending deformation which bends the central axis, or to twisting deformation around the central axis, or in other words, that selectively generates a large electrical charge in response to elongation in the central axis direction.

The orientation angle $\theta$ is measured by the following method when possible. A side photograph of the braided piezoelectric element 1 is taken, and the helical pitch HP of the piezoelectric polymer A' is measured. As shown in Fig. 23, the helical pitch HP is the linear distance in the central axis direction that is required for one piezoelectric polymer A' to extend from the front side around the back side and return again to the front side. After the structure has been anchored with an adhesive if necessary, a cross-section is cut out perpendicular to the central axis of the braided piezoelectric element 1 and photographed, and the outer radius Ro and inner radius Ri are measured at the portion occupied by the sheath 2. When the outer edge and inner edge of the cross-section are elliptical or flattened circular, Ro and Ri are the average values of the long diameter and short diameter, respectively. The orientation angle $\theta$ of the piezoelectric polymer with respect to the direction of the central axis is calculated by the following formula.

$$\theta = \arctan(2\pi Rm/HP)\ (0^\circ \leq \theta \leq 90^\circ)$$

Here, $Rm = 2(Ro^3 - Ri^3)/3(Ro^2 - Ri^2)$, i.e. the radius of the braided piezoelectric element 1 as the weighted average based on the cross-sectional area.

When the piezoelectric polymer has a uniform surface in a side photograph of the braided piezoelectric element 1, such that the helical pitch of the piezoelectric polymer cannot be distinguished, the braided piezoelectric element 1 anchored with the adhesive is cross-cut on a plane running through the central axis, and wide-angle X-ray diffraction analysis is performed with X-ray transmission in the direction perpendicular to the cross-cut surface, in a sufficiently narrow range running through the central axis, determining the orientation direction and measuring its angle with the central axis as $\theta$.

In the case of the braided piezoelectric element 1 of the invention, the helix manifesting along the direction of orientation of the piezoelectric polymer will sometimes consist of two or more simultaneously present helices with different helical directions (S-twisting direction or Z-twisting direction) or helical pitches, in which case each piezoelectric polymer having a different helical direction and helical pitch is measured, and the piezoelectric polymer of one helical direction and helical pitch must satisfy the aforementioned condition.

The charge polarity generated on the central axis side and the outside in response to elongation deformation in the central axis direction is mutually opposite when the direction of orientation of the piezoelectric polymer is situated along an S-twisted helix and when the direction of orientation of the piezoelectric polymer is situated along a Z-twistcd helix. Therefore, if the direction of orientation of the piezoelectric polymer is situated along an S-twisted helix while also being situated along a Z-twisted helix, the charges generated in response to elongation deformation will cancel each other out in the S-twisting direction and the Z-twisting direction, which is undesirable as it will prevent efficient utilization. Therefore, the piezoelectric polymer includes a P-body containing a crystalline polymer with a positive piezoelectric constant dl4 value as the main component and an N-body containing a crystalline polymer with a negative value as the main component, wherein for a portion of the central axis of the braided piezoelectric element 1 having a length of 1 cm, the value of T1/T2 is preferably between 0 and 0.8 and more preferably between 0 and 0.5, T1 being the smaller and T2 being the larger of (ZP + SN) and (SP + ZN), where ZP is the mass of the P-body having the orientation axis wrapped in a helical fashion around the Z-twisting direction, SP is the mass of the P-body having the orientation axis wrapped in a helical fashion around the S-twisting direction, ZN is the mass of the N-body having the orientation axis wrapped in a helical fashion around the Z-twisting direction, and SN is the mass of the N-body having the orientation axis wrapped in a helical fashion around the S-twisting direction.

When fibers including polylactic acid are used as the main component for the piezoelectric fibers of the invention, the polylactic acid contains the lactic acid unit in a proportion of preferably at least 90 mol%, more preferably at least 95 mol% and even more preferably at least 98 mol%.

In the braided piezoelectric element 1, so long as the purpose of the invention is achieved, combined filaments may be prepared in combination with fibers other than the piezoelectric fibers A for the sheath 2, and combined filaments may be prepared in combination with fibers other than the conductive fiber B for the core 3.

There is no particular restriction on the length of the braided piezoelectric element composed of the core 3 of the conductive fiber B and the sheath 2 of the braided piezoelectric fibers A, and it may be appropriately determined according to the size and shape of the measuring region on the measured object. For example, the braided piezoelectric element may be produced in a continuous manner during production, and cut to the necessary length afterwards for use. The length of the braided piezoelectric element is 1 mm to 20 m, preferably 1 cm to 10 m and more preferably 10 cm to 5 m. If the length is too short, the effect of the invention, i.e. the effect of allowing the arrangement number of sensors per unit area to be reduced, and allowing the location of applied stress to be identified with a small number of sensors, may not be adequately achieved compared to a conventional point sensor, while if the length is too long, it may become necessary to consider the resistance value of the conductive fiber B. However, the need to consider the resistance value, for example, may be eliminated by measuring the current value, while noise can be minimized (or eliminated) by amplifying the signal, and therefore it is particularly preferred to use a current amplification type amplifier.

Each of the structural aspects will now be explained in greater detail.

(Conductive fiber)

The conductive fiber B used may be any publicly known one that exhibits conductivity. Examples for the conductive fiber B include metal fibers, fibers made of conductive polymers, carbon fibers, fibers made of polymers dispersing fibrous or granular conductive fillers, or fibers forming a layer with conductivity on the surface of a fibrous substance. The method of forming a layer with conductivity on the surface of a fibrous substance may be metal coating, conductive polymer coating or conductive fiber coiling. Metal coating is preferred among these from the viewpoint of conductivity, durability, flexibility and the like. The specific method of coating a metal may be vapor deposition, sputtering, electrolytic plating, electroless plating or the like, with plating being preferred from the viewpoint of productivity. Fibers that have been metal-plated in this manner may be considered to be metal-plated fibers.
The base fiber that has been coated with a metal may be a publicly known fiber, regardless of whether it has or lacks conductivity, examples of which include synthetic fibers such as polyester fiber, nylon fiber, acrylic fiber, polyethylene fiber, polypropylene fiber, vinyl chloride fiber, aramid fiber, polysulfone fiber, polyether fiber and polyurethane fiber, as well as natural fibers such as cotton, hemp and silk, semisynthetic fibers such as acetate, and regenerated fibers such as rayon and cupra. The base fiber is not limited to these, and any publicly known fiber may be used, or combinations of these fibers may be used.
The metal to be coated onto the base fiber may be any type that exhibits conductivity and exhibits the effect of the invention. Examples to be used include gold, silver, platinum, copper, nickel, tin, zinc, palladium, indium tin oxide, copper sulfide and the like, as well as their mixtures and alloys.
When an organic fiber coated with a metal with bending resistance is used as the conductive fiber B, the conductive fiber will be very highly unlikely to break and the durability and safety of a sensor using the piezoelectric element will be excellent.
The conductive fiber B may be a multifilament consisting of a bundle of multiple filaments, or a monofilament consisting of a single filament. A multifilament is preferred from the viewpoint of long-term stability of the electrical characteristics. In the case of a monofilament (including spun yarn), the monofilament diameter is 1 $\mu$m to 5000 $\mu$m and preferably 2 $\mu$m to 100 $\mu$m. It is more preferably 3 $\mu$m to 50 $\mu$m. In the case of a multifilament, the number of filaments is preferably from 1 to 100,000, more preferably 5 to 500 and even more preferably 10 to 100. However, the fineness and number of conductive fibers B is the fineness and number of cores 3 used to prepare the braid, and a multifilament formed of a plurality of single threads (monofilaments) is counted as one conductive fiber B. The core 3 is the overall amount, including fibers other than conductive fibers when they are used.
If the diameter of the fiber is small the strength will be reduced and handling may become difficult, while if the diameter is large there may be some sacrifice of flexibility. The cross-sectional shape of the conductive fiber B is preferably circular or elliptical from the viewpoint of design and production of the piezoelectric element, but this is not limitative.
A lower electrical resistance is preferred for efficient extraction of electrical output from the piezoelectric polymer, the volume resistivity being preferably no greater than $10^{-1}$ $\Omega\cdot$cm, more preferably no greater than $10^{-2}$ $\Omega\cdot$cm and even more preferably no greater than $10^{-3}$ $\Omega\cdot$cm. However, the resistivity of the conductive fiber B is not limited to this range so long as sufficient strength can be obtained for detection of the electrical signal.
For use according to the present invention, the conductive fiber B must be resistant to movements such as repeated bending and twisting. As one indicator of such a property, a larger knot tenacity is preferred. The knot tenacity can be measured by the method of JIS L1013 8.6. The degree of knot tenacity suitable for the invention is preferably 0.5 cN/dtex or greater, more preferably 1.0 cN/dtex or greater, even more preferably 1.5 cN/dtex or greater and most preferably 2.0 cN/dtex or greater. As another indicator, low flexural rigidity is preferred. Flexural rigidity is generally measured with a measuring apparatus such as a KES-FB2 Pure Bending Tester by Kato Tech Corp. The degree of flexural rigidity suitable for the invention is preferably lower than that of the carbon fibers TENAX$^R$ HTS40-3K by Toho Tenax Co., Ltd. Specifically, the flexural rigidity of the conductive fiber is preferably no greater than $0.05 \times 10^{-4}$ N$\cdot$m$^2$/m, more preferably no greater than $0.02 \times 10^{-4}$ N$\cdot$m$^2$/m and even more preferably no greater than $0.01 \times 10^{-4}$ N$\cdot$m$^2$/m.

(Piezoelectric fibers)

The piezoelectric polymer used as the material for the piezoelectric fibers A may be a polymer exhibiting piezoelectricity such as polyvinylidene fluoride or polylactic acid, but the piezoelectric fibers A described above for this embodiment preferably include a crystalline polymer with a high absolute value for the piezoelectric constant d14 when the orientation axis is the third axis, and especially polylactic acid, as the main component. Polylactic acid is readily oriented and exhibits piezoelectricity by stretching after melt spinning, for example, and has excellent productivity since it does not require electric field orientation treatment as is necessary with polyvinylidene fluoride and the like. However, this is not intended to exclude the use of polyvinylidene fluoride and other piezoelectric materials for carrying out the present invention.
Polylactic acid includes poly-L-lactic acid obtained by polymerization of L-lactic acid and L-lactide, poly-D-lactic acid obtained by polymerization of D-lactic acid and D-lactide, and stereocomplex polylactic acid comprising a hybrid structure of these, depending on the crystal structure, and any of these may be used so long as they exhibit piezoelectricity. Poly-L-lactic acid and poly-D-lactic acid are preferred from the viewpoint of a high piezoelectric modulus. Since poly-L-lactic acid and poly-D-lactic acid exhibit opposite polarization in response to the same stress, they may be used in combination depending on the purpose.

The optical purity of the polylactic acid is preferably 99% or greater, more preferably 99.3% or higher and even more preferably 99.5% or higher. If the optical purity is less than 99% the piezoelectric modulus may be significantly lowered, potentially making it difficult to obtain a sufficient electrical signal by shape deformation of the piezoelectric fibers A. Most preferably, the piezoelectric fibers A include poly-L-lactic acid or poly-D-lactic acid as the main component, with an optical purity of 99% or greater.

Piezoelectric fibers A composed mainly of polylactic acid are stretched during production, and are uniaxially oriented in their fiber axis direction. Furthermore, preferably the piezoelectric fibers A are not only uniaxially oriented in the fiber axis direction but also include polylactic acid crystals, and more preferably they include uniaxially oriented polylactic acid crystals. This is because polylactic acid exhibits higher piezoelectricity and has a higher absolute value for d14 by having high crystallinity and being uniaxially oriented.

The crystallinity and uniaxial orientation are determined by the homo PLA crystallinity $X_{homo}$ (%) and crystal orientation Ao (%). The piezoelectric fibers A of the invention preferably have a homo PLA crystallinity $X_{homo}$ (%) and crystal orientation Ao (%) satisfying the following inequality (1).

$$X_{homo} \times Ao \times Ao \div 10^6 \geq 0.26 \ (1)$$

If inequality (1) is not satisfied, the crystallinity and/or uniaxial orientation will be insufficient, the output value of the electrical signal for operation may be reduced and the sensitivity of the signal for operation in a specific direction may be reduced. The value of the left side of inequality (1) is more preferably 0.28 or greater, and even more preferably 0.3 or greater. Each of the values is determined in the following manner.

Homopolylactic acid crystallinity $X_{homo}$:

The homopolylactic acid crystallinity $X_{homo}$ is determined from crystal structure analysis by wide-angle X-ray diffraction (WAXD). In wide-angle X-ray diffraction (WAXD), an Ultrax18 X-ray diffraction apparatus by Rigaku Corp. is used in a transmission method, and the X-ray diffraction pattern of a sample is recorded on an imaging plate under the following conditions.

X-ray source: Cu-Kα rays (confocal mirror)
Output: 45 kV × 60 mA
Slits: 1st: 1 mmΦ, 2nd: 0.8 mmΦ
Camera length: 120 mm
Elapsed time: 10 minutes
Sample: 35 mg of polylactic acid fibers are aligned to form a 3 cm fiber bundle.

The total scattering intensity $I_{total}$ over the declination in the obtained X-ray diffraction pattern is determined, and the sum $\Sigma I_{HMi}$ of the integrated intensity for each diffraction peak attributed to homopolylactic acid crystals, appearing near 2θ = 16.5°, 18.5° and 24.3°, is calculated. Based on these values, the homopolylactic acid crystallinity $X_{homo}$ is calculated by the following formula (2).

$$\text{Homopolylactic acid crystallinity } X_{homo} (\%) = \Sigma I_{HMi} / I_{total} \times 100 \ (2)$$

The value of $\Sigma I_{HMi}$ is calculated by subtracting the background and amorphous diffuse scattering from the total scattering intensity.

(2) Crystal orientation Ao:

In the X-ray diffraction pattern obtained by the aforementioned wide-angle X-ray diffraction (WAXD), the crystal orientation Ao has an intensity distribution with respect to the declination (°) for the diffraction peaks attributable to homopolylactic acid crystals, appearing near 2θ = 16.5° in the radius vector direction, and it is calculated from the sum ΣWi (°) of the half-widths in the obtained distribution profile, using the following formula (3).

$$\text{Crystal orientation Ao (\%)} = (360 - \sum W_i) \div 360 \times 100 \ (3)$$

Incidentally, since polylactic acid is a polyester with relatively rapid hydrolysis, a publicly known hydrolysis preventer such as an isocyanate compound, oxazoline compound, epoxy compound or carbodiimide compound may be added when resistance to moist heat is an issue. Also, if necessary, an antioxidant, plasticizer, photodegradation inhibitor or the like such as a phosphoric acid-based compound may be added to modify the physical properties.

The piezoelectric fibers A may be multifilaments consisting of bundles of multiple filaments, or a monofilament consisting of a single filament. In the case of monofilaments (including spun yarn), the monofilament diameter is 1 μm to 5 mm, preferably 5 μm to 2 mm and even more preferably 10 μm to 1 mm. In the case of multifilaments, the single filament diameter is 0.1 μm to 5 mm, preferably 2 μm to 100 μm and even more preferably 3 μm to 50 μm. The number of filaments for a multifilament is preferably from 1 to 100,000, more preferably 50 to 50,000 and even more preferably 100 to 20,000. However, the fineness and number of piezoelectric fibers A is the fineness and number per carrier when preparing the braid, with a multifilament formed of a plurality of single threads (monofilaments) being counted as one piezoelectric fiber A. One carrier includes the overall amount, including fibers other than piezoelectric fibers when they are used.

In order to obtain piezoelectric fibers A from such a piezoelectric polymer, any publicly known method for forming fibers from a polymer may be employed so long as the effect of the invention is exhibited. For example, a method of forming fibers by extrusion molding of the piezoelectric polymer, a method of forming fibers by melt spinning of the piezoelectric polymer, a method of forming fibers by dry or wet spinning of the piezoelectric polymer, a method of forming fibers by electrostatic spinning of the piezoelectric polymer, or a method of forming a film and then finely cutting it, may be employed. The spinning conditions employed may be according to a publicly known process suitable for the piezoelectric polymer used, and for most cases a melt spinning process may be employed, which will facilitate industrial production. After formation of the fibers, the formed fibers may also be stretched. This will form piezoelectric fibers A that are uniaxially stretched and oriented, include crystals, and exhibit high piezoelectricity.

In addition, the piezoelectric fibers A may be treated by dyeing, twisting, doubling, heat treatment or the like, before braiding of the fibers prepared as described above.

In addition, since the piezoelectric fibers A will sometimes become twisted together or broken, or produce fluff, during formation of the braid, their strength and abrasion resistance is preferably high, the strength being preferably 1.5 cN/dtex or greater, more preferably 2.0 cN/dtex or greater, even more preferably 2.5 cN/dtex or greater and most preferably 3.0 cN/dtex or greater. The abrasion resistance can be evaluated by JIS L1095 9.10.2, Method B, with an abrasion pass count of preferably 100 or greater, more preferably 1000 or greater, even more preferably 5000 or greater and most preferably 10,000 or greater. The method of increasing the abrasion resistance is not particularly restricted, and any publicly known method may be used, such as increasing the degree of crystallinity, adding fine particles, or surface processing. Abrasion can also be reduced by coating the fibers with a lubricating agent during processing of the braid.

The difference in the shrinkage factor of the piezoelectric fibers is preferably small compared to the shrinkage factor of the conductive fiber mentioned above. If the difference in shrinkage factor is large, then the braid may undergo bending during the post-treatment step after formation of the braid or when it is subjected to heat during use or with time-related changes, thus potentially weakening the piezoelectric signal. If the shrinkage factor is quantified by the boiling water shrinkage ratio as described below, the boiling water shrinkage ratio of the piezoelectric fibers S(p) and the boiling water shrinkage ratio of the conductive fiber S(c) preferably satisfy the following inequality (4).

$$|S(p) - S(c)| \leq 10 \ (4)$$

The left side of inequality (4) is more preferably ≤5 and even more preferably ≤3.

The difference in the shrinkage factor of the piezoelectric fibers is also preferably small compared to the shrinkage factor of the fibers other than the conductive fiber, such as the insulating fibers. If the difference in shrinkage factor is large, then the braid may undergo bending during the post-treatment step after formation of the braid or when it is subjected to heat during use or with time-related changes, thus potentially weakening the piezoelectric signal. If the shrinkage factor is quantified by the boiling water shrinkage ratio, then the boiling water shrinkage ratio of the piezoelectric fibers S(p) and the boiling water shrinkage ratio of the insulating fibers S(i) preferably satisfy the following inequality (5).

$$|S(p) - S(i)| \leq 10 \ (5)$$

The left side of inequality (5) is more preferably ≤5 and even more preferably ≤3.

The shrinkage factor of the piezoelectric fibers is also preferably small. For example, when the shrinkage factor has been quantified by the boiling water shrinkage ratio, the shrinkage factor of the piezoelectric fibers is preferably no greater than 15%, more preferably no greater than 10%, even more preferably no greater than 5% and most preferably no greater than 3%. The means used to lower the shrinkage factor may be any publicly known method, and for example, the shrinkage factor can be lowered by heat treatment to relax the orientation of the amorphous sections or to increase the degree of crystallinity, without any particular restrictions on the timing of heat treatment, which may be after stretching, after twisting or after braiding. The boiling water shrinkage ratio described above was measured by the following method. A reel with 20 coils was prepared using a sizing reel having a frame circumference of 1.125 m, a 0.022 cN/dtex load was applied, it was suspended from a scale board, and the initial reel length L0 was measured. The reel was then treated for 30 minutes in a boiling water bath at 100°C and allowed to cool, a load was again applied, it was suspended from the scale board, and the contracted reel length L was measured. The measured L0 and L values were used to calculate the boiling water shrinkage ratio by the following formula (6).

$$\text{Boiling water shrinkage ratio} = (L0 - L)/L0 \times 100(\%) \quad (6)$$

(Covering)

The conductive fiber B, i.e. the core 3, has its surface covered by the piezoelectric fibers A, i.e. the braided sheath 2. The thickness of the sheath 2 covering the conductive fiber B is preferably 1 μm to 10 mm, more preferably 5 μm to 5 mm, even more preferably 10 μm to 3 mm and most preferably 20 μm to 1 mm. If it is too thin, problems may result in terms of strength, and if it is too thick, the braided piezoelectric element 1 may become hard and more resistant to deformation. The "sheath 2" referred to here is the layer adjacent to the core 3.

In the braided piezoelectric element 1, the total fineness of the piezoelectric fibers A of the sheath 2 is preferably at least 1/2 and no greater than 20 times, more preferably at least 1 and no greater than 15 times, and even more preferably at least 2 and no greater than 10 times, the total fineness of the conductive fiber B of the core 3. If the total fineness of the piezoelectric fibers A is too small with respect to the total fineness of the conductive fiber B, there will be too few piezoelectric fibers A surrounding the conductive fiber B and the conductive fiber B will not be able to sufficiently output an electrical signal, while the conductive fiber B may potentially contact with other adjacent conductive fibers. If the total fineness of the piezoelectric fibers A is too large with respect to the total fineness of the conductive fiber B, there will be too many piezoelectric fibers A surrounding the conductive fiber B, and the braided piezoelectric element 1 will become too hard and resistant to deformation. In other words, the braided piezoelectric element 1 will fail to adequately function as a sensor in both cases.

The total fineness referred to here is the sum of all of the finenesses of the piezoelectric fibers A composing the sheath 2, and in the case of a common 8-strand braid, for example, it is the sum of the finenesses of the 8 strands.

Also, in the braided piezoelectric element 1, the fineness per piezoelectric fiber A of the sheath 2 is preferably at least 1/20 times and no greater than 2 times, more preferably at least 1/15 and no greater than 1.5 times, and even more preferably at least 1/10 and no greater than 1 time, the total fineness of the conductive fiber B. If the fineness per piezoelectric fiber A is too small with respect to the total fineness of the conductive fiber B, there will be too few piezoelectric fibers A and the conductive fiber B will not be able to sufficiently output an electrical signal, while the piezoelectric fibers A may potentially undergo breakage. If the fineness per piezoelectric fiber A is too large with respect to the total fineness of the conductive fiber B, the piezoelectric fibers A will be too thick and the braided piezoelectric element 1 will become too hard and resistant to deformation. In other words, the braided piezoelectric element 1 will fail to adequately function as a sensor in both cases.

Incidentally, when metal fiber is used for the conductive fiber B or when metal fiber is combined with the conductive fiber B or piezoelectric fibers A, the fineness proportion is not limited to that mentioned above. This is because according to the invention, the proportion is important from the standpoint of the contact area and coverage factor, i.e. the area and volume. For example, if the specific gravity of each of the fibers exceeds 2, the proportion of the mean cross-sectional area of the fibers is preferably the same as the fineness proportion.

It is preferred for the piezoelectric fibers A and the conductive fiber B to be as closely bonded as possible, and for improved adhesiveness, an anchor layer or adhesive layer may be provided between the conductive fiber B and the piezoelectric fibers A.

The covering method employed is a method of using the conductive fiber B as the core thread and coiling the piezoelectric fibers A in a braided fashion around it. The form of the braid of the piezoelectric fibers A is not particularly restricted so long as an electrical signal can be outputted in response to stress produced by an applied load, but it is preferably an 8-strand braid or a 16-strand braid with the core 3.

The form of the conductive fiber B and the piezoelectric fibers A is not particularly restricted, but they are preferably as nearly concentric as possible. When a multifilament is used as the conductive fiber B, the piezoelectric fibers A need only be covering in a manner so that at least a portion of the surface of the multifilament of the conductive fiber B (the peripheral surface of the fiber) is contacting, and the piezoelectric fibers A may cover all, or not all, of the filament surfaces (peripheral surfaces of the fibers) of the multifilament. The covering state of the piezoelectric fibers A on each filament in the interior forming the multifilament of the conductive fiber B may be set as appropriate, in consideration of performance and handleability of the piezoelectric element.

Since the braided piezoelectric element 1 of the invention has no need for electrodes on its surface, there is no need to further cover the braided piezoelectric element 1 itself, while it also has the advantage of being less likely to malfunction.

(Insulating fibers)

In the braided piezoelectric element 1, the sheath 2 may be formed of the piezoelectric fibers A alone, or it may be formed of a combination of the piezoelectric fibers A and insulating fibers.

Examples of insulating fibers to be used include synthetic fibers such as polyester fiber, nylon fiber, acrylic fiber, polyethylene fiber, polypropylene fiber, vinyl chloride fiber, aramid fiber, polysulfone fiber, polyether fiber and polyurethane fiber, as well as natural fibers such as cotton, hemp and silk, semisynthetic fibers such as acetate, and regenerated fibers such as rayon and cupra. There is no restriction to these, however, and any publicly known insulating fibers may be used as desired. These insulating fibers may also be used in combination, or combined with fibers having no insulating property to form fibers with an overall insulating property.

Fibers with various publicly known cross-sectional shapes may also be used.

(Production method)

The braided piezoelectric element 1 of the invention has the surface of at least one conductive fiber B covered by the braided piezoelectric fibers A, and the method for its production may be the following, for example. Specifically, it may be a method of preparing the conductive fiber B and the piezoelectric fibers A in separate steps, and coiling the piezoelectric fibers A in braided form around the conductive fiber B to cover it. In this case, the covering is preferably carried out as nearly concentrically as possible.

The preferred spinning and stretching conditions, when using polylactic acid as the piezoelectric polymer forming the piezoelectric fibers A, is a melt spinning temperature of preferably 150°C to 250°C, a stretching temperature of preferably 40°C to 150°C, a draw ratio of preferably 1.1 to 5.0 and a crystallization temperature of preferably 80°C to 170°C.

The piezoelectric fibers A to be used by coiling around the conductive fiber B may be multifilaments consisting of bundles of multiple filaments, or monofilaments (including spun yarn). The conductive fiber B around which the piezoelectric fibers A are to be coiled may also be a multifilament consisting of bundles of multiple filaments, or a monofilament (including spun yarn).

The preferred manner of covering is to use the conductive fiber B as the core thread and braid the piezoelectric fibers A around its periphery in a braided form to prepare a tubular braid to cover it. More specifically, this may be an 8-strand braid or 16-strand braid with the core 3. However, the piezoelectric fibers A may be in the form of a braided tube, for example, with the conductive fiber B as the core inserted in the braided tube to cover it.

The braided piezoelectric element 1 having the surface of the conductive fiber B covered with the braided piezoelectric fibers A can be obtained by the production method described above.

The braided piezoelectric element 1 of the invention does not require formation of an electrical signal-detecting electrode on the surface, and it can therefore be produced in a relatively simple manner.

(Protective layer)

A protective layer may also be provided on the outer surface of the braided piezoelectric element 1 of the invention. The protective layer preferably has an insulating property, and from the viewpoint of flexibility it is more preferably composed of a polymer. When the protective layer is given an insulating property, the entire protective layer will of course be deformed and rubbed, and there are no particular restrictions in this regard so long as the external force reaches the piezoelectric fibers A and can induce polarization. The protective layer is not limited to being formed by coating of the polymer or the like, and it may instead be a coiled film, fabric, fiber or the like, or a combination of these.

The thickness of the protective layer is as small as possible to facilitate transmission of shearing stress to the piezoelectric fibers A, but if it is too small, problems may be caused such as breakdown of the protective layer itself, and it is therefore preferably 10 nm to 200 μm, more preferably 50 nm to 50 μm, even more preferably 70 nm to 30 μm and most preferably 100 nm to 10 μm. The shape of the piezoelectric element may also be created by the protective layer.

In addition, an electromagnetic shield layer may be incorporated into the braid structure in order to reduce noise. The electromagnetic shield layer is not particularly restricted, but a conductive substance may be coated, or a conductive film, fabric, fiber or the like may be coiled. The volume resistivity of the electromagnetic shield layer is preferably no greater than $10^{-1}$ $\Omega\cdot$cm, more preferably no greater than $10^{-2}$ $\Omega\cdot$cm and even more preferably no greater than $10^{-3}$ $\Omega\cdot$cm. However, the resistivity is not limited to this range so long as the effect of the electromagnetic shield layer can be obtained. The electromagnetic shield layer may be provided on the surface of the piezoelectric fibers A of the sheath, or it may be provided on the outer side of the aforementioned protective layer. Naturally, multiple layers of the electromagnetic shield layer and protective layer may be overlaid, their order being suitably determined according to the purpose.

In addition, a plurality of layers made of piezoelectric fibers may be provided, or a plurality of layers made of conductive fibers for signal extraction may be provided. Naturally, the number and order of the protective layer, the electromagnetic shield layer, the layer made of piezoelectric fibers and the layer made of conductive fibers, may be determined as appropriate according to the purpose. The coiling method may be a method of additionally forming a braid structure over the outer layer of the sheath 2, or a method of forming a cover ring.

When deformation is produced in the central axis direction of the braided piezoelectric element 1, the piezoelectric fibers A deform, generating polarization. As the positive and negative electrical charges generated by polarization of the piezoelectric fibers A become aligned, electrical charge migration takes place on the lead wire from the output terminal of the conductive fiber B that forms the core 3 of the braided piezoelectric element 1. The electrical charge migration on the lead wire from the conductive fiber B appears as a minute electrical signal (current or difference in potential). That is, an electrical signal is output from the output terminal, corresponding to the electrical charge generated when deformation is applied to the braided piezoelectric element 1. Therefore, the braided piezoelectric element 1 can effectively function in the piezoelectric sensor and for the impact detection method of the invention.

In the experiments illustrated in Figs. 11 to 18 described above, the linear piezoelectric elements in the piezoelectric sensors of the invention were of the type of the braided piezoelectric element 1-2 described below, which was produced by the following method.

The properties of the piezoelectric fibers used in the braided piezoelectric element were determined by the following method.

(1) Poly-L-lactic acid crystallinity $X_{homo}$:

The poly-L-lactic acid crystallinity $X_{homo}$ was determined from crystal structure analysis by wide-angle X-ray diffraction (WAXD). In the wide-angle X-ray diffraction (WAXD), an Ultrax18 X-ray diffraction apparatus by Rigaku Corp. was used in a transmission method, and the X-ray diffraction pattern of a sample was recorded on an imaging plate under the following conditions.

X-ray source: Cu-K$\alpha$ rays (confocal mirror)
Output: 45 kV $\times$ 60 mA
Slits: 1st: 1 mm$\Phi$, 2nd: 0.8 mm$\Phi$
Camera length: 120 mm
Elapsed time: 10 minutes
Sample: 35 mg of polylactic acid fibers aligned to form a 3 cm fiber bundle.

The total scattering intensity $I_{total}$ over the declination in the obtained X-ray diffraction pattern was determined, and the sum $\Sigma I_{HMi}$ of the integrated intensity for each diffraction peak attributed to poly-L-lactic acid crystals, appearing near $2\theta$ = 16.5°, 18.5° and 24.3°, was calculated. Based on these values, the poly-L-lactic acid crystallinity $X_{homo}$ was calculated by the following formula (3).
[Mathematical Formula 3]

$$\text{Poly-L-lactic acid crystallinity } X_{homo}\ (\%) = \Sigma I_{HMi}/I_{total} \times 100 \quad (3)$$

The value of $\Sigma I_{HMi}$ was calculated by subtracting the background and amorphous diffuse scattering from the total scattering intensity.

(2) Poly-L-lactic acid crystal orientation A:

In the X-ray diffraction pattern obtained by the aforementioned wide-angle X-ray diffraction (WAXD), the poly-L-lactic acid crystal orientation A had an intensity distribution with respect to the declination (°) for the diffraction peaks attributable to poly-L-lactic acid crystals, appearing near $2\theta$ = 16.5° in the radius vector direction, and it was calculated from the sum $\Sigma_{Wi}$ (°) of the half-widths in the obtained distribution profile, using the following formula (4).

[Mathematical Formula 4]

$$\text{Poly-L-lactic acid crystal orientation A (\%)} = (360 - \sum W_i) \div 360 \times 100 \quad (4)$$

(3) Optical purity of polylactic acid:

After sampling 0.1 g of a single polylactic acid fiber composing the braided piezoelectric element (one bundle in the case of a multifilament), 1.0 mL aqueous sodium hydroxide at 5 mol/liter concentration and 1.0 mL methanol were added, the mixture was set in a water bath shaker adjusted to 65°C, hydrolysis was performed for about 30 minutes until the polylactic acid became a homogeneous solution, the completely hydrolyzed solution was neutralized to pH 7 by addition of 0.25 mol/liter sulfuric acid, and 0.1 mL of the hydrolyzed solution was sampled and diluted with 3 mL of a high-performance liquid chromatography (HPLC) mobile phase solution, and filtered with a membrane filter (0.45 μm). The modified solution was measured by HPLC to quantify the proportion of L-lactic acid monomer and D-lactic acid monomer. When one polylactic acid fiber did not fully supply 0.1 g, the amount of the other solution was adjusted to match the sampleable amount, and the polylactic acid concentration of the sample solution provided for HPLC measurement was adjusted in a range from an amount equal to the above, to 1/100.

<HPLC measuring conditions>

Column: "SUMICHIRAL$^R$" OA-5000 (4.6 mmφ × 150 mm) by Sumika Chemical
Analysis Service, Ltd.

Mobile phase: 1.0 millimole/liter aqueous copper sulfate solution
Mobile phase flow rate: 1.0 milliliter/min
Detector: UV detector (wavelength of 254 nm)
Injection rate: 100 microliters

With the peak area attributed to L-lactic acid monomer as $S_{LLA}$ and the peak area attributed to D-lactic acid monomer as $S_{DLA}$, since $S_{LLA}$ and $S_{DLA}$ are proportional to the molar concentration of L-lactic acid monomer $M_{LLA}$ and the molar concentration $M_{DLA}$ of D-lactic acid monomer, respectively, the larger value of $S_{LLA}$ and $S_{DLA}$ was used as $S_{MLA}$ to calculate the optical purity by the following formula (5).
[Mathematical Formula 5]

$$\text{Optical purity (\%)} = S_{MLA} \div (S_{LLA} + S_{DLA}) \times 100 \quad (5)$$

(Production of polylactic acid)

The polylactic acid was produced by the following method.
After adding 0.005 part by mass of tin octylate to 100 parts by mass of L-lactide (product of Musashino Chemical Laboratory, Co. Ltd., 100% optical purity), the mixture was reacted at 180°C for 2 hours in a stirring blade-equipped reactor under a nitrogen atmosphere, and phosphoric acid was added at 1.2 equivalents with respect to the tin octylate, after which the remaining lactide was removed under reduced pressure at 13.3 Pa, and chips were formed to obtain poly-L-lactic acid (PLLA1). The weight-average molecular weight of the obtained PLLA1 was 152,000, the glass transition point (Tg) was 55°C and the melting point was 175°C.

(Piezoelectric fibers)

PLLA1 melted at 240°C was discharged from a 24-hole cap at 20 g/min, and drawn out at 887 m/min. The unstretched multifilament thread was stretched to a factor of 2.3 at 80°C and heat set at 100°C, to obtain an 84 dTex/24 filament multifilament uniaxial stretched thread PF1. PLLA1 melted at 240°C was discharged from a 12-hole cap at 8 g/min, and drawn out at 1050 m/min. The unstretched multifilament thread was stretched to a factor of 2.3 at 80°C and heat set at 150°C, to obtain an 33 dtex/12 filament multifilament uniaxial stretched thread PF2. The piezoelectric fibers PF1 and PF2 were used as piezoelectric polymers. The poly-L-lactic acid crystallinity, poly-L-lactic acid crystal orientation and optical purity of PF1 and PF2 were measured by the methods described above, giving the results listed in Table 1.

[Table 1]

Table 1

| Piezoelectric fibers | Poly-L-lactic acid crystallinity $X_{homo}$ [%] | Poly-L-lactic acid crystal orientation A [%] | Poly-L-lactic acid optical purity [%] |
|---|---|---|---|
| PF1 | 35.9 | 95.6 | 99.7 |
| PF2 | 36.8 | 94.8 | 99.9 |

(Conductive fiber)

Silver plated nylon "AGposs" 100d34f (CF1) by Mitsufuji Corp. was used as the conductive fiber B. The resistivity of the CF1 was 250 Ω/m.
Silver plated nylon "AGposs" 30d10f (CF2) by Mitsufuji Corp. was used as the conductive fiber B. The conductivity of the CF2 was 950 Ω/m.

(Insulating fibers)

Stretched yarn IF1 (84 dTex/24 filament) produced by melt spinning and then stretching of polyethylene terephthalate, and stretched yarn IF2 (33 dTex/12 filament), were used as insulating fibers.

(Braided piezoelectric element)

A braided piezoelectric element 1-1 was fabricated having conductive fiber CF1 as the core thread and with piezoelectric fibers PF1 wound in a helical manner in the Z-twisting direction around the core thread, as shown in Fig. 22, by setting the piezoelectric fibers PF1 on 4 carriers in the Z-twisting direction and setting insulating fibers IF1 on 4 carriers in the S-twisting direction, of the 8 carriers of an 8-strand round braid braiding machine. The coiling angle (orientation angle θ) of the piezoelectric fibers was 45° with respect to the fiber axis CL of the conductive fiber. Using the braided piezoelectric element 1-1 as core thread, braided piezoelectric element 1-2, having the periphery of the braided piezoelectric element 1-1 covered by conductive fibers, was fabricated by setting the conductive fibers CF2 on all of the 4 carriers in the Z-twisting direction and 4 carriers in the S-twisting direction, of the 8 carriers of the braider. The braided piezoelectric element 1-2 was used in the experiment for Figs. 11 to 18, as described above.
Next, the effect of the orientation angle θ and T1/T2 value of piezoelectric polymers on electrical signals in response to elongation deformation was examined, for piezoelectric elements to be used for piezoelectric sensors of the invention.
The properties of each piezoelectric element were determined by the following method. (1) Orientation angle θ of piezoelectric polymer with respect to direction of central axis
The orientation angle θ of the piezoelectric polymer with respect to the direction of the central axis was calculated by the following formula.

$$\theta = \arctan(2\pi Rm/HP)\ (0° \leq \theta \leq 90°)$$

Here, $Rm = 2(Ro^3 - Ri^3)/3(Ro^2 - Ri^2)$, i.e. the radius of the braided piezoelectric element (or other structure) as the weighted average based on the cross-sectional area. The helical pitch HP and the outer radius Ro and inner radius Ri of the portions constituted by the braided piezoelectric element (or other structure) were measured in the following manner.
(1-1) For a braided piezoelectric element, the side was photographed (or in the case of covering other than by the piezoelectric polymer of the braided piezoelectric element, the covering was first removed as necessary to form a condition allowing the piezoelectric polymer to be observed from the side), and the helical pitch HP (μm) of the piezoelectric polymer was measured at 5 arbitrary locations as shown in Fig. 23, recording the average value. The braided piezoelectric element was impregnated with the low-viscosity rapid bonding adhesive "AronAlpha EXTRA2000" (ToaGosei Co., Ltd.) which was allowed to solidify, after which a cross-section was cut out perpendicular to the long axis of the braid, a cross-sectional photograph was taken, and for each cross-sectional photograph, the outer radius Ro (μm) and inner radius Ri (μm) were measured at sections occupied by the braided piezoelectric element, with the same measurement being conducted at 5 other arbitrary cross-section locations and the average value being recorded. When a piezoelectric polymer and insulating polymer were both incorporated, such as when using doubled piezoelectric fibers and insulating fibers, or when 4 fibers of an 8-strand braid were of the piezoelectric polymer and the remaining 4 fibers were of the insulating polymer, since the regions where the piezoelectric polymer was present and the regions where the insulating polymer was present were interchanging when taking cross-sections at different locations, the regions where the piezoelectric polymer was present and the regions where the insulating polymer was present were collectively considered to be the portion occupied by the braided piezoelectric element. However, sections where the insulating polymer and piezoelectric polymer were not both incorporated were not considered to be part of the braided piezoelectric element.

The outer radius Ro and inner radius Ri were measured in the following manner. As shown in the cross-sectional photograph of Fig. 24(a), two regions were defined: the region occupied by the piezoelectric structure (the sheath 2 formed by piezoelectric fibers A) (this region will hereunder be referred to as "PSA"), and the region at the center portion of PSA that was not PSA (this region will hereunder be referred to as "CA"). The average value between the diameter of the minimum circle not overlapping with PSA, on the outside of PSA, and the diameter of the maximum circle not falling outside of PSA (but possibly falling within CA) was recorded as Ro (Fig. 24(b)). Also, the average value between the diameter of the minimum circle not overlapping with CA, on the outside of CA, and the diameter of the maximum circle not falling outside of CA was recorded as Ri (Fig. 24(c)).

(1-2) For a covering thread-like piezoelectric element, the helical pitch HP ($\mu$m) was 1,000,000/T, for a winding speed of T times/m during covering of the piezoelectric polymer (the rotational speed of the piezoelectric polymer per length of the covering thread). The covering thread-like piezoelectric element was impregnated with the low-viscosity rapid bonding adhesive "AronAlpha EXTRA2000" (ToaGosei Co., Ltd.) which was allowed to solidify, after which a cross-section was cut out perpendicular to the long axis of the braid, a cross-sectional photograph was taken, and for each cross-sectional photograph, the outer radius Ro ($\mu$m) and inner radius Ri ($\mu$m) were measured at sections occupied by the covering thread-like piezoelectric element, similar to the braided piezoelectric element, with the same measurement being conducted at 5 other arbitrary locations of the cross-section and the average value being recorded. When a piezoelectric polymer and insulating polymer were both covered, such as when doubled piezoelectric fibers and insulating fibers were covered, or when piezoelectric fibers and insulating fibers were simultaneously covered in a non-overlapping manner, since the regions where the piezoelectric polymer was present and the regions where the insulating polymer was present were interchanging when taking cross-sections at different locations, the regions where the piezoelectric polymer was present and the regions where the insulating polymer was present were collectively considered to be the portion occupied by the covering thread-like piezoelectric element. However, sections where the insulating polymer and piezoelectric polymer were not simultaneously covered, i.e. sections in which the insulating polymer was always on the inside or outside of the piezoelectric polymer in any cross-section, were not considered to be part of the covering thread-like piezoelectric element.

(2) Electrical signal measurement

With an Electrometer (B2987A by Keysight Technologies Inc.) connected to the conductor of the piezoelectric element via a coaxial cable (core: Hi electrode, shield: Lo electrode), the piezoelectric element was subjected to one of the motion tests of 2-1 to 2-5 below, while measuring the current value at 50 msec intervals.

(2-1) Tensile test

Using a "TENSILON RTC-1225A" universal testing machine by Orientech Co., Ltd., the piezoelectric element was gripped by a chuck across a spacing of 12 cm in the longitudinal direction of the piezoelectric element, and with 0.0 N as the force on the element in the relaxed state and 0 mm as the displacement when stretching to a tensile force of 0.5 N, an operation of pulling to 1.2 mm at an operating speed of 100 mm/min followed by restoration to 0 mm at an operating speed of -100 mm/min, was repeated 10 times.

(2-2) Torsional test

Using a torsional test device designed having one of two chucks gripping the piezoelectric element set on a rail able to move freely in the long axis direction of the piezoelectric element without twisting movement, with constant application of 0.5 N tensile force on the piezoelectric element, and the other chuck able to perform twisting movement without movement in the long axis direction of the piezoelectric element, the piezoelectric element was gripped with the chucks across a spacing of 72 mm in the longitudinal direction of the piezoelectric element, and a reciprocal twisting operation of rotating from 0° to 45° at a speed of 100°/s followed by rotating from 45° to 0° at a speed of -100/s was repeated 10 times, the twisting being in the clockwise direction when viewing the chucks from the center of the element.

(2-3) Bending test

Using a test apparatus comprising two chucks, an upper and a lower chuck, with the lower chuck fixed and the upper chuck positioned 72 mm above the lower chuck, the upper chuck being movable over an imaginary circumference having a line segment connecting the two chucks as the diameter, the piezoelectric element was anchored by being gripped by the chucks, and after slightly warping the piezoelectric element in a convex manner in the 9-o'clock direction with the upper chuck at the 12-o'clock position and the lower chuck at the 6-o'clock position on the circumference, reciprocal bending motion in which the upper chuck was moved from the 12-o'clock position through the 1-o'clock and 2-o'clock positions on the circumference to the 3-o'clock position over a period of 0.9 second at a constant speed, and then moved to the 12-o'clock position over a period of 0.9 second, was repeated 10 times.

(2-4) Shearing test

A section of the piezoelectric element with a length of 64 mm at the center portion was horizontally sandwiched from above and below by two rigid metal sheets having a plain woven fabric that was woven with cotton yarn at a yarn count of 50 attached to their surfaces (the lower metal sheet being fixed to a base), and a perpendicular load of 3.2 N was applied from above with the cotton cloth and piezoelectric element unable to slide between the metal sheet surfaces, after which shearing motion, in which the upper metal sheet was pulled in the longitudinal direction of the piezoelectric element over a period of 1 second from a load of 0 N to I N and then the tensile load was restored to 0 N over a period of 1 second, was repeated 10 times.

(2-5) Compression test

Using a "TENSILON RTC-1225A" universal testing machine by Orientech Co., Ltd., a section of the piezoelectric element with a length of 64 mm at the center portion, set still on a horizontal rigid metal base, was gripped horizontally by the rigid metal sheet set on the upper cross head, and motion in which the upper cross head was lowered and pressed on the metal sheet from above the piezoelectric element from a reaction force of 0.01 N to 20 N over a period of 0.6 second and then the pressure was released to 0.01 N over a period of 0.6 second, was repeated 10 times.

(Example A)

As the sample for Example A, a braided piezoelectric element 1-A was fabricated having conductive fiber CF1 as the core thread and with piezoelectric fibers PF1 wound in a helical manner in the Z-twisting direction around the core thread, as shown in Fig. 22, by setting the piezoelectric fibers PF1 on 4 carriers in the Z-twisting direction and setting insulating fibers IF1 on 4 carriers in the S-twisting direction, of the 8 carriers of an 8-strand round braid braiding machine.

(Example B)

Using the braided piezoelectric element 1-A as core thread, braided piezoelectric element 1-B, having the braided piezoelectric element 1-A covered by conductive fibers, was fabricated by setting the conductive fibers CF2 on all of the 4 carriers in the Z-twisting direction and 4 carriers in the S-twisting direction, of the 8 carriers of the braider.

(Examples C and D)

In the same manner as braided piezoelectric element 1-A, except for changing the coiling speed for PF1, two braided piezoelectric elements were formed and the braided piezoelectric elements were used as core threads and covered with conductive fibers in the same manner as braided piezoelectric element 1-B, to fabricate braided piezoelectric elements 1-C and 1-D.

(Examples E to H)

Braided piezoelectric elements were fabricated having piezoelectric fibers PF1 wound in a helical fashion at predetermined proportions in the Z-twisting direction and the S-twisting direction around the core thread, by setting PF1 or IF1 on carriers in the Z-twisting direction and S-twisting direction of the 8 carriers of the braider as shown in Table 2, and braided piezoelectric elements 1-E to 1-H were fabricated having the braided piezoelectric elements as core threads and covered with conductive fibers in the same manner as braided piezoelectric element 1-B.

(Example I)

A braided piezoelectric element was fabricated in the same manner as braided piezoelectric element 1-A, except for using PF2 instead of PF1 and IF2 instead of IF1, and adjusting the coiling speed, and the braided piezoelectric element was used as core thread and covered with conductive fibers in the same manner as braided piezoelectric element 1-B, to fabricate braided piezoelectric element 1-1.

(Example J)

A braided piezoelectric element was fabricated in the same manner as braided piezoelectric element 1-A, except for using IF2 instead of PF2 and PF2 instead of IF2, and the braided piezoelectric element was used as core thread and covered with conductive fibers in the same manner as braided piezoelectric element 1-B, to fabricate braided piezoelectric element 1-J.

(Example K)

Covering thread-like piezoelectric element 1-K was fabricated having piezoelectric fibers PF1 wrapped in a helical manner around a core thread in the S-twisting direction and having the outside covered by conductive fibers, by using CF1 as the core thread and PF1 wrapped around to cover the core thread 3000 times/m in the S-twisting direction, further wrapping the outside with IF1 to cover it 3000 times/m in the Z-twisting direction, in turn wrapping that outside with CF2 to cover it 3000 times/m in the S-twisting direction, and still further wrapping that outside with CF2 to cover it 3000 times/m in the Z-twisting direction.

(Example L)

A braided piezoelectric element was fabricated in the same manner as braided piezoelectric element 1-A, except for using IF1 instead of PF1, and the braided element was used as core thread to fabricate a braided element 1-L covered with conductive fibers in the same manner as braided piezoelectric element 1-B.

(Example M)

A covering thread-like element was fabricated in the same manner as covering thread-like piezoelectric element 1-K, except for using IF1 instead of PF1, to obtain covering thread-like element 1-M.

(Example N)

Braided piezoelectric element 1-N was fabricated in the same manner as braided piezoelectric element 1-B, except for using PF1 instead of IF1.

(Example O)

Braided piezoelectric element 1-O was fabricated in the same manner as braided piezoelectric element 1-I, except for using PF2 instead of IF2.

(Example P)

A braided piezoelectric element was fabricated having conductive fiber CF1 as the core thread and piezoelectric fibers PF1 wrapped in a helical fashion around a core thread in the Z-twisting direction, by setting the piezoelectric fibers PF1 on 8 carriers in the Z-twisting direction and setting insulating fibers IF1 on 8 carriers in the S-twisting direction, of the 16 carriers of a 16-strand round braid braiding machine, and a braided piezoelectric element 1-P was fabricated having this braided piezoelectric element as the core thread and covered with conductive fiber in the same manner as braided piezoelectric element 1-B.

(Example Q)

Covering thread-like piezoelectric element 1-Q was fabricated having piezoelectric fibers PF1 wrapped in a helical manner around a core thread in the S-twisting direction and having the outside further covered by conductive fibers, by using CF1 as the core thread and PF1 wrapped around to cover the core thread 6000 times/m in the S-twisting direction, further wrapping the outside with IF1 to cover it 6000 times/m in the Z-twisting direction, in turn wrapping that outside with CF2 to cover it 3000 times/m in the S-twisting direction, and still further wrapping that outside with CF2 to cover it 3000 times/m in the Z-twisting direction.

The Ri, Ro and HP values of each piezoelectric element were measured, and the calculated values of the orientation angle θ of the piezoelectric polymer with respect to the direction of the central axis and the T1/T2 are shown in Table 2. Ri and Ro for each braided piezoelectric element were measured in a region occupied by the piezoelectric element which was a combination of cross-sectional regions containing piezoelectric fibers and insulating fibers. Ri and Ro for each covering thread-like piezoelectric element were also measured in a region occupied by the piezoelectric element, which was a cross-sectional region containing piezoelectric fibers. Each piezoelectric element was also cut to a 15 cm length and connected to an Electrometer (B2987A by Keysight Technologies Inc.) with conductive fiber of the core as the Hi electrode and conductive fibers of the wire mesh or sheath shielding the periphery as the Lo electrode, to monitor the current value. Table 2 shows the current values during the tensile test, torsional test, bending test, shearing test and compression test. Examples L and M did not include a piezoelectric polymer, and therefore the θ and T1/T2 values could not be measured.

[Table 2]

Table 2

| Ex. | Element | Conductive fiber of core | Piezoelectric fibers | | | | Conductive fiber of sheath | | Current signal [pA] | | | | |
|---|---|---|---|---|---|---|---|---|---|---|---|---|---|
| | | | Z-twisting direction | S-twisting direction | Θ [°] | T1/T2 | Z-twisting direction | S-twisting direction | Tensile test | Twisting test | Bending test | Shear test | Compression test |
| A | Braided piezoelectric element 1-A | CF1 | PF1 4 strands | IF1 4 strands | 38 | 0 | None | None | -992 | 49 | 3 | -11 | 9 |
| B | Braided piezoelectric element 1-B | CF1 | PF1 4 strands | IF1 4 strands | 38 | 0 | CF2 4 strands | CF2 4 strands | -1262 | 58 | -1 | 13 | -18 |
| C | Braided piezoelectric element 1-C | CF1 | PF1 4 strands | IF1 4 strands | 44 | 0 | CF2 4 strands | CF2 4 strands | -1718 | -15 | -1 | 0 | 9 |
| D | Braided piezoelectric element 1-D | CF1 | PF1 4 strands | IF1 4 strands | 29 | 0 | CF2 4 strands | CF2 4 strands | -1060 | 45 | -8 | -1 | -2 |
| E | Braided piezoelectric element 1 -E | CF1 | PF1 4 strands | PF1 1 strand IF1 3 strands | 44 | 0.25 | CF2 4 strands | CF2 4 strands | -1443 | -19 | -7 | 8 | 4 |
| F | Braided piezoelectric element 1-F | CF1 | PF1 4 strands | PF1 2 strands IF1 2 strands | 43 | 0.5 | CF2 4 strands | CF2 4 strands | -1115 | -16 | 8 | 3 | -3 |
| G | Braided piezoelectric element 1-G | CF1 | PF1 4 strands | PF1 3 strands IF1 1 strand | 45 | 0.75 | CF2 4 strands | CF2 4 strands | -872 | -10 | -3 | 2 | 0 |

(continued)

| Ex. | Element | Conductive fiber of core | Piezoelectric fibers | | | | Conductive fiber of sheath | | Current signal [pA] | | | | |
|---|---|---|---|---|---|---|---|---|---|---|---|---|---|
| | | | Z-twisting direction | S-twisting direction | Θ [°] | T1/T2 | Z-twisting direction | S-twisting direction | Tensile test | Twisting test | Bending test | Shear test | Compression test |
| H | Braided piezoelectric element 1-H | CF1 | PF1 1 strand IF1 3 strands | IF1 4 strands | 43 | 0 | CF2 4 strands | CF2 4 strands | -355 | -4 | -11 | 0 | 13 |
| I | Braided piezoelectric element 1-I | CF1 | PF2 4 strands | IF2 4 strands | 44 | 0 | CF2 4 strands | CF2 4 strands | -3165 | -13 | -5 | -7 | 42 |
| J | Braided piezoelectric element 1-J | CF1 | IF2 4 strands | PF2 4 strands | 42 | 0 | CF2 4 strands | CF2 4 strands | 3347 | 24 | 10 | 1.2 | 41 |
| K | Covering thread-like piezoelectric element 1-K | CF1 | IF1 1 strand | PF1 1 strand | 60 | 0 | CF2 1 strand | CF2 1 strand | 650 | -41 | 19 | 4 | 21 |
| L | Braided element 1-L | CF1 | IF1 4 strands | IF1 4 strands | - | - | CF2 4 strands | CF2 4 strands | 12 | -9 | 5 | 7 | 45 |
| M | Covering thread-like element 1-M | CF1 | IF1 1 strand | IF1 1 strand | - | - | CF2 1 strand | CF2 1 strand | 11 | 0.9 | 1 | 1 | 5 |
| N | Braided piezoelectric element 1-N | CF1 | PF1 4 strands | PF1 4 strands | 35 | 1 | CF2 4 strands | CF2 4 strands | 85 | 80 | 3 | -5 | 5 |
| O | Braided piezoelectric element 1-O | CF1 | PF2 4 strands | PF2 4 strands | 43 | 1 | CF2 4 strands | CF2 4 strands | -33 | -10.0 | 5 | 10 | 50 |
| P | Braided piezoelectric element 1-P | CF1 | PF1 8 strands | IF1 8 strands | 3.5 | 0 | CF2 4 strands | CF2 4 strands | 29 | 183 | -6 | 1 | 8 |

(continued)

| Ex. | Element | Conductive fiber of core | Piezoelectric fibers | | | | Conductive fiber of sheath | | Current signal [pA] | | | | |
|---|---|---|---|---|---|---|---|---|---|---|---|---|---|
| | | | Z-twisting direction | S-twisting direction | Θ [°] | T1/T2 | Z-twisting direction | S-twisting direction | Tensile test | Twisting test | Bending test | Shear test | Compression test |
| Q | Covering thread-like piezoelectric element 1-Q | CF1 | PF1 1 strand | IF1 1 strand | 80 | 0 | CF2 4 strands | CF2 4 strands | -220 | -257 | 5 | -3 | -12 |

Based on the results in Table 2, when the orientation angle θ of the piezoelectric polymer with respect to the direction of the central axis is between 15° and 75° and the value of T1/T2 is between 0 and 0.8, a large signal is generated in response to tensile motion (elongation deformation) while a large signal is not generated with motion other than tensile motion, indicating that the element selectively responds to tensile motion. When Examples I and J are compared, for comparison between a case where most of the piezoelectric fibers are wrapped in the Z-twisting direction and where most of the piezoelectric fibers are wrapped in the S-twisting direction, the polarities of the signals in the tensile test were opposite, indicating that the direction of coiling corresponds to the polarity of the signal.

Also, while not shown in the table, comparing the signal under a tensile load and the signal without a tensile load with the elements of Examples A to K showed that signals having approximately the same absolute values but with opposite polarities were generated, indicating that the elements are suitable for quantitation of tensile load and displacement. On the other hand, comparing the signal under a tensile load and the signal without a tensile load using the elements of Examples N to O showed that the polarities of the signals were sometimes opposite and sometimes the same, indicating that the elements are not suitable for quantitation of tensile load and displacement. Furthermore, while not shown in the table, the noise level during the tensile test in Example B was lower than the noise level during the tensile test of Example A, indicating that noise can be reduced in an element shielded by situating conductive fibers on the outside of a braided piezoelectric element.

Fig. 25 is a graph showing an example of an electrical signal generated upon vibration on a linear piezoelectric element according to the embodiment of Fig. 20 and Fig. 21. Using the braided piezoelectric element 1-A as core thread, braided piezoelectric element 1-B for Example B described above, having the braided piezoelectric element 1-A covered by conductive fibers, was fabricated by setting the conductive fibers CF2 on all of the 4 carriers in the Z-twisting direction and 4 carriers in the S-twisting direction, of the 8 carriers of the braider. The braided piezoelectric element 1-B having a length of 200 mm was sandwiched by 140 mm × 40 mm × 3 mm aramid fiber nonwoven fabrics and impregnated with a thermosetting resin comprising 0.337 part by weight of "KAYAHARD$^R$" AA by Nippon Kayaku Co., Ltd. mixed with 100 parts by weight of the epoxy resin "jER$^R$" 828 by Mitsubishi Chemical Holdings Corp. The resin-impregnated nonwoven fabrics were heat treated at 130°C for 3 hours to obtain resin sheets integrating the braided piezoelectric element. The conductive fiber of the core and the conductive fibers of the sheath of each braided piezoelectric element were connected via a coaxial cable (core: Hi polarity, shield: Lo polarity) in an ANALOG DISCOVERY kit by Digilent Corp. For this experiment, while a portion 40 mm from the end of the resin sheet was fixed with a vice, 20 mm of the opposite end of the resin sheet was bent by hand and then released, causing vibration of the resin sheet. It was demonstrated that a signal can be detected from the braided piezoelectric element in response to the vibration, as shown in Fig. 25, and the vibrational state of the resin sheet can be determined.

Fig. 26 is a graph showing an example of the polarity of an electrical signal generated upon vibration on a linear piezoelectric element according to the embodiment of Fig. 20 and Fig. 21. Eight prepregs using 3K plain weave carbon cloths were layered, and with the braided piezoelectric element 1-B sandwiched between the second layer and third layer, heat treatment was carried out at 130°C for 3 hours while applying a pressure of 0.1 MPa to obtain a CFRP laminate integrating the braided piezoelectric element. Also, an electrical signal-measuring Electrometer (B2987A by Keysight Technologies Inc.) was connected to the conductive fiber of the core and the conductive fibers of the sheath of the braided piezoelectric element via coaxial cables (core: Hi polarity, shield: Lo polarity). For this experiment, a "TENSILON RTC-1225A" universal testing machine by Orientech Co., Ltd. was used to measure the electrical signal of the CFRP laminate during a three-point bending test with a fulcrum distance of 100 mm, a displacement of 2 mm and a speed of 120 mm/min, and with the braided piezoelectric element oriented upward. As shown in Fig. 26, a square wave of about ±300 pA is produced in response to deformation. Upon doubling the speed, i.e. at 240 mm/min, a current of about 600 pA was generated, and a signal strength corresponding to the deformation speed was produced. Since the amount of deformation can also be determined by time-integration of the signal strength, it is possible to ascertain the state of deformation of the laminate from the electrical signal.

Incidentally, it was confirmed (though the results are not shown here) that even when the CFRP was inverted so that the braided piezoelectric element was oriented downward (elongation and compression were switched from the upward orientation), the polarity (sign) of the electrical signal was merely inverted due to switching of elongation and compression on the front and back, and the speed and direction of deformation could be determined from the electrical signal.

REFERENCE SIGNS LIST

101 Linear piezoelectric element
102 Signal detector
103 Overrun assessing unit

104 Timing recorder
105 Region identifying unit
106 Stress calculating unit
107 Application assessing unit
111 Boundary defining unit
112 Region establishing unit
1000 Piezoelectric sensor

## Claims

1. A piezoelectric sensor (1000) comprising

a linear piezoelectric element that consists of two or more linear piezoelectric elements (101) disposed near a measured object, generating an electrical signal in response to stress applied to the linear piezoelectric element (101),
a signal detector (102) that detects an electrical signal generated by each linear piezoelectric element (101),
an overrun assessing unit (103) that assesses whether or not the size of the electrical signal detected by the signal detector (102) has overrun a predetermined threshold value, for each linear piezoelectric element (101),
a timing recorder (104) that records the timing of overrun of the linear piezoelectric element (101) when the size of the electrical signal has been assessed by the overrun assessing unit (103) to have overrun a predetermined threshold value, and
a region identifying unit (105) that identifies the region on the measured object where stress has been applied, based on the timing of overrun of the linear piezoelectric element (101) recorded at the timing recorder (104), wherein the region identifying unit (105) comprises,
a boundary defining unit (111) which, based on the order of overrun of the linear piezoelectric elements (101) recorded at the timing recorder (104), defines as boundary line the collection of points equidistant from the linear piezoelectric element (101) that has been assessed to have overrun, and the next linear piezoelectric element (101) that has been assessed to have overrun following overrun of that linear piezoelectric element (101), and
a region establishing unit (112) which establishes, as the region of stress application, the region that has the boundary line defined by the boundary defining unit (111) and includes the linear piezoelectric element (101) that was initially assessed to have overrun.

2. The piezoelectric sensor (1000) according to claim 1, further comprising a stress calculating unit (106) that calculates the size of stress applied to the linear piezoelectric element (101) based on the size of the electrical signal detected by the signal detector (102).

3. The piezoelectric sensor (1000) according to claim 1 or 2, wherein

the signal detector (102) detects a current value as the size of the electrical signal generated by each linear piezoelectric element (101),
the overrun assessing unit (103) assesses whether or not the current value of the electrical signal detected by the signal detector (102) has overrun a predetermined threshold value, for each linear piezoelectric element (101), and
the timing recorder (104) records the timing of the linear piezoelectric element (101) when the current value of the electrical signal has been assessed by the overrun assessing unit (103) to have overrun the predetermined threshold value.

4. The piezoelectric sensor (1000) according to any one of claims 1 to 3, wherein the linear piezoelectric element (101) outputs an electrical signal by elongation deformation.

5. The piezoelectric sensor (1000) according to any one of claims 1 to 4, wherein the linear piezoelectric element (101) is a braided piezoelectric element (1) having a core (3) formed of conductive fiber (B), and a sheath (2) formed of braided piezoelectric fibers (A) covering the core (3).

6. The piezoelectric sensor (1000) according to claim 5, wherein the piezoelectric fibers (A) are composed of a piezoelectric polymer including as the main component a crystalline polymer having an absolute value of between 0.1 pC/N and 1000 pC/N for the piezoelectric constant d14, when the orientation axis is the third axis, the orientation angle of the piezoelectric polymer with respect to the direction of the central axis (CL) of the core (3) covered by the piezoelectric polymer being between 15° and 75°, and the piezoelectric polymer includes a P-body containing a crystalline polymer with a positive piezoelectric constant d14 value as a main component and an N-body containing a crystalline polymer with a negative value as a main component, wherein for a portion of the central axis (CL) having a length of 1 cm, the value of T1/T2 is between 0 and 0.8, T1 being the smaller and T2 being the larger of (ZP + SN) and (SP + ZN), where ZP is the mass of the P-body having the orientation axis wrapped in a helical fashion around the Z-twisting direction, SP is the mass of the P-body having the orientation axis wrapped in a helical fashion around the S-twisting direction, ZN is the mass of the N-body having the orientation axis wrapped in a helical fashion around the Z-twisting direction, and SN is the mass of the N-body having the orientation axis wrapped in a helical fashion around the S-twisting direction.

**7.** An impact detection method whereby the region on a measured object where stress has been applied is identified, the method comprising

a signal detecting step (S201) in which the electrical signal generated when stress is applied to two or more linear piezoelectric elements (101) disposed near a measured object is detected for each linear piezoelectric element (101),
an overrun assessing step (S202) in which it is assessed whether or not the size of the electrical signal detected in the signal detecting step has overrun a predetermined threshold value, for each linear piezoelectric element (101),
a timing recording step (S203) in which the timing of overrun of the linear piezoelectric element (101) is recorded when the size of the electrical signal has been assessed in the overrun assessing step to have overrun the predetermined threshold value, and
a region identifying step (S204) in which the region on the measured object where stress has been applied is identified, based on the linear piezoelectric element timing recorded in the timing recording step, wherein the region identifying step comprises,
a boundary defining step (S204-1) which, based on the order of overrun of the linear piezoelectric elements (101) recorded in the timing recording step, defines as boundary line the collection of points equidistant from the linear piezoelectric element (101) that has been assessed to have overrun, and the next linear piezoelectric element (101) that has been assessed to have overrun following overrun of that linear piezoelectric element (101),
a region establishing step (S204-2) which establishes, as the region of stress application, the region that has the boundary line defined in the boundary defining step and includes the linear piezoelectric element (101) that was initially assessed to have overrun.

**8.** The impact detection method according to claim 7, further comprising a stress calculating step in which the size of stress applied to the linear piezoelectric element (101) is calculated based on the size of the electrical signal detected in the signal detecting step (S201).

**9.** The impact detection method according to claim 7 or 8, wherein

in the signal detecting step (S201), a current value is detected as the size of the electrical signal generated by each linear piezoelectric element (101),
in the overrun assessing step (S202), it is assessed whether or not the current value of the electrical signal detected in the signal detecting step (S201) has overrun a predetermined threshold value, for each linear piezoelectric element (101), and
in the timing recording step (S203), the linear piezoelectric element timing is recorded when the current value of the electrical signal has been assessed in the overrun assessing step (S202) to have overrun the predetermined threshold value.

**Patentansprüche**

**1.** Piezoelektrischer Sensor (1000) umfassend
ein lineares piezoelektrisches Element, das aus zwei oder mehr linearen piezoelektrischen Elementen (101) besteht, die in der Nähe eines Messobjekts angeordnet sind und als Reaktion auf eine auf das lineare piezoelektrische Element (101) ausgeübte Belastung, ein elektrisches Signal erzeugen,
eine Signalerfassungseinrichtung (102), die ein elektrisches Signal erfasst, das von jedem linearen piezoelektrischen Element (101) erzeugt wird,
eine Überschreitungsbeurteilungseinheit (103), die für jedes lineare piezoelektrische Element (101) beurteilt, ob die Größe des von der Signalerfassungseinrichtung (102) erfassten elektrischen Signals einen vorbestimmten Schwellenwert überschritten hat oder nicht,
eine Zeitablaufaufzeichnungseinrichtung (104), die den Zeitablauf des Überschreitens des linearen piezoelektrischen Elements (101) aufzeichnet, wenn die Größe des elektrischen Signals von der Überschreitungsbeurteilungseinheit (103) als einen vorbestimmten Schwellenwert überschreitend beurteilt worden ist, und
eine Gebietsidentifizierungseinheit (105), die das Gebiet auf dem Messobjekt identifiziert, auf das eine Belastung ausgeübt wurde, basierend auf dem Zeitablauf des Überschreitens des linearen piezoelektrischen Elements (101), der in der Zeitablaufaufzeichnungseinrichtung (104) aufgezeichnet wurde, wobei die Gebietsidentifizierungseinheit (105) umfasst,
eine Grenzdefinierungseinheit (111), die basierend auf der Reihenfolge des Überschreitens der linearen piezoelektrischen Elemente (101), die in der Zeitablaufaufzeichnungseinrichtung (104) aufgezeichnet ist, als eine Grenzlinie, die Ansammlung von Punkten definiert, die von dem linearen piezoelektrischen Element (101), das als überschreitend beurteilt worden ist und dem nächsten linearen piezoelektrischen Element (101), das nach dem Überschreiten dieses linearen piezoelektrischen Elements (101) als überschreitend beurteilt wurde, gleichweit entfernt sind, und
eine Gebietsermittlungseinheit (112), die das Gebiet als das Gebiet der Belastungsanwendung ermittelt, das die durch die Grenzdefinierungseinheit (111) definierte Grenzlinie aufweist und das lineare piezoelektrische Element (111) beinhaltet, das anfänglich als überschreitend beurteilt wurde.

**2.** Piezoelektrischer Sensor (1000) nach Anspruch 1, umfasst des Weiteren eine Belastungsberechnungseinheit (106), die die Stärke der Belastung, die auf das lineare piezoelektrische Element (111) ausgeübt wird, basierend auf der Größe des von der Signalerfassungseinrichtung (102) erfassten elektrischen Signal berechnet.

**3.** Piezoelektrischer Sensor (1000) nach Anspruch 1 oder 2, wobei
die Signalerfassungseinrichtung (102) einen Stromwert als die Größe des durch jedes lineare piezoelektrische Element (101) erzeugenden elektrischen Signals erfasst,
die Überschreitungsbeurteilungseinheit (103) für jedes lineare piezoelektrische Element (101) beurteilt, ob der Stromwert des durch die Signalerfassungseinrichtung (102) erfassten elektrischen Signals einen vorbestimmten Schwellenwert überschritten hat oder nicht, und
die Zeitablaufaufzeichnungseinrichtung (104) den Zeitablauf des linearen piezoelektrischen Elements (101) aufzeichnet, wenn der Stromwert des elektrischen Signals von der Überschreitungsbeurteilungseinheit (103) als den vorbestimmten Schwellenwert überschreitend beurteilt worden ist.

**4.** Piezoelektrischer Sensor (1000) nach einem der Ansprüche 1 bis 3, wobei das lineare piezoelektrische Element (101), ein elektrisches Signal durch Dehnungsverformung ausgibt.

**5.** Piezoelektrischer Sensor (1000) nach einem der Ansprüche 1 bis 4, wobei das lineare piezoelektrische Element (101) ein geflochtenes piezoelektrisches Element (1) ist, das einen Kern (3) aufweist, der aus leitender Faser (B) gebildet ist, und einen aus geflochtenen piezoelektrischen Fasern (A) gebildeten Mantel (2) aufweist, der den Kern (3) bedeckt.

**6.** Piezoelektrischer Sensor (1000) nach Anspruch 5, wobei
die piezoelektrischen Fasern (A) aus einem piezoelektrischen Polymer zusammengesetzt sind, das als die Hauptkomponente ein kristallines Polymer mit einem Absolutwert zwischen 0,1 pC/N und 1000pC/N für die piezoelektrische Konstante d14 beinhaltet, wenn die Orientierungsachse die dritte Achse ist, wobei der Orientierungswinkel des piezoelektrischen Polymers in Bezug auf die Richtung der zentralen Achse (CL) des von dem piezoelektrischen Polymer bedeckten Kerns (3) zwischen 15° und 75° liegt, und das piezoelektrische Polymer einen P-Körper, der ein kristallines Polymer mit einem positiven Wert der piezoelektrischen Konstante d14 als eine Hauptkomponente enthält, und einen N-Körper, der ein kristallines Polymer mit einem negativen Wert als eine Hauptkomponente enthält, beinhaltet, wobei für einen Abschnitt der zentralen Achse (CL) mit einer Länge von 1 cm der Wert von T1/T2 zwischen 0 und 0,8 liegt, wobei T1 der kleinere und T2 der größere Wert von (ZP + SN) und (SP + ZN) ist, wobei ZP die Masse des P-Körpers ist, bei dem die Orientierungsachse helixförmig um die Z-Verdrehungsrichtung gewickelt ist, SP die Masse des P-Körpers ist, bei dem die Orientierungsachse helixförmig um die S-Verdrehungsrichtung gewickelt ist, ZN die Masse des N-Körpers ist, bei dem die Orientierungsachse helixförmig um die Z-Verdrehungsrichtung gewickelt ist, und SN die Masse des N-Körpers ist, bei dem die Orientierungsachse helixförmig um die S-Verdrehungsrichtung gewickelt bist.

**7.** Einwirkungserfassungsverfahren, bei dem der Bereich auf einem Messobjekt identifiziert wird, auf den eine Belastung ausgeübt wurde, wobei das Verfahren umfasst

einen Signalerfassungsschritt (S201), in dem das elektrische Signal für jedes lineare piezoelektrische Element (101) erfasst wird, das erzeugt wird, wenn eine Belastung auf zwei oder mehr lineare piezoelektrische Elemente (101) ausgeübt wird, die in der Nähe eines Messobjekts angeordnet sind,
einen Überschreitungsbeurteilungsschritt (S202), in dem für jedes lineare piezoelektrische Element (101) beurteilt wird, ob die Größe des in dem Signalerfassungsschritt erfassten elektrischen Signals einen vorbestimmten Schwellenwert überschritten hat oder nicht,
einen Zeitablaufaufzeichnungsschritt (S203), in dem der Zeitablauf des Überschreitens des linearen piezoelektrischen Elements (101) aufgezeichnet wird, wenn die Größe des elektrischen Signals in dem Überschreitungsbeurteilungsschritt als den vorbestimmten Schwellenwert überschreitend beurteilt worden ist, und
einen Gebietsidentifizierungsschritt (S204), in dem das Gebiet auf dem Messobjekt identifiziert wird, auf das eine Belastung ausgeübt wurde, basierend auf dem Zeitablauf des linearen piezoelektrischen Elements, der in dem Zeitablaufaufzeichnungsschritt aufgezeichnet wurde, wobei der Gebietsidentifizierungsschritt umfasst,
einen Grenzdefinierungsschritt (S204-1), der basierend auf der Reihenfolge des Überschreitens der linearen piezoelektrischen Elemente (101), die in dem Zeitablaufaufzeichnungsschritt aufgezeichnet wurde, als eine Grenzlinie, die Ansammlung von Punkten definiert, die von dem linearen piezoelektrischen Element (101), das als überschreitend beurteilt worden ist und dem nächsten linearen piezoelektrischen Element (101), das nach dem Überschreiten dieses linearen piezoelektrischen Elements (101) als überschreitend beurteilt wurde, gleichweit entfernt sind,
einen Gebietsermittlungsschritt (S204-2), der das Gebiet als das Gebiet der Belastungsanwendung ermittelt, das die in dem Grenzdefinierungsschritt definierte Grenzlinie aufweist und das lineare piezoelektrische Element (111) beinhaltet, das anfänglich als überschreitend beurteilt wurde.

**8.** Einwirkungserfassungsverfahren nach Anspruch 7, umfasst des Weiteren einen Belastungsberechnungsschritt, in dem die Stärke der Belastung, die auf das lineare piezoelektrische Element (111) ausgeübt wird, basierend auf der Größe des in dem Signalerfassungsschritt (S201) erfassten elektrischen Signal berechnet wird.

**9.** Einwirkungserfassungsverfahren nach Anspruch 7 oder 8, wobei

in dem Signalerfassungsschritt (S201) ein Stromwert als die Größe des durch jedes lineare piezoelektrische Element (101) erzeugenden elektrischen Signals erfasst wird,
in dem Überschreitungsbeurteilungsschritt (S202) für jedes lineare piezoelektrische Element (101) beurteilt wird, ob der Stromwert des in dem Signalerfassungsschritt (S201) erfassten elektrischen Signals einen vorbestimmten Schwellenwert überschritten hat oder nicht, und
in dem Zeitablaufaufzeichnungsschritt (S203) der Zeitablauf des linearen piezoelektrischen Elements (101) aufgezeichnet wird, wenn der Stromwert des elektrischen Signals in dem Überschreitungsbeurteilungsschritt (S202) als den vorbestimmten Schwellenwert überschreitend beurteilt worden ist.

**Revendications**

**1.** Capteur piézoélectrique (1000) comprenant
un élément piézoélectrique linéaire qui consiste en deux ou plusieurs éléments piézoélectriques linéaires (101) disposés près d'un objet mesuré, générant un signal électrique en réponse à une contrainte appliquée à l'élément piézoélectrique linéaire (101),
un détecteur de signal (102) qui détecte un signal électrique généré par chaque élément piézoélectrique linéaire (101),
une unité d'évaluation de dépassement (103) qui évalue si oui ou non la taille du signal électrique détecté par le détecteur de signal (102) a dépassé une valeur de seuil prédéterminée, pour chaque élément piézoélectrique linéaire (101),
un enregistreur de temps (104) qui enregistre le temps de dépassement de l'élément piézoélectrique linéaire (101) lorsque la taille du signal électrique a été évaluée par l'unité d'évaluation de dépassement (103) comme ayant dépassé une valeur de seuil prédéterminée, et
une unité d'identification de région (105) qui identifie la région sur l'objet mesuré où une contrainte a été appliquée, sur la base de la synchronisation du dépassement de l'élément piézoélectrique linéaire (101) enregistrée au niveau de l'enregistreur de synchronisation (104), dans laquelle l'unité d'identification de région (105) comprend,

une unité de définition de frontière (111) qui, sur la base de l'ordre de dépassement des éléments piézoélectriques linéaires (101) enregistrés au niveau de l'enregistreur de temps (104), définit comme ligne de frontière la collection de points équidistants de l'élément piézoélectrique linéaire (101) qui a été évalué comme ayant dépassé, et l'élément piézoélectrique linéaire suivant (101) qui a été évalué comme ayant dépassé après le dépassement de cet élément piézoélectrique linéaire (101), et
une unité d'établissement de région (112) qui établit, en tant que région d'application de contrainte, la région qui a la ligne de limite définie par l'unité de définition de limite (111) et comprend l'élément piézoélectrique linéaire (101) qui a été initialement évalué comme ayant dépassé.

**2.** Capteur piézoélectrique (1000) selon la revendication 1, comprenant en outre une unité de calcul de contrainte (106) qui calcule la taille de la contrainte appliquée à l'élément piézoélectrique linéaire (101) sur la base de la taille du signal électrique détecté par le détecteur de signal (102).

**3.** Capteur piézoélectrique (1000) selon la revendication 1 ou 2, dans lequel
le détecteur de signaux (102) détecte une valeur de courant en tant que taille du signal électrique généré par chaque élément piézoélectrique linéaire (101),
l'unité d'évaluation de dépassement (103) évalue si oui ou non la valeur de courant du signal électrique détecté par le détecteur de signal (102) a dépassé une valeur de seuil prédéterminée, pour chaque élément piézoélectrique linéaire (101), et
l'enregistreur de temps (104) enregistre le temps de l'élément piézoélectrique linéaire (101) lorsque la valeur courante du signal électrique a été évaluée par l'unité d'évaluation de dépassement (103) comme ayant dépassé la valeur de seuil prédéterminée.

**4.** Capteur piézoélectrique (1000) selon l'une quelconque des revendications 1 à 3, dans lequel l'élément piézoélectrique linéaire (101) délivre un signal électrique par déformation d'allongement.

**5.** Capteur piézoélectrique (1000) selon l'une quelconque des revendications 1 à 4, dans lequel l'élément piézoélectrique linéaire (101) est un élément piézoélectrique tressé (1) ayant une âme (3) formée de fibre conductrice (B), et une gaine (2) formée de fibres piézoélectriques tressées (A) recouvrant l'âme (3).

**6.** Capteur piézoélectrique (1000) selon la revendication 5, dans lequel les fibres piézoélectriques (A) sont composées d'un polymère piézoélectrique comprenant comme composant principal un polymère cristallin ayant une valeur absolue comprise entre 0. 1 pC/N et 1000 pC/N pour la constante piézoélectrique d14, lorsque l'axe d'orientation est le troisième axe, l'angle d'orientation du polymère piézoélectrique par rapport à la direction de l'axe central (CL) du noyau (3) recouvert par le polymère piézoélectrique étant compris entre 15° et 75°, et le polymère piézoélectrique comprend un corps P contenant un polymère cristallin avec une valeur de constante piézoélectrique d14 positive comme composant principal et un corps N contenant un polymère cristallin avec une valeur négative comme composant principal, dans lequel pour une partie de l'axe central (CL) ayant une longueur de 1 cm, la valeur de T1/T2 est comprise entre 0 et 0. 8, T1 étant la plus petite et T2 étant la plus grande de (ZP + SN) et (SP + ZN), où ZP est la masse du corps P dont l'axe d'orientation est enroulé de manière hélicoïdale autour de la direction de torsion Z, SP est la masse du corps P dont l'axe d'orientation est enroulé de manière hélicoïdale autour de la direction de torsion S, ZN est la masse du corps N dont l'axe d'orientation est enroulé de manière hélicoïdale autour de la direction de torsion Z, et SN est la masse du corps N dont l'axe d'orientation est enroulé de manière hélicoïdale autour de la direction de torsion S.

**7.** Procédé de détection d'impact par lequel la région sur un objet mesuré où une contrainte a été appliquée est identifiée, le procédé comprenant
une étape de détection de signal (S201) dans laquelle le signal électrique généré lorsqu'une contrainte est appliquée à deux ou plusieurs éléments piézoélectriques linéaires (101) disposés près d'un objet mesuré est détecté pour chaque élément piézoélectrique linéaire (101),
une étape d'évaluation de dépassement (S202) dans laquelle on évalue si la taille du signal électrique détecté dans l'étape de détection de signal a dépassé ou non une valeur de seuil prédéterminée, pour chaque élément piézoélectrique linéaire (101),
une étape d'enregistrement du moment (S203) dans laquelle le moment du dépassement de l'élément piézoélectrique linéaire est enregistré lorsque la taille du signal électrique a été évaluée dans l'étape d'évaluation du dépassement comme ayant dépassé la valeur de seuil prédéterminée, et
une étape d'identification de région (S204) dans laquelle la région sur l'objet mesuré où la contrainte a été appliquée est identifiée, sur la base de la synchronisation de l'élément piézoélectrique linéaire enregistrée dans l'étape d'enregistrement de synchronisation, dans laquelle l'étape d'identification de région comprend,
une étape de définition de frontière (S204-1) qui, sur la base de l'ordre de dépassement des éléments piézoélectriques linéaires (101) enregistrés dans l'étape d'enregistrement de synchronisation, définit comme ligne de frontière la collection de points équidistants de l'élément piézoélectrique linéaire (101) qui a été évalué comme ayant dépassé, et l'élément piézoélectrique linéaire suivant (101) qui a été évalué comme ayant dépassé après le dépassement de cet élément piézoélectrique linéaire (101),
une étape d'établissement de région (S204-2) qui établit, en tant que région d'application de contrainte, la région qui a la ligne de limite définie dans l'étape de définition de limite et inclut l'élément piézoélectrique linéaire (101) qui a été initialement évalué comme ayant dépassé.

**8.** Procédé de détection d'impact selon la revendication 7, comprenant en outre une étape de calcul de contrainte dans laquelle la taille de la contrainte appliquée à l'élément piézoélectrique linéaire (101) est calculée sur la base de la taille du signal électrique détecté dans l'étape de détection de signal (S201).

**9.** Procédé de détection d'impact selon la revendication 7 ou 8, dans lequel
dans l'étape de détection de signal (S201), une valeur de courant est détectée comme étant la taille du signal électrique généré par chaque élément piézoélectrique linéaire (101),
dans l'étape d'évaluation de dépassement (S202), il est évalué si oui ou non la valeur de courant du signal électrique détecté dans l'étape de détection de signal (S201) a dépassé une valeur de seuil prédéterminée, pour chaque élément piézoélectrique linéaire (101), et
dans l'étape d'enregistrement de synchronisation (S203), la synchronisation de l'élément piézoélectrique linéaire est enregistrée lorsque la valeur courante du signal électrique a été évaluée dans l'étape d'évaluation de dépassement (S202) comme ayant dépassé la valeur de seuil prédéterminée.

FIG. 1

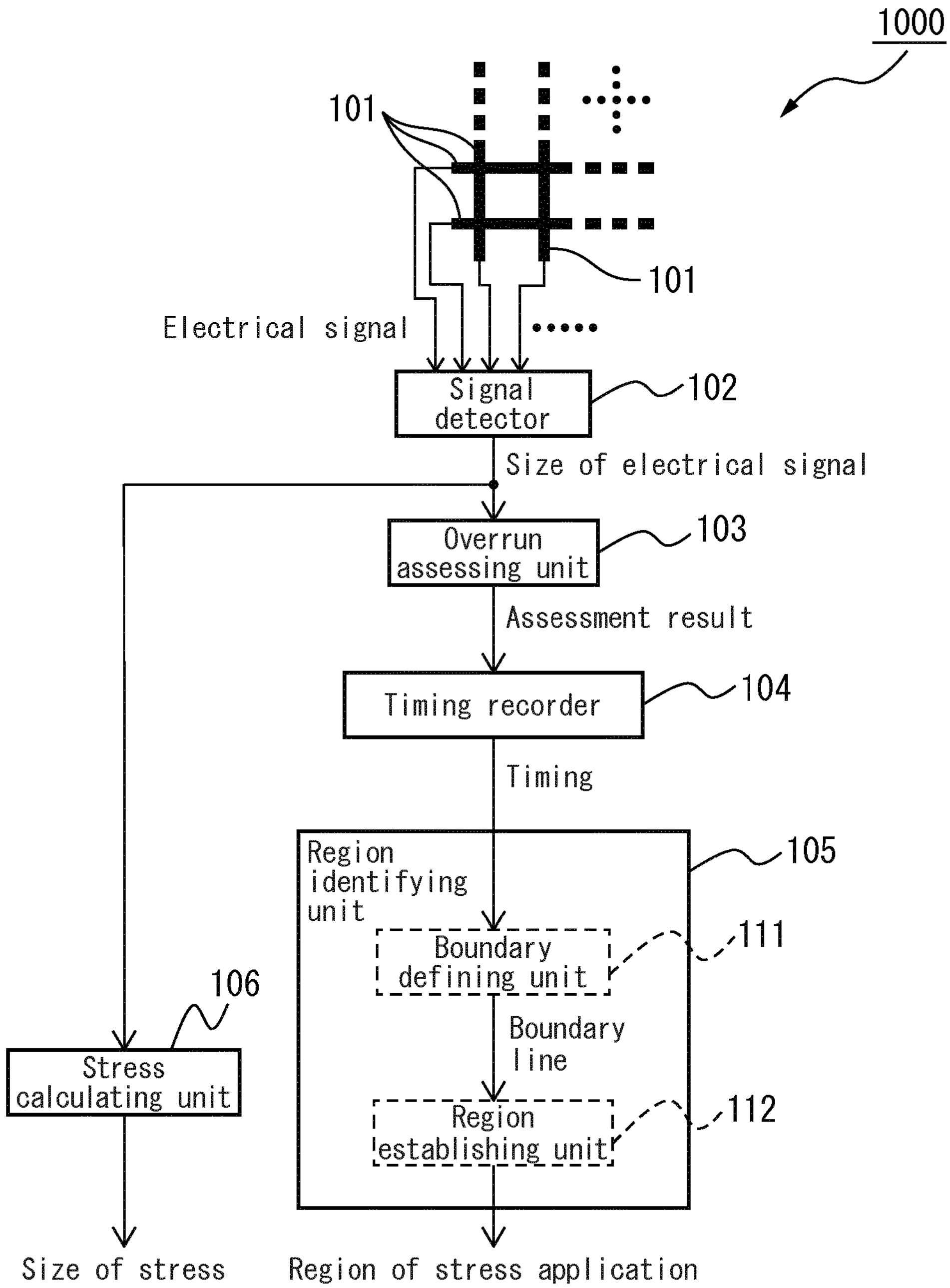
1000
101
101
Electrical signal
Signal detector
102
Size of electrical signal
Overrun assessing unit
103
Assessment result
Timing recorder
104
Timing
Region identifying unit
105
Boundary defining unit
111
Boundary line
Region establishing unit
112
106
Stress calculating unit
Size of stress
Region of stress application

FIG. 2

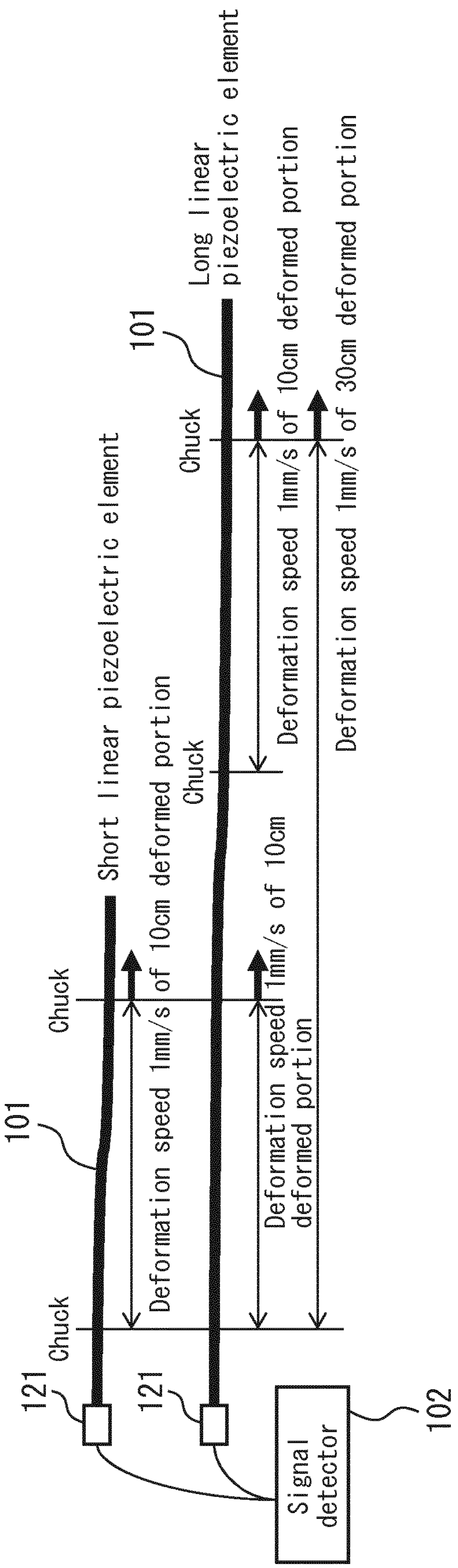
Short linear piezoelectric element
101
Chuck
Chuck
Deformation speed 1mm/s of 10cm deformed portion
121
121
Signal detector
102
Long linear piezoelectric element
101
Chuck
Chuck
Deformation speed 1mm/s of 10cm deformed portion
Deformation speed 1mm/s of 10cm deformed portion
Deformation speed 1mm/s of 30cm deformed portion

FIG. 3

(A)

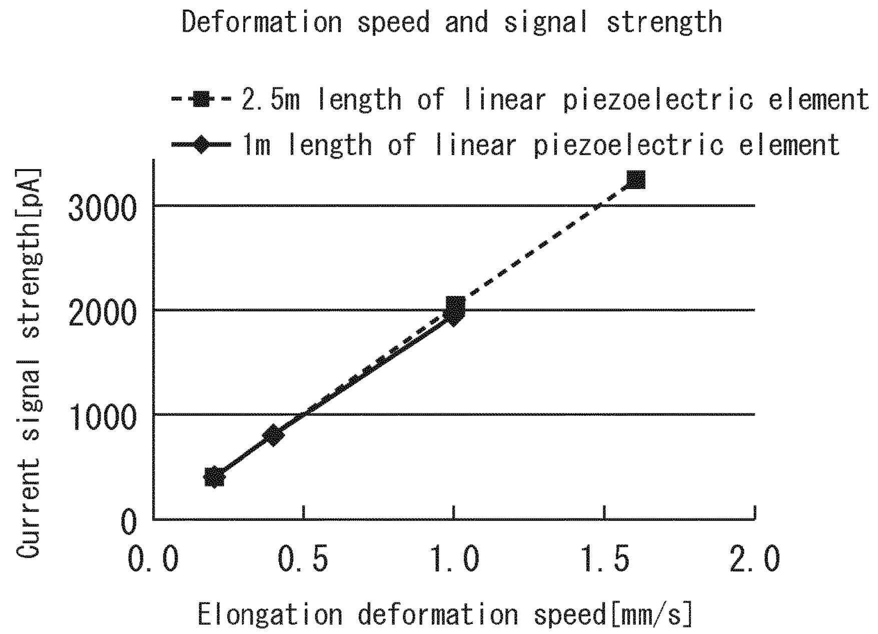
Deformation speed and signal strength
2.5m length of linear piezoelectric element
1m length of linear piezoelectric element
Current signal strength[pA]
3000
2000
1000
0
0.0
0.5
1.0
1.5
2.0
Elongation deformation speed[mm/s]

(B)

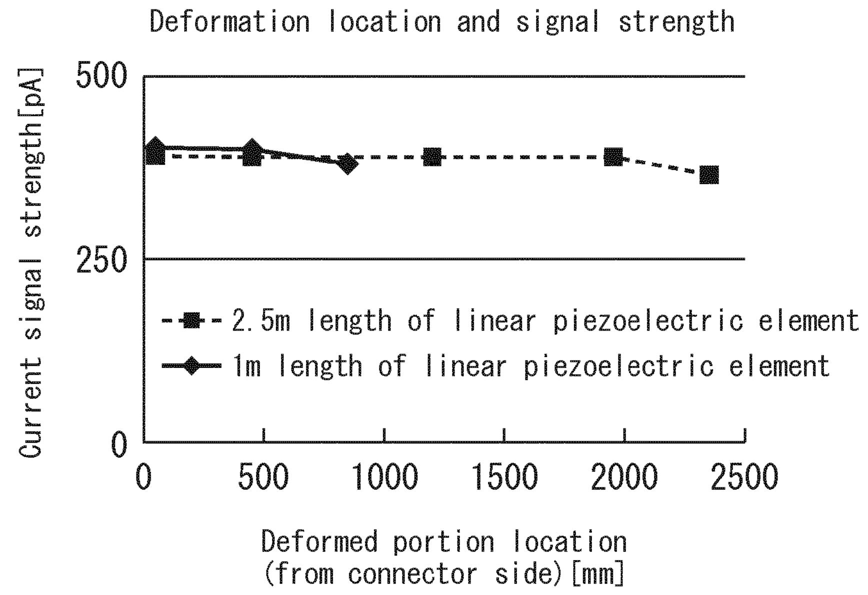
Deformation location and signal strength
Current signal strength[pA]
500
250
0
2.5m length of linear piezoelectric element
1m length of linear piezoelectric element
0
500
1000
1500
2000
2500
Deformed portion location
(from connector side)[mm]

FIG. 4

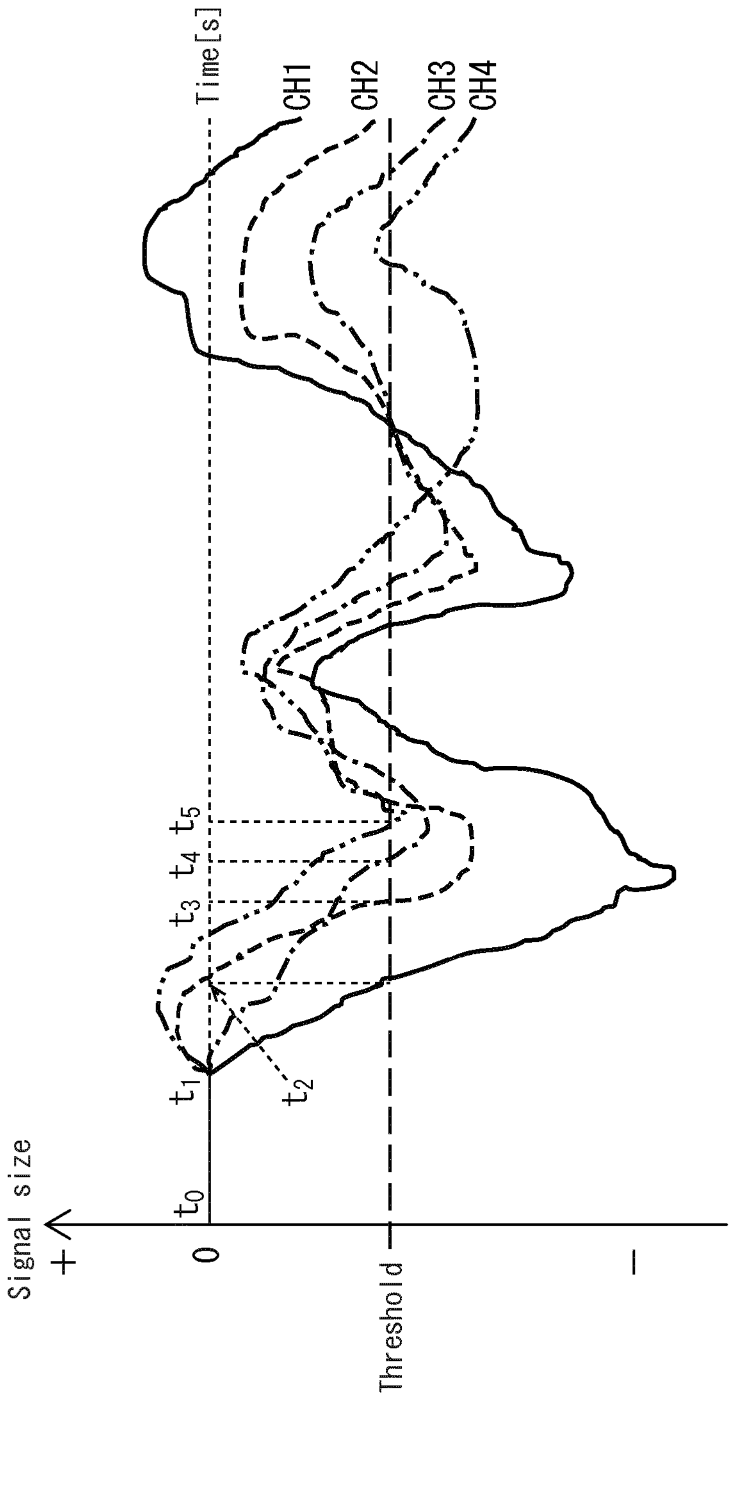

FIG. 5

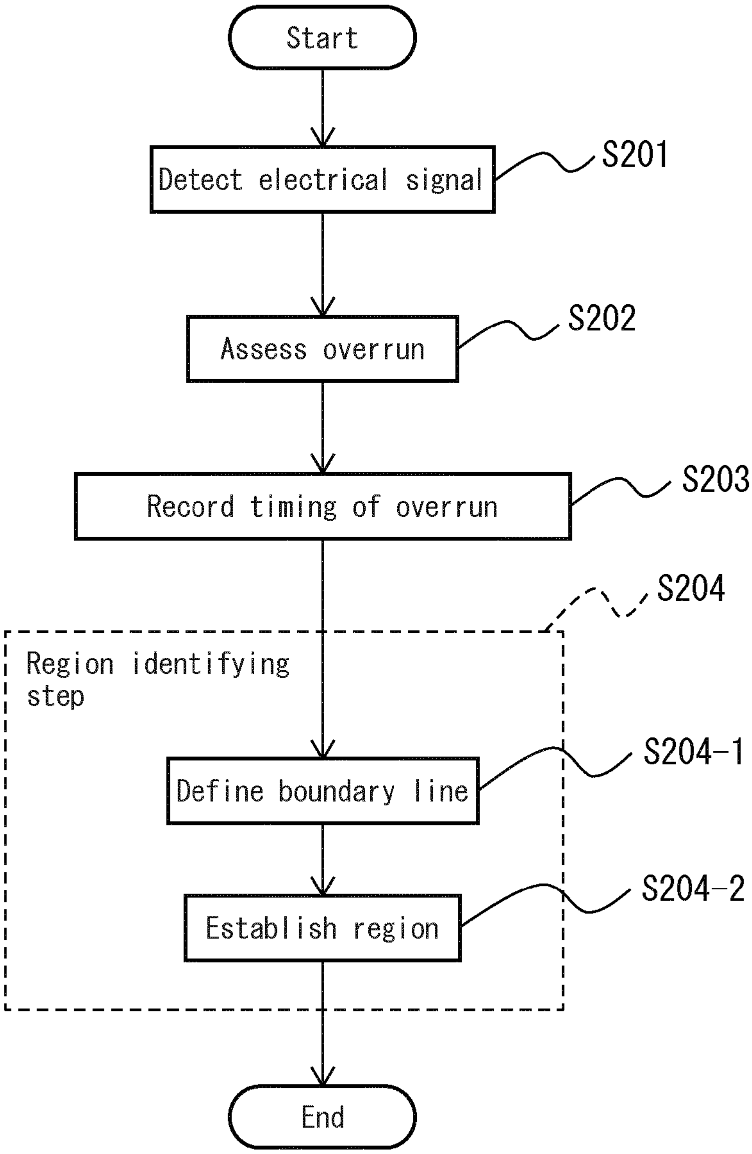
Start
Detect electrical signal
S201
Assess overrun
S202
Record timing of overrun
S203
S204
Region identifying step
Define boundary line
S204-1
Establish region
S204-2
End

FIG. 6

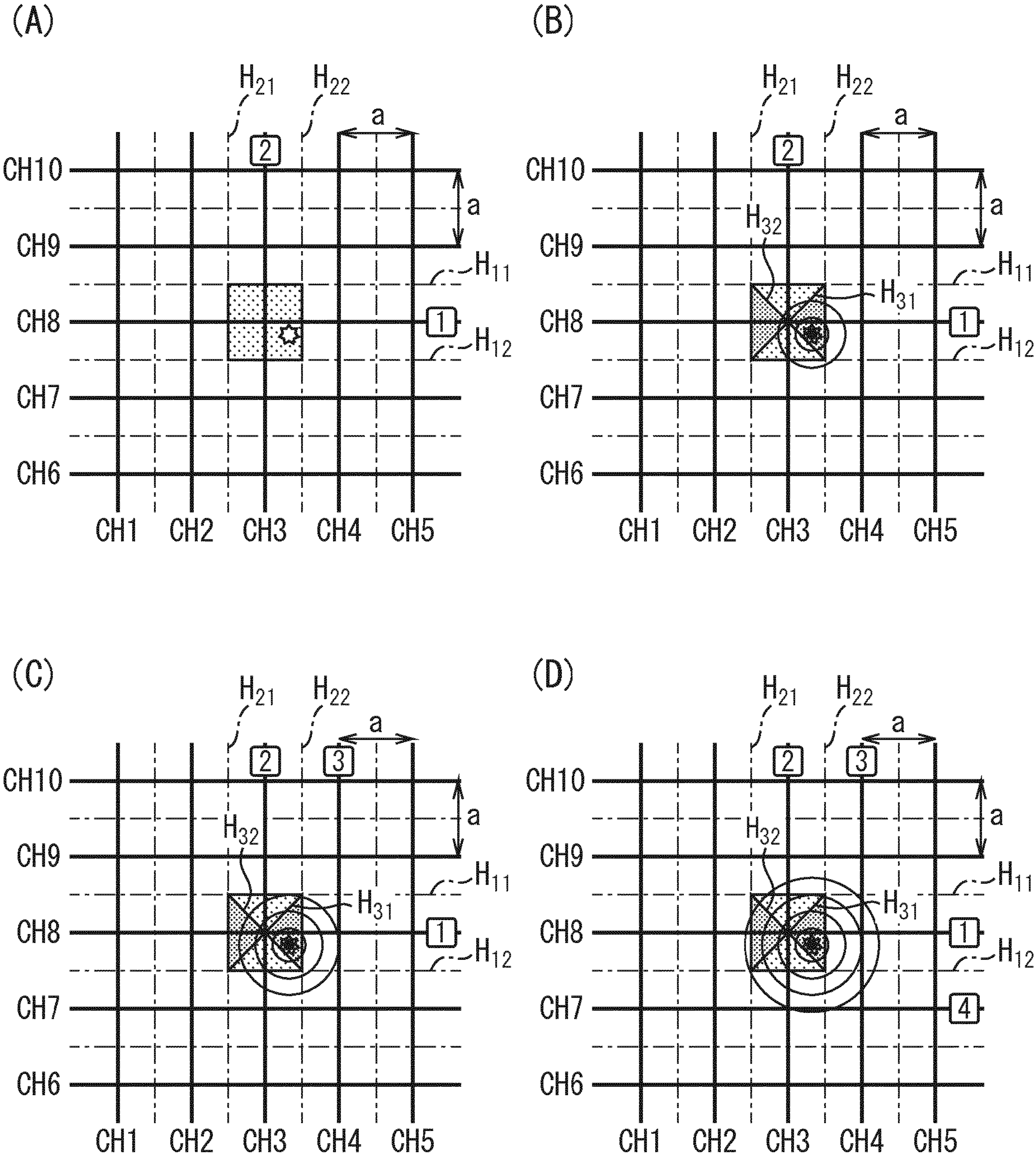
(A)
(B)
(C)
(D)
H21
H22
H31
H32
H11
H12
a
CH10
CH9
CH8
CH7
CH6
CH1
CH2
CH3
CH4
CH5
1
2
3
4

FIG. 7

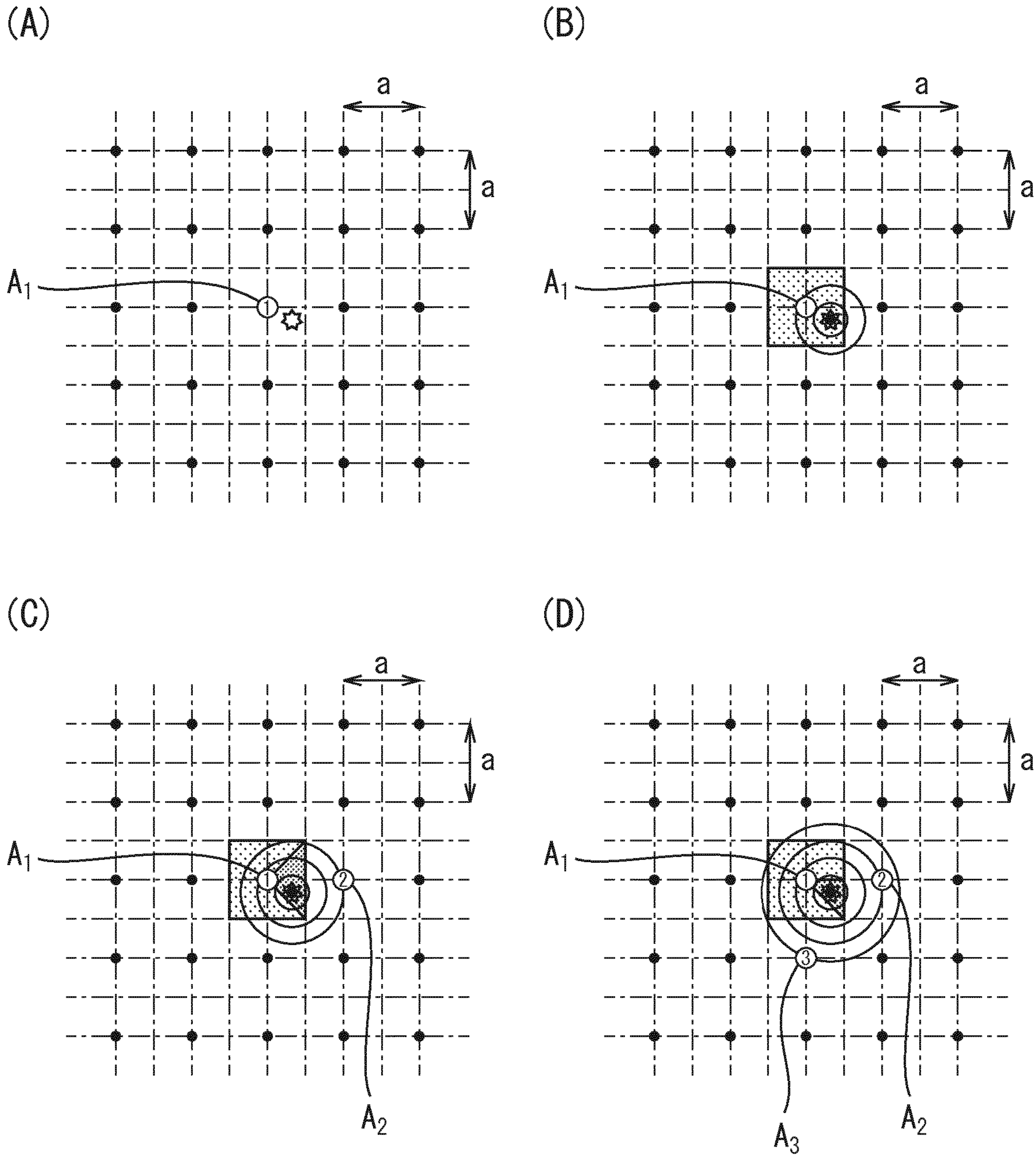

FIG. 8

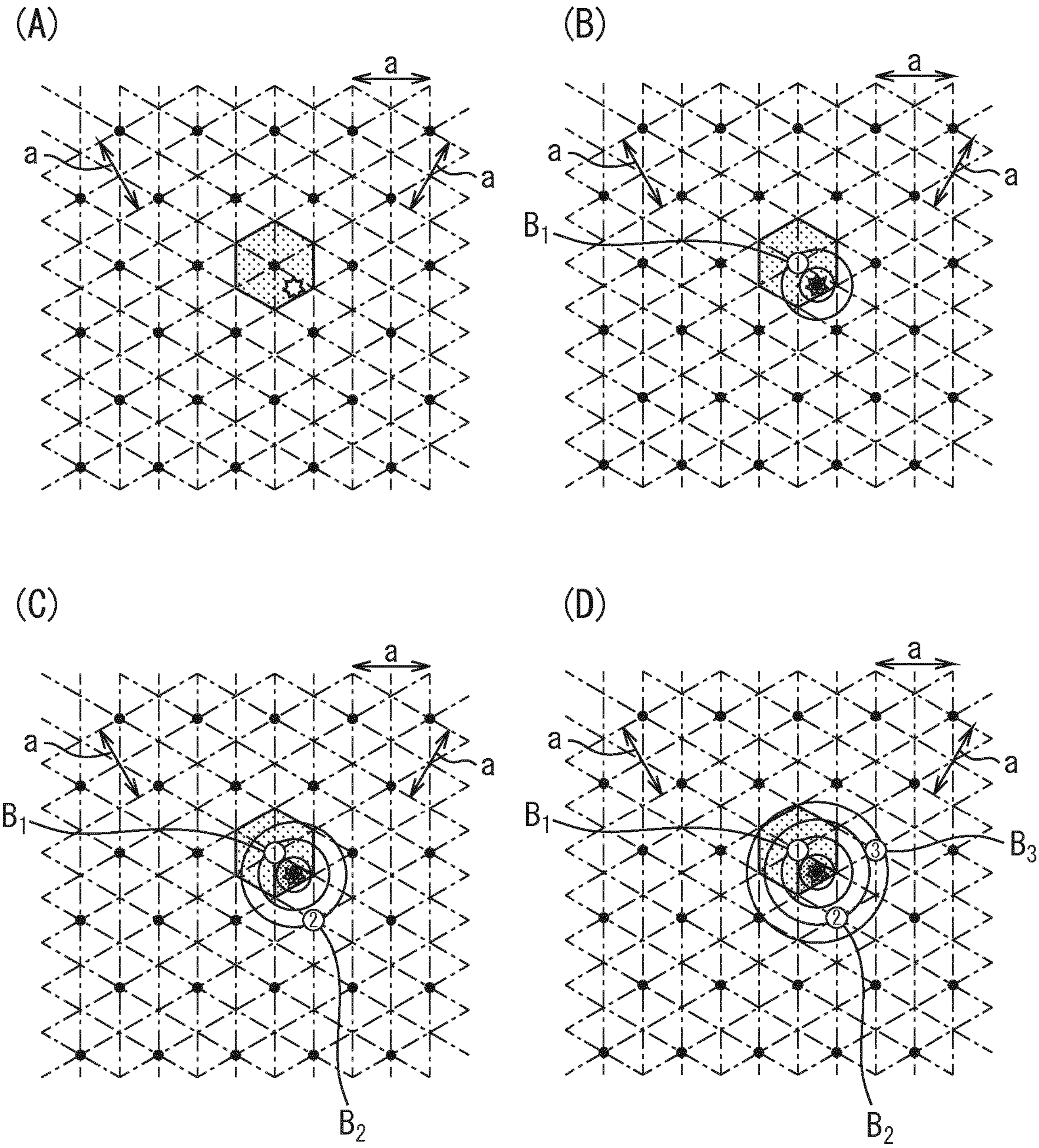

FIG. 9

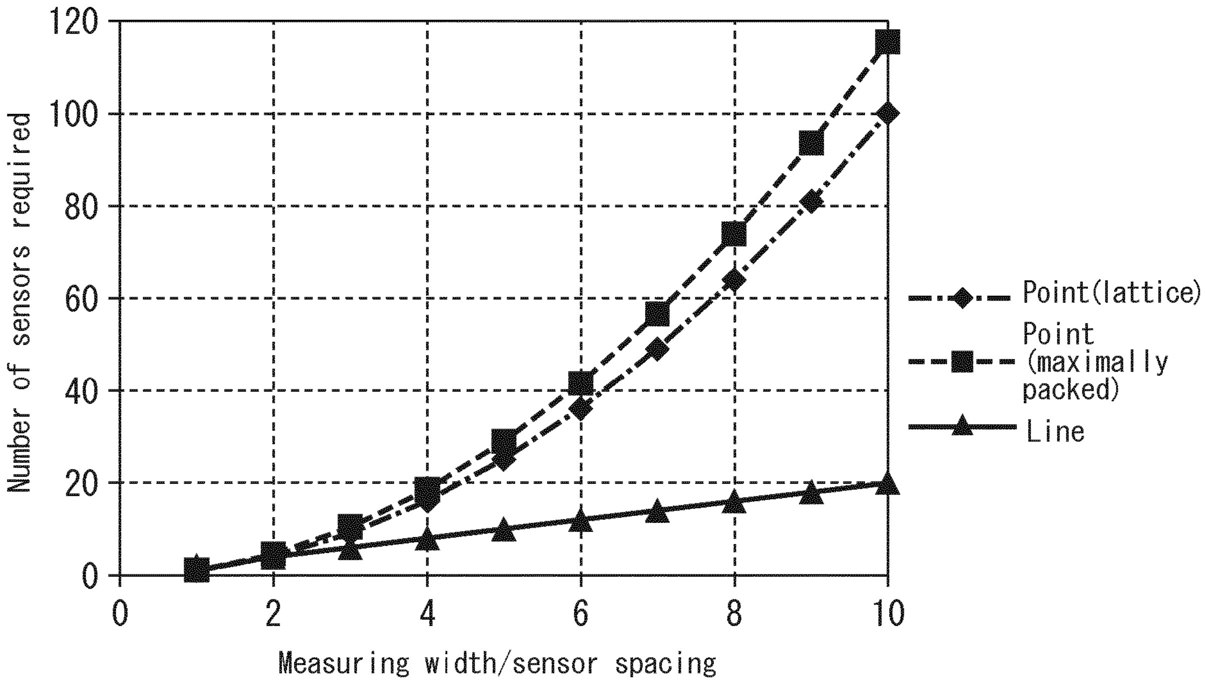


FIG. 10

Maximal packing

| Sensor shape | Point | Point | Line |
|---|---|---|---|
| Configuration | Lattice | | Lattice |
| Number of sensors per unit area (distance "a" between sensors) | $1/a^2$ | $1.15/a^2$ | $2/a^2$ |
| Specified area at one sensor | $a^2$ | $0.87a^2$ | $a^2$ (one each for x,y) |
| Specified area by order analysis within radius "a" | $0.125a^2$ | $0.07a^2$ | $0.125a^2$ |

FIG. 11

(A)

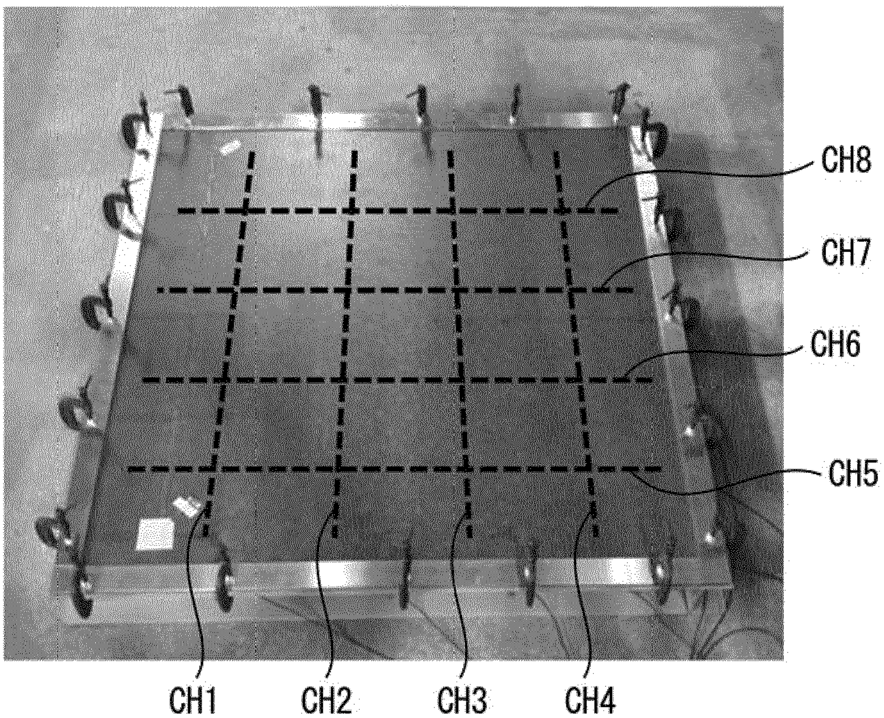


(B)

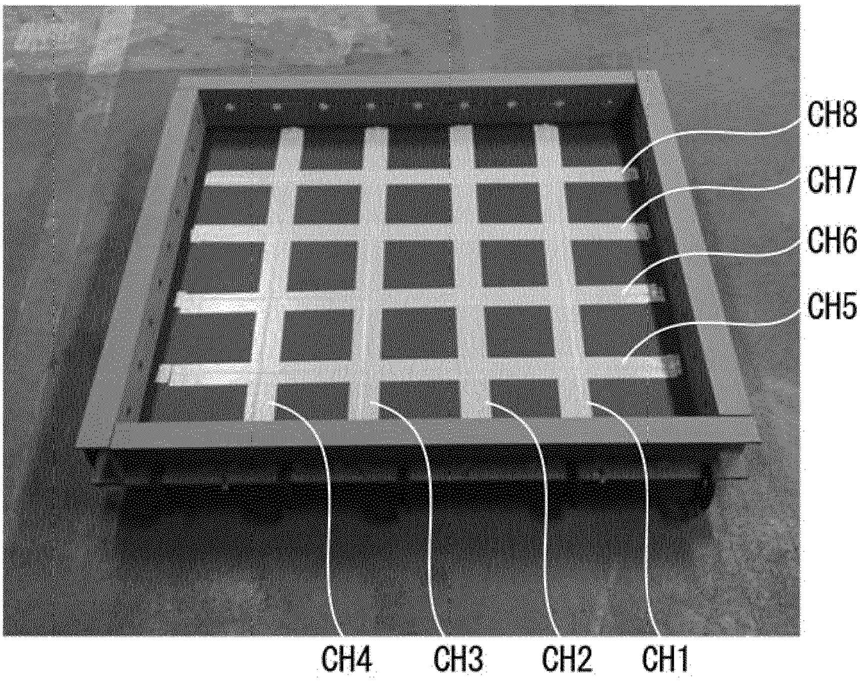

FIG. 12

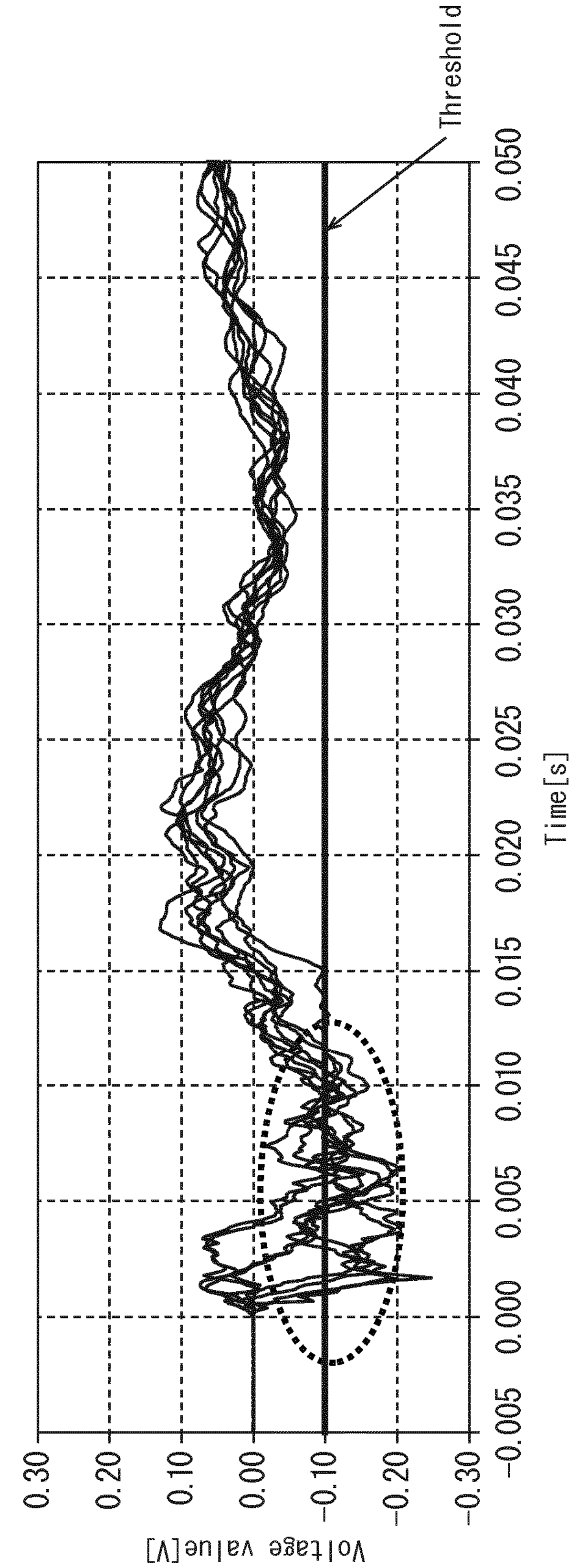
Threshold
Time[s]
Voltage value[V]
-0.005
0.000
0.005
0.010
0.015
0.020
0.025
0.030
0.035
0.040
0.045
0.050
0.30
0.20
0.10
0.00
-0.10
-0.20
-0.30

FIG. 13

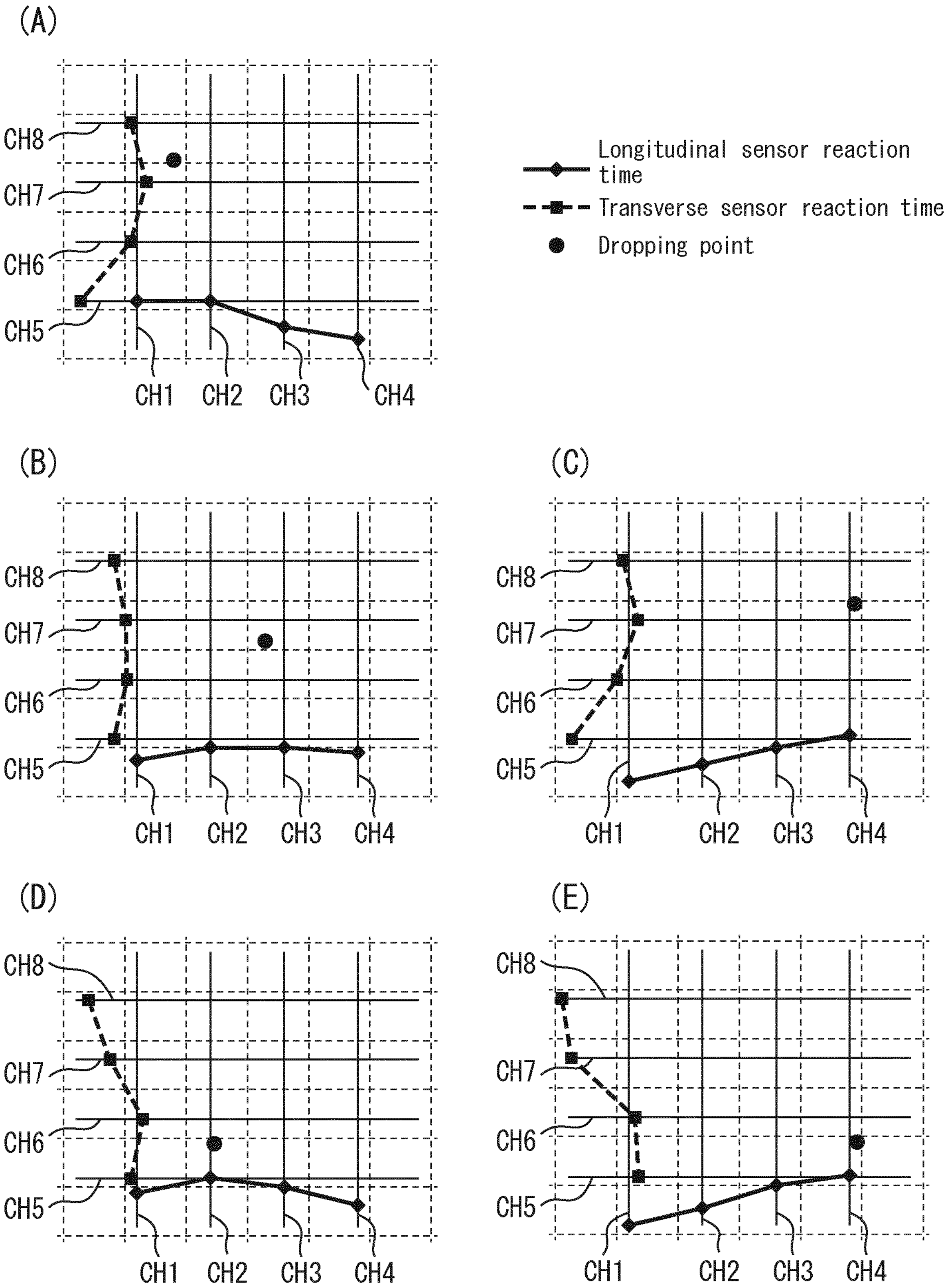
(A)
CH8
CH7
CH6
CH5
CH1
CH2
CH3
CH4
Longitudinal sensor reaction time
Transverse sensor reaction time
Dropping point
(B)
CH8
CH7
CH6
CH5
CH1
CH2
CH3
CH4
(C)
CH8
CH7
CH6
CH5
CH1
CH2
CH3
CH4
(D)
CH8
CH7
CH6
CH5
CH1
CH2
CH3
CH4
(E)
CH8
CH7
CH6
CH5
CH1
CH2
CH3
CH4

FIG. 14

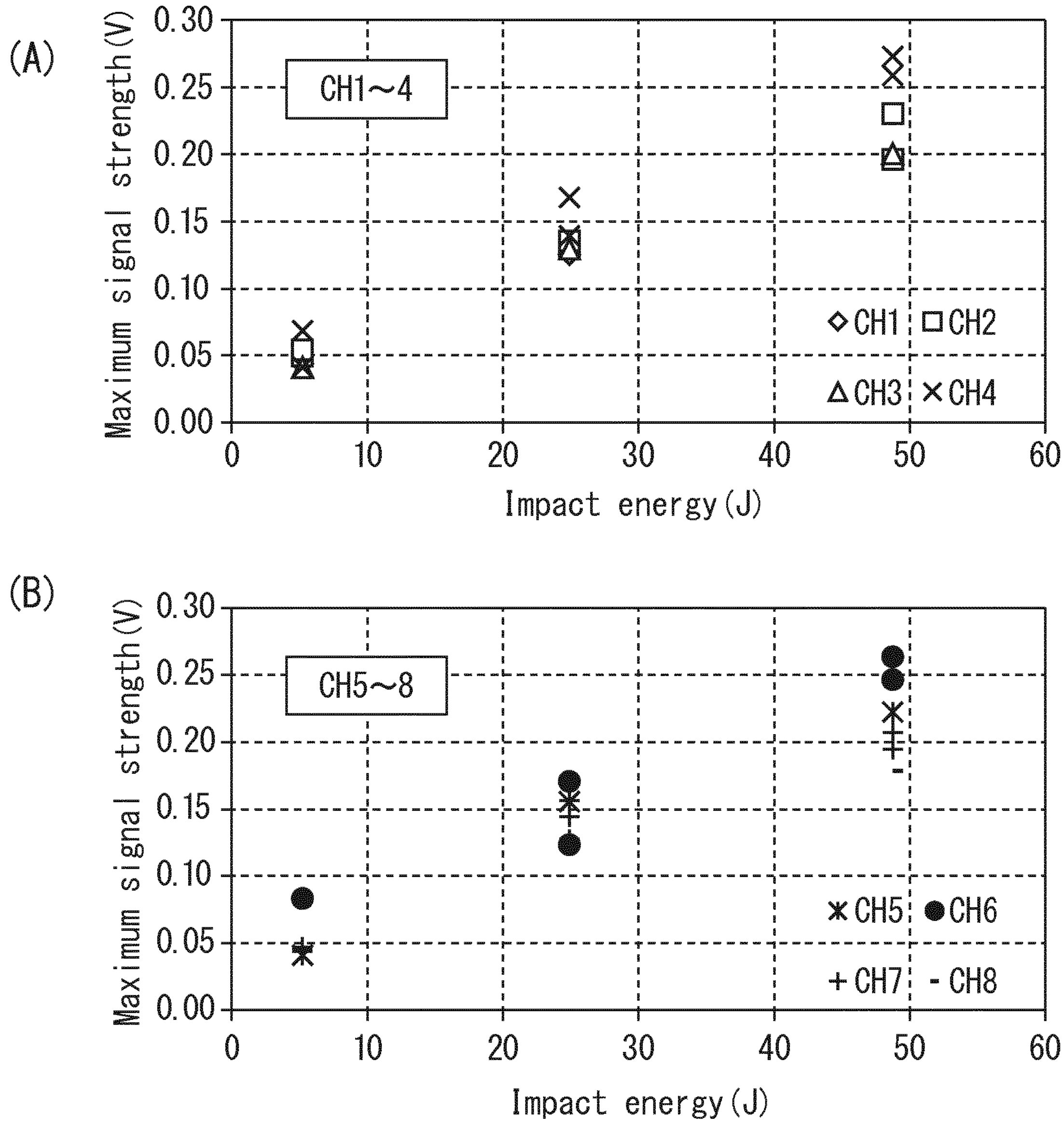
(A)
CH1~4
Maximum signal strength (V)
0.30
0.25
0.20
0.15
0.10
0.05
0.00
0
10
20
30
40
50
60
Impact energy (J)
CH1
CH2
CH3
CH4
(B)
CH5~8
Maximum signal strength (V)
0.30
0.25
0.20
0.15
0.10
0.05
0.00
0
10
20
30
40
50
60
Impact energy (J)
CH5
CH6
CH7
CH8

FIG. 15

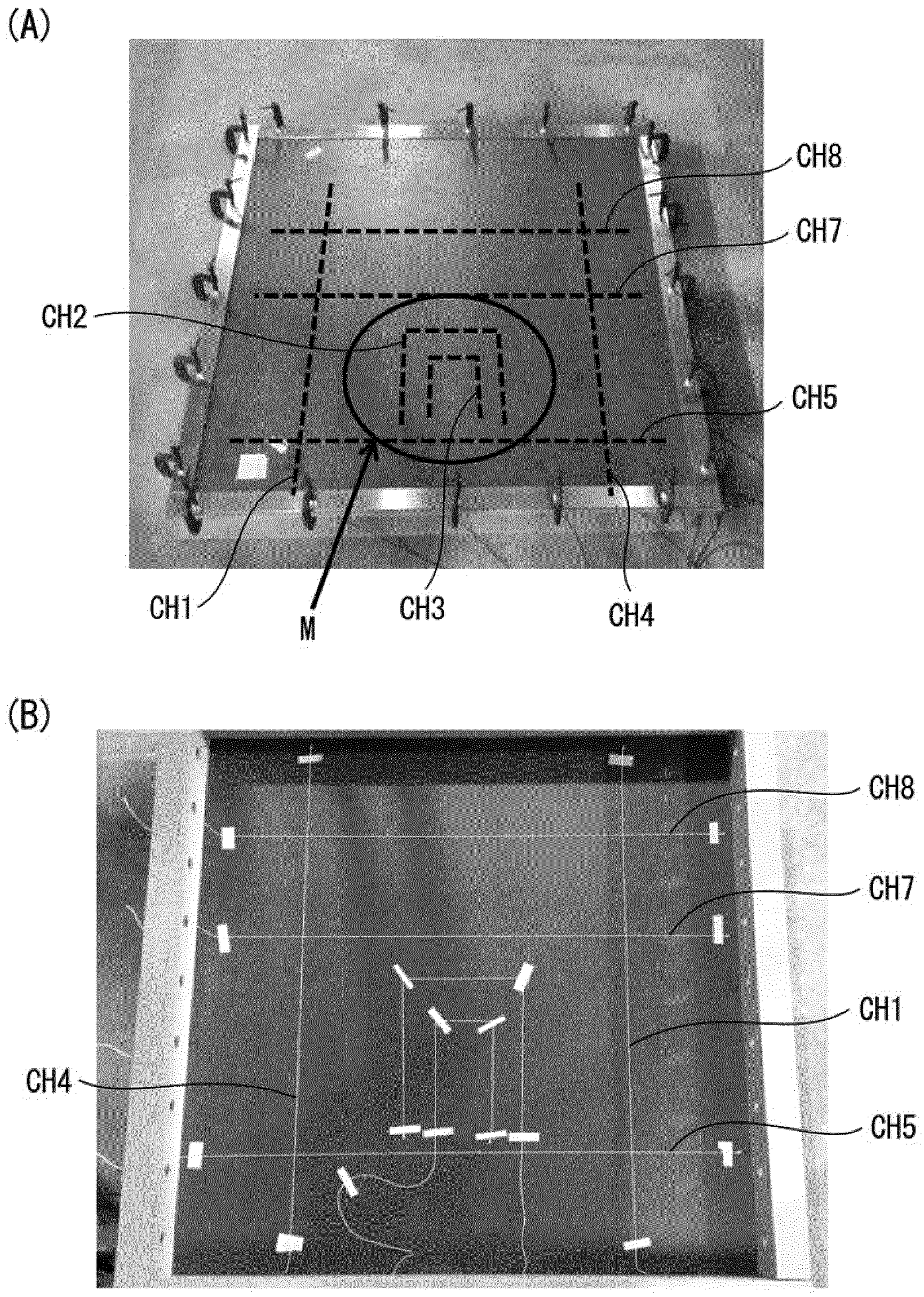

FIG. 16

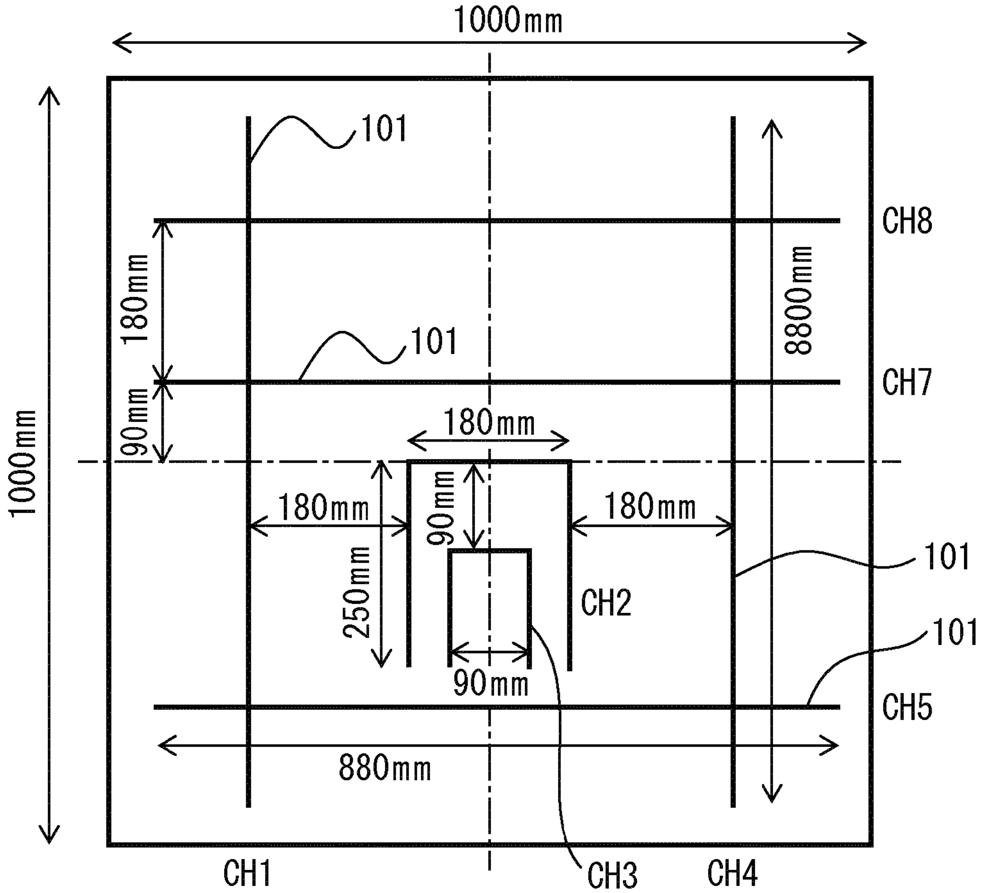
1000mm
101
CH8
180mm
101
8800mm
CH7
90mm
180mm
1000mm
180mm
90mm
180mm
101
250mm
CH2
101
90mm
CH5
880mm
CH1
CH3
CH4

FIG. 17

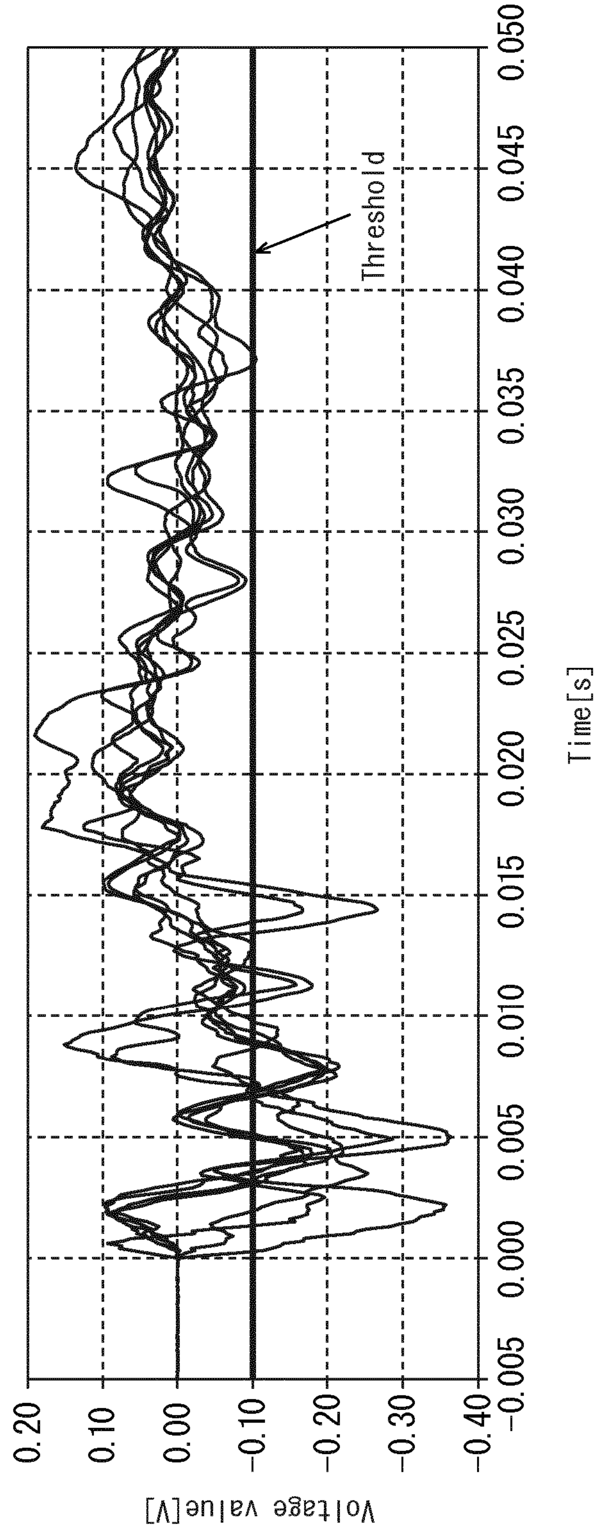
Threshold
Time[s]
Voltage value[V]
0.20
0.10
0.00
−0.10
−0.20
−0.30
−0.40
−0.005
0.000
0.005
0.010
0.015
0.020
0.025
0.030
0.035
0.040
0.045
0.050

FIG. 18

(A)

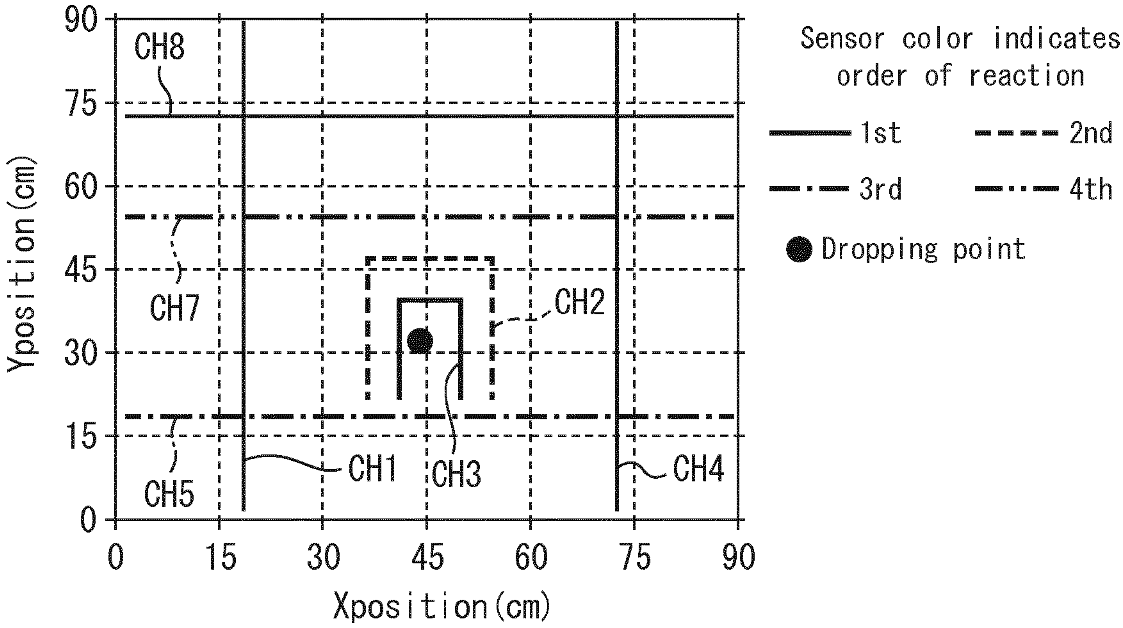

90
75
60
45
30
15
0
0
15
30
45
60
75
90
Yposition(cm)
Xposition(cm)
CH8
CH7
CH5
CH1
CH2
CH3
CH4
Sensor color indicates order of reaction
1st
2nd
3rd
4th
Dropping point


(B)

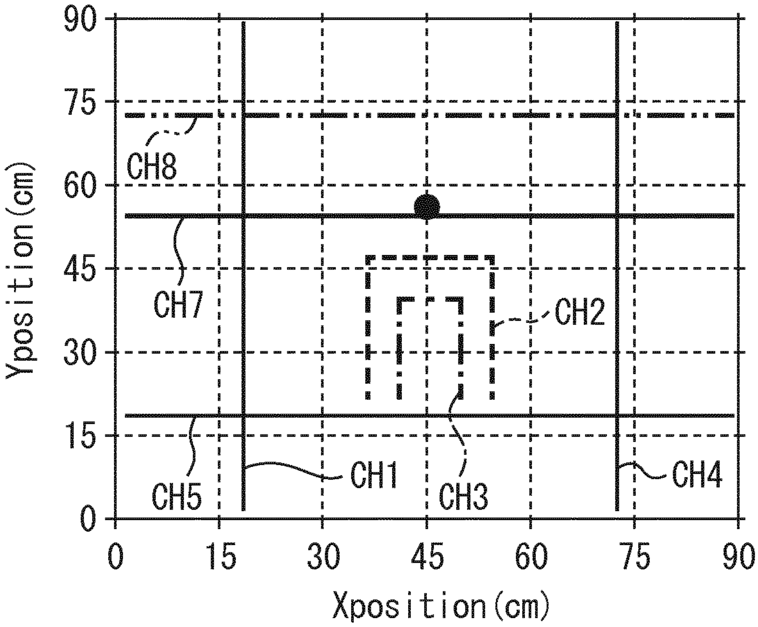

90
75
60
45
30
15
0
0
15
30
45
60
75
90
Yposition(cm)
Xposition(cm)
CH8
CH7
CH5
CH1
CH2
CH3
CH4

FIG. 19

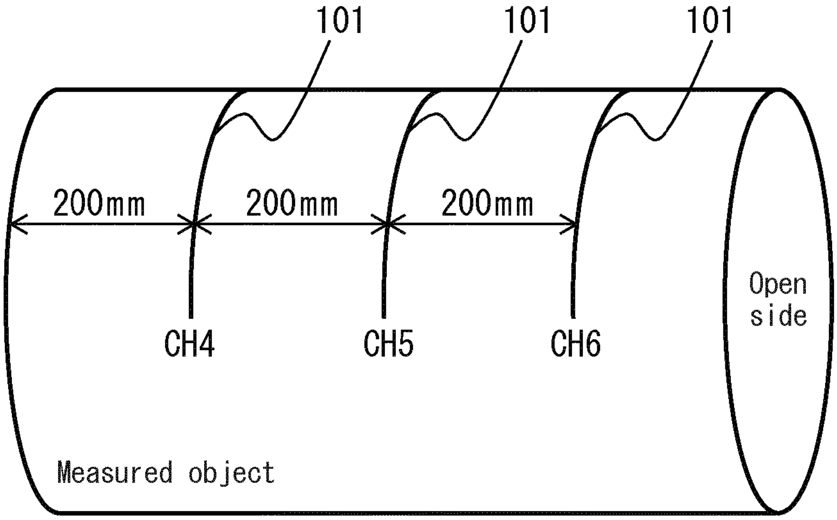
101
101
101
200mm
200mm
200mm
Open side
CH4
CH5
CH6
Measured object

FIG. 20

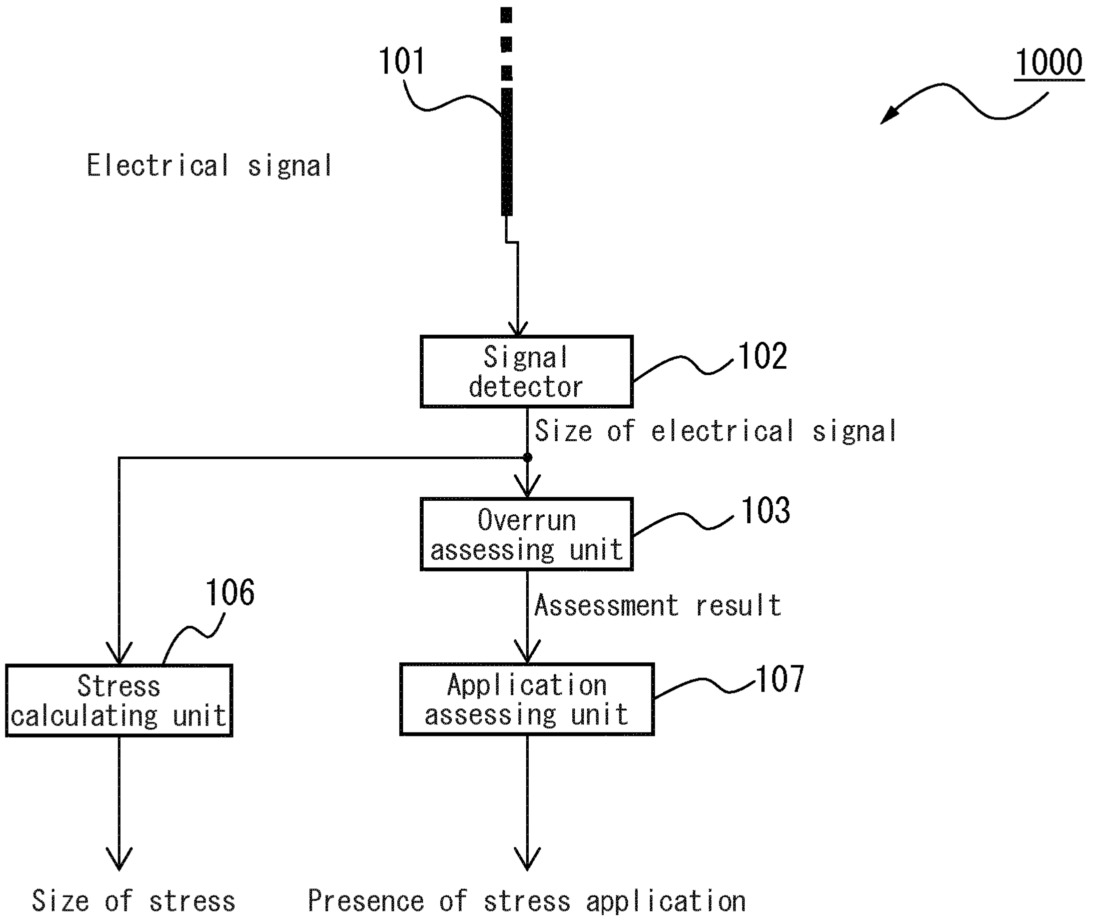
101
1000
Electrical signal
Signal detector
102
Size of electrical signal
Overrun assessing unit
103
Assessment result
106
Stress calculating unit
Application assessing unit
107
Size of stress
Presence of stress application

FIG. 21

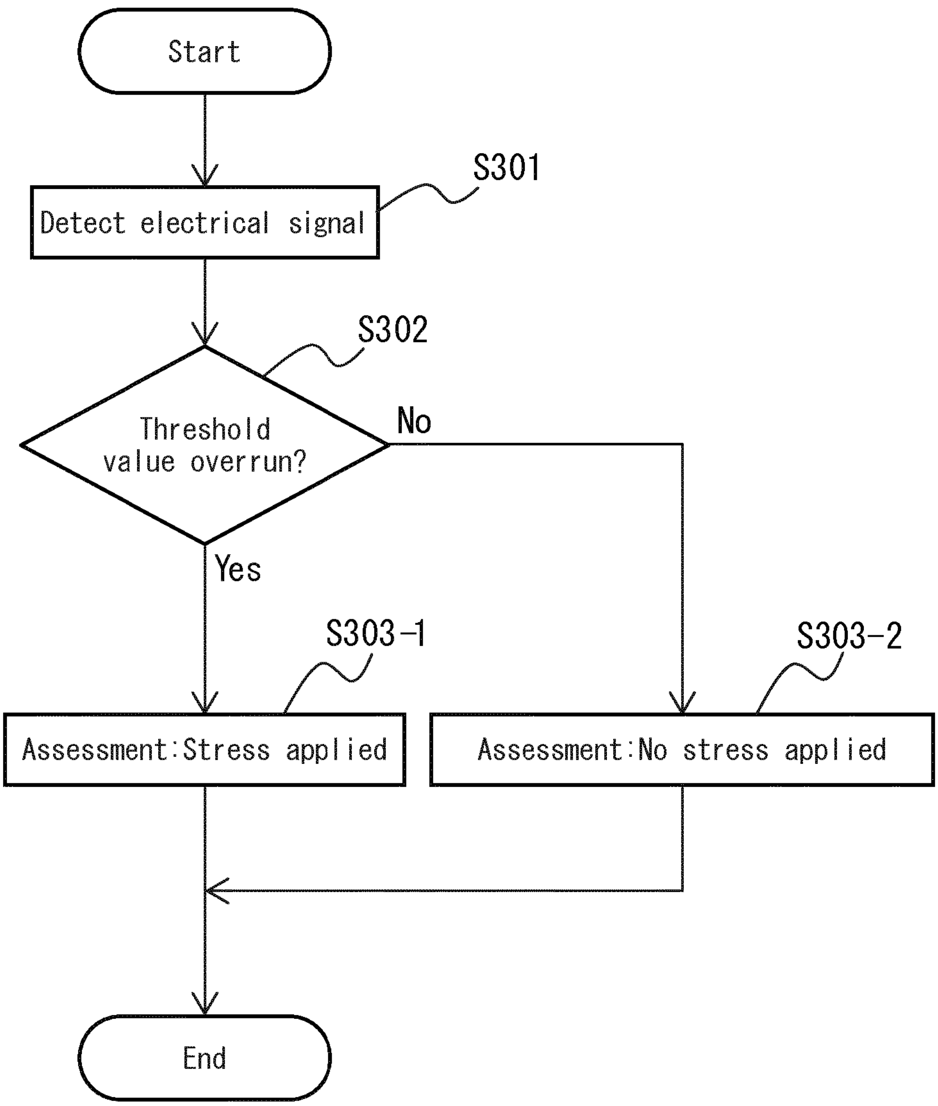
Start
S301
Detect electrical signal
S302
Threshold value overrun?
No
Yes
S303-1
S303-2
Assessment:Stress applied
Assessment:No stress applied
End

FIG. 22

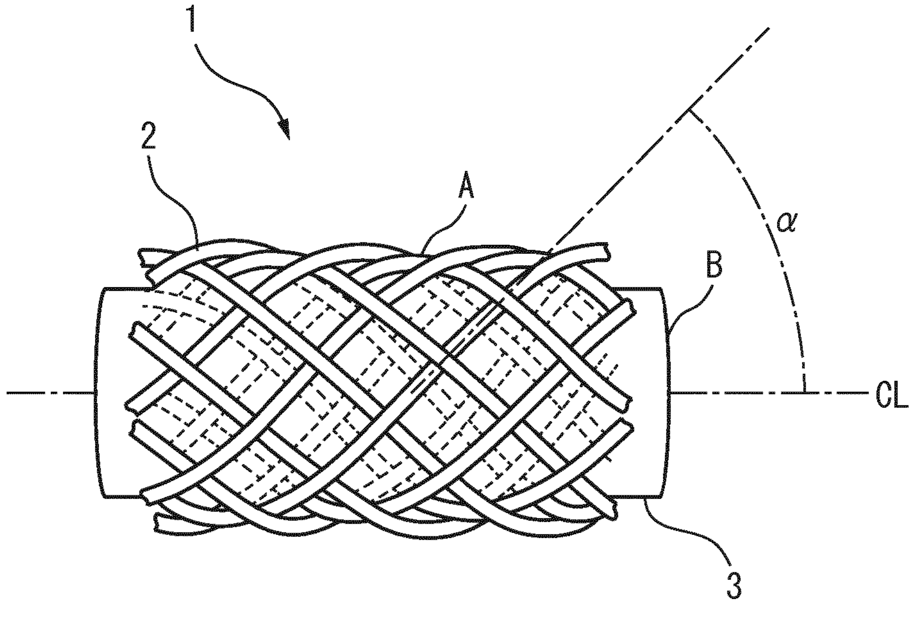

FIG. 23

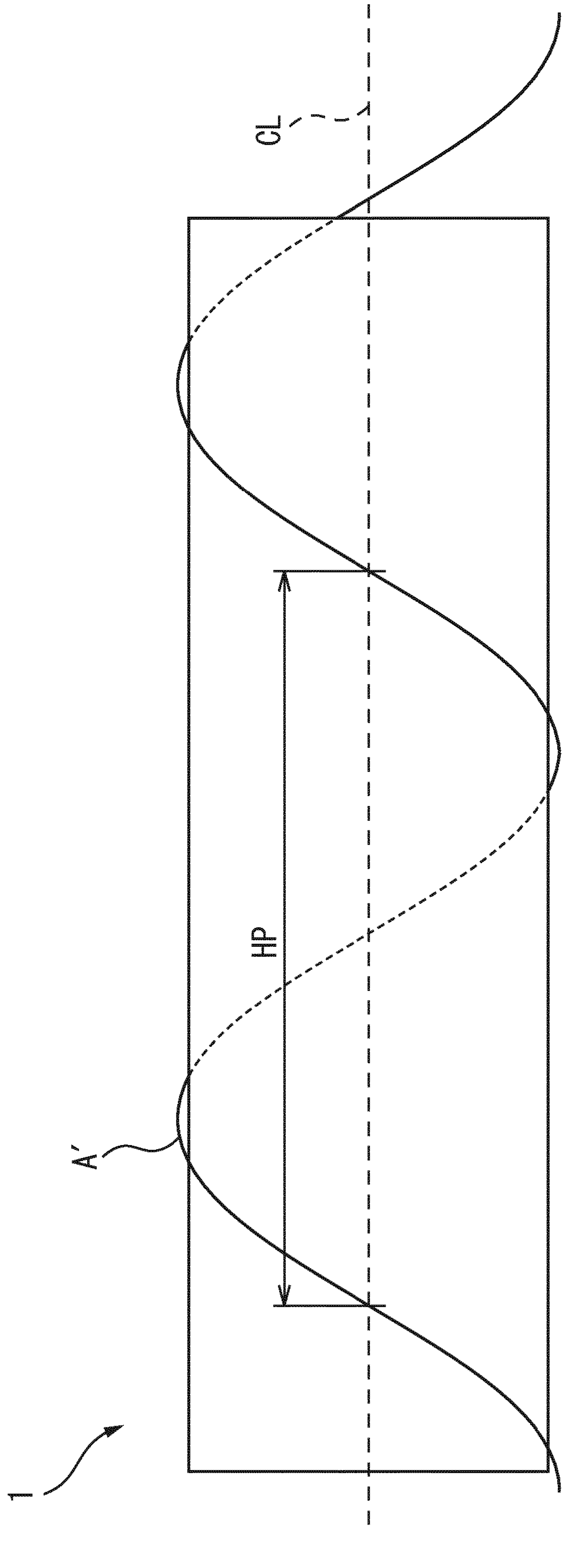

FIG. 24

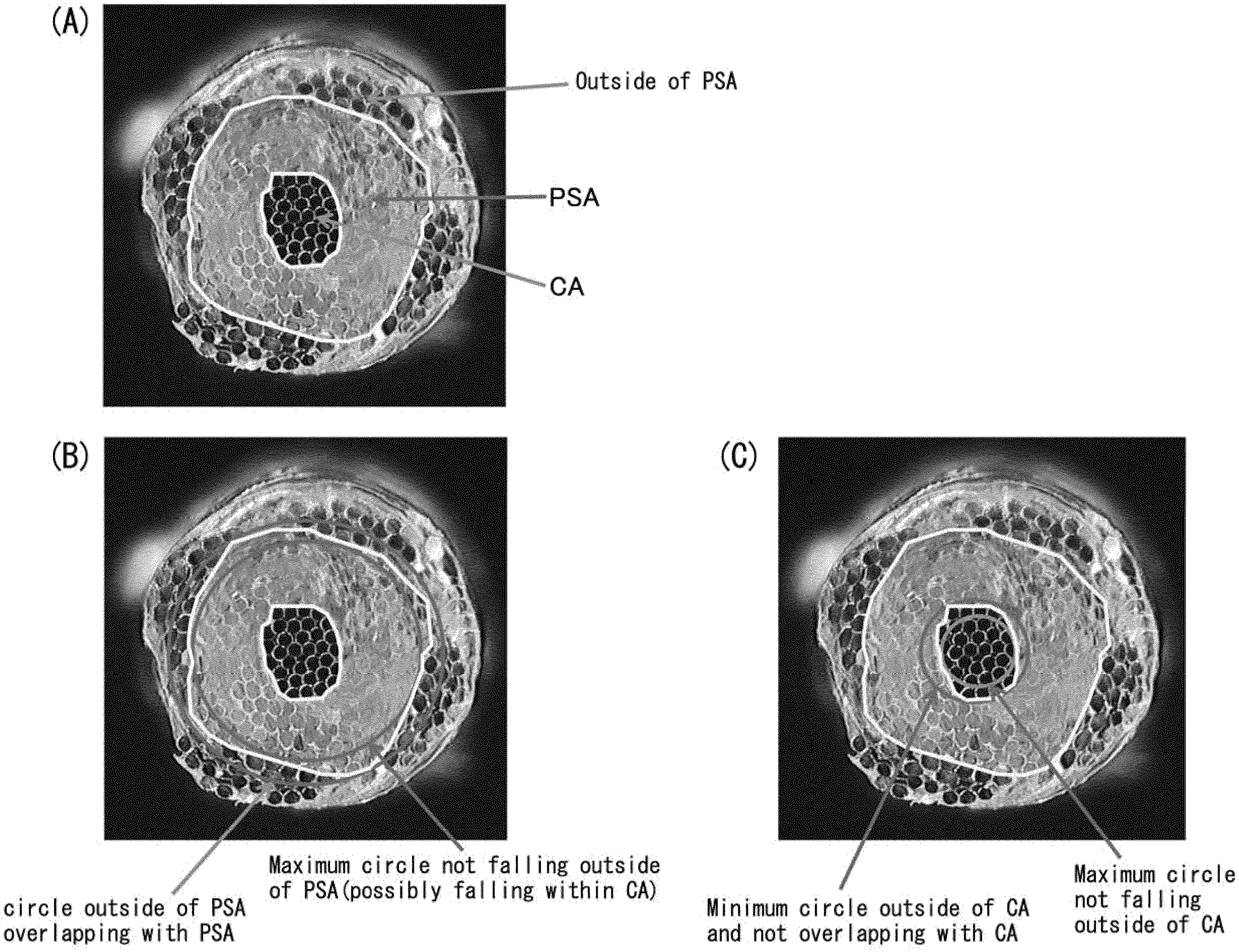
(A)
Outside of PSA
PSA
CA
(B)
Maximum circle not falling outside of PSA(possibly falling within CA)
Minimum circle outside of PSA and not overlapping with PSA
(C)
Minimum circle outside of CA and not overlapping with CA
Maximum circle not falling outside of CA

FIG. 25

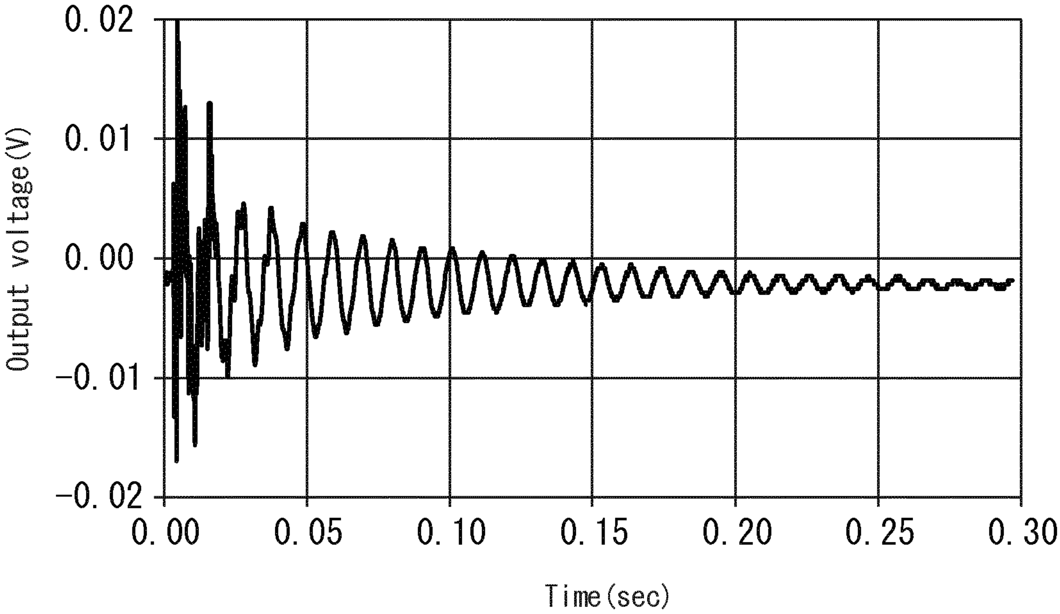
0.02
0.01
0.00
−0.01
−0.02
Output voltage(V)
0.00
0.05
0.10
0.15
0.20
0.25
0.30
Time(sec)

FIG. 26

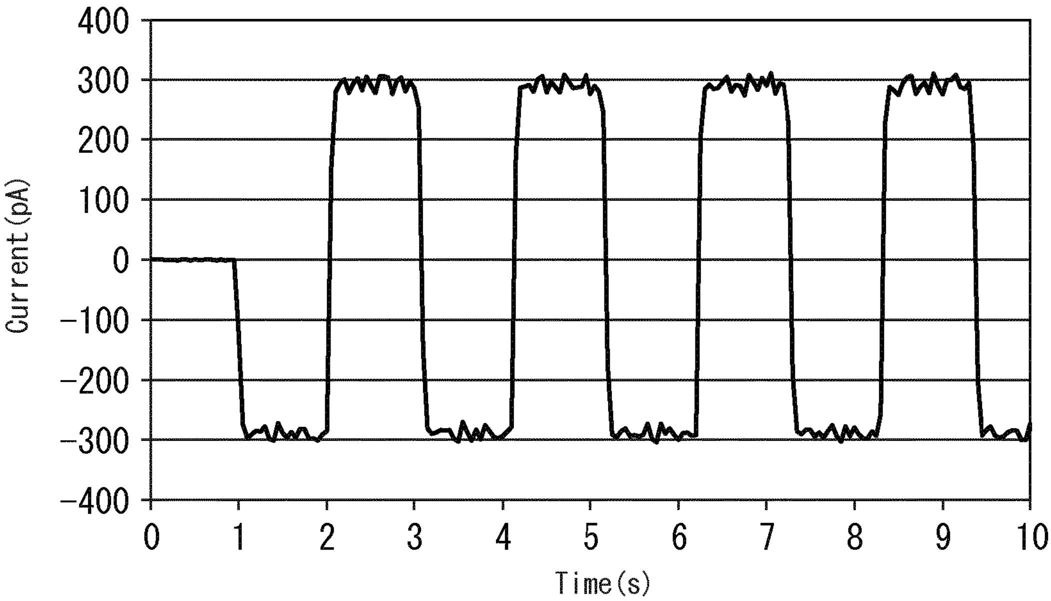
400
300
200
100
0
−100
−200
−300
−400
Current(pA)
0
1
2
3
4
5
6
7
8
9
10
Time(s)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005351781 A
- WO 2013165011 A
- JP 2004163182 A
- JP 2006090960 A
- JP 3238356 A
- US 2009164147 A1
- US 2010198528 A1
- JP 2016109652 A
- US 4943757 A
- WO 2016175321 A1